(19) Europäisches Patentamt
European Patent Office
Office européen des brevets

(11) **EP 2 936 560 B1**

(12) **EUROPÄISCHE PATENTSCHRIFT**

(45) Veröffentlichungstag und Bekanntmachung des Hinweises auf die Patenterteilung:
**08.02.2017   Patentblatt 2017/06**

(21) Anmeldenummer: **13811496.2**

(22) Anmeldetag: **18.12.2013**

(51) Int Cl.:
***H01L 31/0465*** *(2014.01)*

(86) Internationale Anmeldenummer:
**PCT/EP2013/077228**

(87) Internationale Veröffentlichungsnummer:
**WO 2014/096094 (26.06.2014 Gazette 2014/26)**

(54) **VERFAHREN ZUR HERSTELLUNG EINER DÜNNSCHICHTSOLARZELLENANORDNUNG**

METHOD FOR PRODUCING A THIN FILM CELL ARRANGEMENT

PROCÉDÉ DE FABRICATION D'UN ENSEMBLE DE CELLULES SOLAIRES À COUCHE MINCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.12.2012   DE 102012024754**

(43) Veröffentlichungstag der Anmeldung:
**28.10.2015   Patentblatt 2015/44**

(73) Patentinhaber: **Fraunhofer-Gesellschaft zur Förderung der angewandten Forschung e.V.
80686 München (DE)**

(72) Erfinder:
• **ZIMMERMANN, Birger
79289 Horben (DE)**
• **SCHLEIERMACHER, Hans-Frieder
79100 Freiburg (DE)**

• **SCHIEFER, Sebastian
79106 Freiburg (DE)**

(74) Vertreter: **Pfenning, Meinig & Partner mbB Patent- und Rechtsanwälte
Theresienhöhe 11a
80339 München (DE)**

(56) Entgegenhaltungen:
**DE-A1- 10 020 784      DE-A1-102008 049 056
US-A1- 2011 155 219**

• **LUNGENSCHMIED ET AL: "Flexible, long-lived, large-area, organic solar cells", SOLAR ENERGY MATERIALS AND SOLAR CELLS, ELSEVIER SCIENCE PUBLISHERS, AMSTERDAM, NL, Bd. 91, Nr. 5, 26. Januar 2007 (2007-01-26), Seiten 379-384, XP005862266, ISSN: 0927-0248, DOI: 10.1016/J.SOLMAT.2006.10.013**

**Beschreibung**

Die vorliegende Erfindung betrifft ein Verfahren zur Herstellung einer Dünnschichtsolarzellenanordnung, bei der mehrere einzelne Dünnschichtsolarzellen auf einem Substrat appliziert sind. Die einzelnen Dünnschichtsolarzellen sind dabei bereichsweise übereinander abgeschieden, sodass ein Überlappbereich aus jeweils einem Paar zweier einzelner Dünnschichtsolarzellen entsteht; in diesem Bereich liegt eine serielle Verschaltung der beiden, das Paar bildenden Dünnschichtsolarzellen vor. Zudem weist die Dünnschichtsolarzellenanordnung einen Übergangsbereich auf, in dem die auf der ersten Solarzelle applizierte Dünnschichtsolarzelle in eine darunter liegende Lage überführt wird.

Bei der Aufskalierung von Solarzellen, organischen Leuchtdioden und Batterien besteht das Problem, dass der Strom proportional zur Fläche anwächst. Da der Ohm'sche Leistungsverlust quadratisch mit dem Strom ansteigt, ergeben sich hieraus klare Grenzen für die Größe von Einzelzellen. Dieses Problem wird in der Regel durch die

    1. Verwendung von sehr leitfähigen Leiterbahnen (meist Silber) sowie die
    2. serielle Verschaltung von Zellelementen zu einem Modul gelöst.

In letzterem Fall bleibt der Strom bei Vergrößerung der Modulfläche konstant und die Spannung steigt proportional zur Größe des Moduls. Allerdings ist hiermit ein deutlicher Verlust von aktiver Fläche und damit Wirkungsgrad verbunden.

Für kleinflächige Anwendungen besteht oft das Problem, auf geringer Fläche eine ausreichend hohe Spannung zu erreichen. Bei einer konventionellen Verschaltung führt dies zwangsläufig zu einem sehr hohen relativen Flächen- und damit Effizienzverlust. Man kann dieses Problem lösen, indem man mehrere teiltransparenten Solarzellen/oLEDs/Batterien stapelt, um eine höhere Spannung und geringere Stromdichten zu erreichen, wodurch weniger Zellstreifen benötigt werden. Jedoch stellt sich das Problem, dass alle Subzellen den gleichen Strom liefern/konsumieren müssen. Dies kann z.B. für Solarzellen durch Anpassung der Schichtdecken jedoch nur für ein bestimmtes Spektrum gewährleistet werden.

Bei Dünnschichtsolarzellen wird zur Vermeidung Ohm'scher Leistungsverluste in der transparenten Elektrode in der Regel eine monolithische Serienschaltung erzeugt, indem die einzelnen Schichten der Solarzelle periodisch in individuelle Streifen strukturiert werden, wobei bestimmte Schichten einen definierten Überlapp aufweisen, um den Pluspol eines Streifens mit dem Minuspol des benachbarten Streifens elektrisch zu verbinden, ohne dass zwischen den Polen eines Streifens ein Kurzschluss entsteht. Ähnlich kann auch für großflächige oLEDs oder Batterien vorgegangen werden. Diese Verschaltungsbereich liefern keinen Strom/Licht und stellen somit einen Flächen- und damit Leistungs-/Effizienzverlust dar. Da die jeweiligen Schichten zumindest teilweise vor der Beschichtung mit den weiteren Schichten strukturiert werden müssen, stellt diese Verschaltung hohe Anforderungen an die Wiederholungsgenauigkeit bzw. Registerhaltigkeit. Es werden mindestens drei, eher fünf Mal die minimale Strukturgröße bzw. Toleranz für die Verschaltung benötigt. Je mehr Schichten der Stapel beinhaltet, desto kritischer wird dieses Problem. Eine weitere Möglichkeit ist die Herstellung einzelner Zelleelemente, wobei einer der Kontakte auf die Rückseite geführt wird und diese Zellelemente dann schindelartig mit geringem Überlapp aufeinander befestigt werden (DE 10 2008 049056, DE 100 20 784). Hierdurch wird der Flächenverlust deutlich reduziert. Nachteilig hierbei sind die hohen Anforderungen an die Positioniergenauigkeit, ein relativ aufwendiges Handling der meist kleinen Einzelelemente sowie die resultierende stark unebene Topographie, aus der eine aufwendigere Verkapselung resultiert und auch mechanische Sollbruchstellen entstehen.

LUNGENSCHMIED ET AL: "Flexible, long-lived, large-area, organic solar cells", SOLAR ENERGY MATERIALS AND SOLAR CELLS, Bd. 91, Nr. 5, Seiten 379-384, offenbart ein Verfahren zur Herstellung einer Dünnschichtsolarzellenanordnung, umfassend eine Mehrzahl von auf einem Substrat aufgebrachten Dünnschichtsolarzellen, die jeweils zumindest eine erste, dem Substrat zugewandte Rückseitenelektrode, eine zweite Elektrode und/oder eine Konversionsschicht sowie eine zwischen der Rückseitenelektrode und der zweiten Elektrode und/oder der Konversionsschicht angeordnete photoaktive Schicht umfassen, wobei die Dünnschichtsolarzellen miteinander verbunden und elektrisch seriell verschaltet sind.

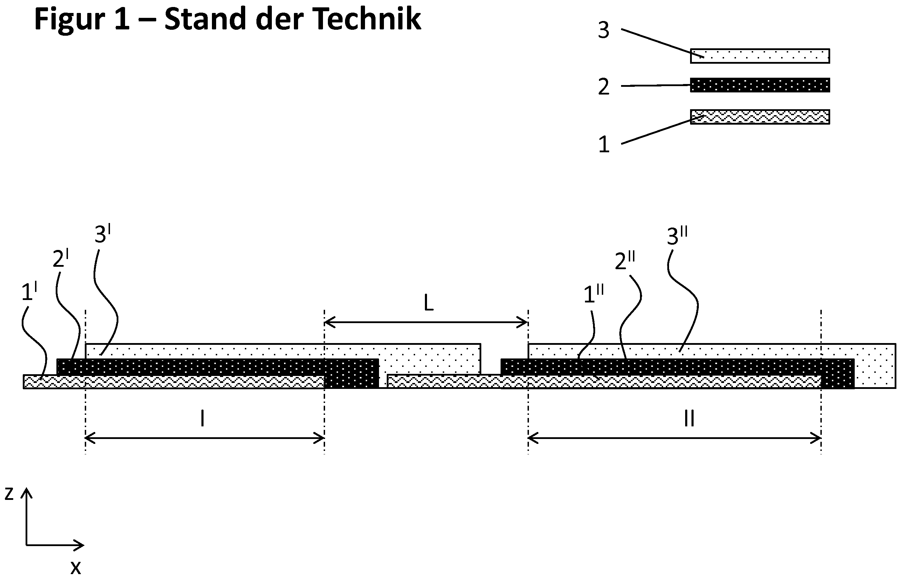

Eine gewöhnliche, aus dem Stand der Technik bekannte Anordnung von Dünnschichtsolarzellen ist in Figur 1 beschrieben. Hinsichtlich der Bedeutung der Bezugszeichen und der verwendeten Terminologie wird auf die für die Figuren 1 ff. weiter unten stehenden Definitionen verwiesen. Dargestellt sind mehrere, in x-Richtung nebeneinander aufgebrachte Dünnschichtsolarzellen (I und II). Die jeweiligen Dünnschichtsolarzellen weisen dabei jeweils eine Rückseitenelektrode (1), eine in z-Richtung über der Elektrode (1) aufgebrachte photoaktive Schicht (2), sowie eine hierauf aufgebrachte zweite Elektrode und/oder eine Konversionsschicht (3) auf. Sämtliche prinzipiell in Figur 1 dargestellten Bestandteile derartiger Dünnschichtsolarzellen, d.h. Elektrode (1) photoaktive Schicht (2) sowie Konversionsschicht (3) können dabei einschichtig ausgebildet sein, jedoch auch aus mehreren Schichten bestehen (z.B. einer leitfähigen Schicht und einer Ladungsträger-selektiven Schicht, ebenso sind mehrere Schichten möglich. Beispielsweise kann ebenso die photoaktive Schicht (2) eine innere Struktur aufweisen (z.B. zwei oder mehr Schichten übereinander oder ein interpenetrierendes Netzwerk aus zwei oder mehr Materialien). Beispielhaft ist ebenso möglich, dass die Elektroden eine Konversionsschicht beinhalten können. Die Teilsolarzellen können jeweils auch Mehrfachsolarzellen (Multijunction-Solarzellen) sein. Die derartige Vielfalt an Möglichkeiten für die einzelnen Bestandteile der Dünnschichtsolarzellen sind sowohl für die aus dem Stand der Technik bekannte Dünnschichtsolarzelle gemäß Figur 1 gültig, wie auch sämtliche nachfolgend dargestellten Ausführungsformen der mit dem erfindungsgemäßen Verfahren hergestellten Dünnschichtsolarzellen.

Die Erzeugung von Strom bei der in Figur 1 dargestellten Dünnschichtsolarzellenanordnung ist auf die Flächen beschränkt, in denen sämtliche der drei Schichten (Rückseitenelektrode, photoaktive Schicht sowie zweite Elektrode und/oder Konversionsschicht) übereinander liegend angeordnet sind. Die jeweiligen einzelnen Schichten der einzelnen Solarzellen sind dabei gestuft ausgeführt (in Figur 1 bei den jeweiligen Solarzellen I und II jeweils links dargestellt), um elektrische Kurzschlüsse der Solarzellen zu vermeiden. In einem Bereich (L) erfolgt eine serielle Verschaltung der einzelnen Solarzellenmodule I und II, in dem die obere Elektrode und/oder Konversionsschicht ($3^I$) der ersten Solarzelle (I) mit der Rückseitenelektrode ($1^{II}$) der zweiten Dünnschichtsolarzelle (II) kontaktiert wird. Eine derartige serielle Verschaltung wird im Stand der Technik als "monolithische Serienverschaltung" bezeichnet. Erkennbar ist, dass im Bereich (L) keine Solarzelle ausgebildet ist, da in diesem Bereich die drei, eine jeweilige Solarzelle bildenden Schichten (1, 2 und 3) nicht übereinander liegend angeordnet sind. Die im Bereich (L) ausgebildete Fläche einer derartigen Dünnschichtsolarzellenanordnung kann somit nicht zur Stromgewinnung genutzt werden.

Ausgehend hiervon ist es somit Aufgabe der vorliegenden Erfindung, ein Verfahren anzugeben um eine verbesserte Dünnschichtsolarzellenanordnung herzustellen, mit der eine höhere Stromausbeute erzielbar ist, und mit der die aus dem Stand der Technik bekannten mechanischen Problematiken gelöst werden können. Kern der Erfindung ist ein Verfahren um durch direktes Abscheiden/strukturieren der Funktionsschichten in geeigneter räumlicher und zeitlicher Abfolge eine schindelartige Struktur zu erzeugen, die bislang nur durch Vorfertigen, Zerschneiden und mechanisches Übereinanderplatzieren zugänglich war. Hierfür ist es erforderlich, getrennte Bereiche der jeweiligen Funktionsschichten zu erzeugen. Die kann direkt durch strukturiertes Abscheiden oder indirekt durch ein vollflächiges Abscheiden mit anschließendem selektiven oder teilselektiven Abtrag, z.B. durch Laserstrukturierung oder mechanischen Abtrag erfolgen.

Diese Aufgabe wird mit den Merkmalen des Patentanspruchs 1 gelöst. Die jeweiligen abhängigen Patentansprüche stellen dabei vorteilhafte Weiterbildungen dar.

Die Erfindung betrifft somit ein Verfahren zur Herstellung einer Dünnschichtsolarzellenanordnung, umfassend eine Mehrzahl von auf einem Substrat (S) aufgebrachten Dünnschichtsolarzellen (I, II, III, ...), die jeweils zumindest eine erste, dem Substrat (S) zugewandte Rückseitenelektrode ($1^I$, $1^{II}$, $1^{III}$, ...), eine zweite Elektrode und/oder eine Konversionsschicht ($3^I$, $3"$, $3^{III}$, ...) sowie eine zwischen der Rückseitenelektrode ($1^I$, $1^{II}$, $1^{III}$, ...) und der zweiten Elektrode und/oder der Konversionsschicht ($3^I$, $3^{II}$, $3^{III}$, ...) angeordnete photoaktive Schicht ($2^I$, $2^{II}$, $2^{III}$, ...) umfassen, wobei die Dünnschichtsolarzellenanordnung

a) mindestens einen Überlappbereich (B) aufweist, in dem jeweils eine erste (I, II, ...) und eine zweite Dünnschichtsolarzelle (II, III, ...) in zwei Lagen (n, n+1, ...) paarweise (I-II, II-III, ...) übereinander liegend angeordnet sind, wobei ein Bereich derjeweils ersten Dünnschichtsolarzelle (I, II, ...) in einer ersten Lage (n, ...) und ein Bereich der jeweils zweiten Dünnschichtsolarzelle (II, III, ...), der auf der vom Substrat (S) abgewandten Seite derjeweils ersten Dünnschichtsolarzelle (I, II, ...) in einer über der jeweils ersten Dünnschichtsolarzelle (I, II, ...) liegenden Lage (n+1, ...) angeordnet ist, miteinander verbunden und elektrisch seriell verschaltet sind, und

b) mindestens einen Übergangsbereich (A) aufweist, in dem jeweils nur die jeweils zweite Dünnschichtsolarzelle (II, III, ...) des Paares aus jeweils erster und jeweils zweiter Dünnschichtsolarzelle (I-II, II-III, ...) ausgebildet ist, wobei die in der über der ersten Lage liegende Lage (n+1, ...) ausgebildete Rückseitenelektrode $\left( 1^{II}_{n+1} , 1^{III}_{n+1} , ... \right)$, die photoaktive Schicht $\left( 2^{II}_{n+1} , 2^{III}_{n+1} , ... \right)$ und die zweite Elektrode und/oder die Konversionsschicht $\left( 3^{II}_{n+1} , 3^{III}_{n+1} ... \right)$ der jeweils zweiten Dünnschichtsolarzelle (II, III, ...) in jeweils eine, in der ersten Lage (n, ...) ausgebildete Rückseitenelektrode $\left( 1^{II}_{n} , 1^{III}_{n} , ... \right)$, eine photoaktive Schicht $\left( 2^{II}_{n} , 2^{III}_{n} , ... \right)$ und eine zweite Elektrode und/oder eine Konversionsschicht $\left( 3^{II}_{n} , 3^{III}_{n} ... \right)$ überführt wird.

Die erfindungsgemäß hergestellte Dünnschichtsolarzellenanordnung gemäß der vorliegenden Erfindung umfasst somit mehrere Dünnschichtsolarzellen, die jeweils eine Rückseitenelektrode, eine photoaktive Schicht sowie eine zweite Elektrode und/oder Konversionsschicht aufweisen. Diese essentiellen Bestandteile der Dünnschichtsolarzellen werden im Folgenden auch als "Schichten" oder "aktive Schichten" bezeichnet.

Als Substrat wird ein Träger bezeichnet, auf dem der Solarzellenstapel bestehend aus mindestens 1. Elektrode, photoaktiver Schicht und 2. Elektrode aufgebracht wird. Dies schließt die aus der Dünnschichtphotovoltaik bekannten Substrat und Superstrat Konfigurationen ein. Für den Fall, dass die aktiven Schichten der Dünnschichtsolarzellenanordnung auf einem Superstrat aufgebracht sind, stellt die oben genannte Rückseitenelektrode (1) somit die Front- oder Vorseitenelektrode dar, während die zweite Elektrode (3) in diesem Fall eher als Rückseitenelektrode zu bezeichnen ist. Da sich an den prinzipiellen konstruktiven Prinzipien eines auf einem Superstrat basierenden Aufbaus einer Dünnschichtsolarzellenanordnung jedoch nichts ändert, wird im Nachfolgenden die Terminologie für eine Substrat-basierte Dünnschichtsolarzellenanordnung verwendet, explizit sei aber betont, dass diese konstruktiven Prinzipien ebenso auf Superstrat-basierte Dünnschichtsolarzellen anwendbar und übertragbar sind. Die Superstrat-basierten Dünnschichtsolarzellen sind somit ebenso vom erfindungsgemäßen Konzept umfasst.

Gemäß der vorliegenden Erfindung ist nunmehr vorgesehen, dass die einzelnen Dünnschichtsolarzellen, die die Dünnschichtsolarzellenanordnung bilden, versetzt zueinander angeordnet werden, wobei jeweils zwei Dünnschichtsolarzellen paarweise in einem Überlappbereich übereinander liegend angeordnet sind bzw. abgeschieden werden. In diesem Überlappbereich erfolgt eine serielle Verschaltung dieser beiden Dünnschichtsolarzellen eines jeweiligen Paares.

Zudem ist erfindungsgemäß vorgesehen, dass mindestens ein Übergangsbereich in der Dünnschichtsolarzellenanordnung vorhanden ist. In diesem Übergangsbereich erfolgt eine Überführung derjenigen Solarzelle, die in einem Paar aus zwei Solarzellen über der jeweiligen anderen Solarzelle angeordnet bzw. laminiert ist, in eine darunter liegende Lage. In diesem Übergangsbereich ist somit nur die zweite Solarzelle des Paars aus erster und zweiter Solarzelle ausgebildet. Der Begriff "laminieren" bzw. "auflaminiert" etc. wird dabei im Sinne der vorliegenden Erfindung synonym mit "abscheiden" bzw. "abgeschieden" verwendet.

Die somit nunmehr in der untenliegenden Lage ausgebildete Solarzelle kann mit einer weiteren Solarzelle gemäß den zuvor beschriebenen Prinzipien seriell verschaltet werden, sodass eine iterative Anordnung von mehreren seriell verschalteten Solarzellen erhalten werden kann.

Besonders bevorzugt dabei ist, dass der Bereich der monolithischen Verschaltung (Bereich L, siehe Figur 1) der monolithisch verschalteten Solarzellen, wie sie aus dem Stand der Technik bekannt sind, vollständig zur Energiegewinnung genutzt werden kann, da in diesem Bereich (erfindungsgemäß entspricht dies dem Übergangsbereich A) nunmehr ebenso eine aktive Solarzelle vorhanden ist, da auch hier ein aktiver Stapel der jeweiligen Schichten eines Dünnschichtsolarzellenmoduls vorhanden ist. Flächenverluste, durch nichtaktive Bereiche innerhalb einer Dünnschichtsolarzellenanordnung können somit vollständig vermieden werden.

Das vorgeschlagene Verfahren erlaubt die Herstellung von besonders schmalen Teilsolarzellen und macht insbesondere den Einsatz sehr geringer Verschaltungsabstände trotz signifikanter Strukturdimensionen und Toleranzen möglich. So kann die Streifenbreite der aktiven Schichten in der gleichen Größenordnung liegen, wie die minimal mögliche Strukturdimension bzw. Registertoleranz. Durch den geringeren Flächenverlust und geringere Abstände kann der Wirkungsgrad ggf. deutlich gesteigert werden. Dieses Verfahren erlaubt auch den Einsatz von transparenten Elektroden mit besonders geringer Leitfähigkeit. Dadurch kann eine Steigerung der Transparenz und damit des Wirkungsgrades erzielt werden, oder es können besonders kostengünstige Materialien eingesetzt werden. Darüber hinaus kann durch Überlappen mehrerer Solarzellen auf sehr kleinen Flächen sehr hohe Spannungen erreicht werden.

Weiterhin kann bei gleicher oder ähnlicher Investition die Produktionsgeschwindigkeit erhöht werden, da anstelle einer nachträglichen Schneide- und Laminiervorrichtung weitere Abscheidequellen eingesetzt werden.

Beim erfindungsgemäßen Verfahren werden auf einem Substrat (S) gleichzeitig oder nacheinander mehrere Dünnschichtsolarzellen (I, II, III, ...) durch jeweiliges gleichzeitiges oder nacheinander erfolgendes Abscheiden zumindest einer ersten, dem Substrat (S) zugewandten Rückseitenelektrode ($1^I$, $1^{II}$, $1^{III}$, ...), zumindest einer darüber angeordneten photoaktiven Schicht ($2^I$, $2^{II}$, $2^{III}$, ...) sowie zumindest einer darüber angeordneten zweiten Elektrode und/oder einer Konversionsschicht ($3^I$, $3^{II}$, $3^{III}$, ...) auf dem Substrat (S) erzeugt, wobei zumindest zwei Dünnschichtsolarzellen (I, II, III, ...) in mindestens einem Überlappbereich (B) paarweise (I-II, II-III) in mindestens zwei Lagen (n, n+1, ...) übereinander liegend erzeugt werden, indem die jeweils zweite Dünnschichtsolarzelle (II, III, ...) eines jeden Paares (I-II, II-III) aus erster (I, II, ...) und zweiter Dünnschichtsolarzelle (II, III, ...) bereichsweise in einer über der jeweils ersten Dünnschichtsolarzelle liegenden Lage (n+1, n+2, ...) abgeschieden wird und die jeweils erste (I, II, ...) und zweite Dünnschichtsolarzelle (II, III, ...) in diesem Bereich (B) elektrisch seriell verschaltet werden, und die jeweils zweite Dünnschichtsolarzelle (II, III, ...) eines jeden Paares aus erster (I, II, ...) und zweiter Dünnschichtsolarzelle (II, III, ...) versetzt zur jeweils ersten Dünnschichtsolarzelle (I, II, ...) eines jeden Paares aus erster (I, II, ...) und zweiter Dünnschichtsolarzelle (II, III, ...) abgeschieden wird, so dass ein Übergangsbereich (A) ausgebildet wird, in dem die Rückseitenelektrode ($1^{II}$, $1^{III}$, ...), die darüber angeordnete photoaktive Schicht ($2^{II}$, $2^{III}$, ...) sowie die darüber angeordnete zweite Elektrode und/oder die Konversionsschicht ($3^{II}$, $3^{III}$, ...) der jeweils zweiten Dünnschichtsolarzelle eines jeden Paares aus erster (I, II, ...) und zweiter Dünnschichtsolarzelle (II, III, ...) aus der über der jeweils ersten Dünnschichtsolarzelle liegenden Lage (n+1, n+2, ...) auf eine darunterliegende Lage (n, n+1) überführt wird.

Das erfindungsgemäße Verfahren ermöglicht die Herstellung einer zuvor beschriebenen Dünnschichtsolarzellenanordnung, bei der jeweils paarweise zwei Dünnschichtsolarzellen in einem Überlappbereich seriell miteinander verschaltet und übereinander liegend appliziert sind, wobei in einem Übergangsbereich die jeweils zweite Dünnschichtsolarzelle eines Paares aus erster und zweiter Dünnschichtsolarzelle aus einer oberhalb der ersten Solarzelle liegenden Lage in eine darunter liegende Lage überführt wird. Gemäß dem erfindungsgemäßen Verfahren können die Solarzellen in zwei Lagen, aber auch mehr als zwei Lagen durch jeweiliges Wiederholen des Erzeugens der jeweiligen Dünnschichtsolarzellen abgeschieden werden. Zudem ist es auch möglich, mehrere Dünnschichtsolarzellen (in x-Richtung) paarweise seriell zu verschalten, sodass eine Vielzahl von nebeneinander angeordneten seriell verschalteten Dünnschichtsolarzellen resultiert.

Bevorzugt ist, wenn mehrere Paare (I-II, II-III, ...) aus erster (I, II, ...) und zweiter Dünnschichtsolarzelle (II, III, ...) iterativ angeordnet sind, wobei mehrere Überlappbereiche ($B^{I\text{-}II}$, $B^{I\text{-}III}$, ...) mit paarweise verbundenden Dünnschichtsolarzellen (I-II, II-III, ...) sowie mehrere Übergangsbereiche ($A^{I}$, $A^{II}$, ...) der jeweils zweiten Dünnschichtsolarzelle (II, III, ...) der mehreren Paare (I-II, II-III, ...) aus erster (I, II, ...) und zweiter Dünnschichtsolarzelle (II, III, ...) vorhanden sind.

Diese bevorzugte Ausführungsform sieht vor, dass mehrere Dünnschichtsolarzellen jeweils versetzt zueinander angeordnet sind, und jeweils paarweise miteinander seriell verschaltet sind. Beispielsweise kann eine erste Solarzelle (I) mit einer zweiten Solarzelle (II) durch einen Überlappbereich (B) miteinander seriell verschaltet sein, die erste Solarzelle (I) und die zweite Solarzelle (II) bilden dabei ein Paar. Weiterhin kann die zweite Solarzelle (II) mit einer dritten Solarzelle (III) ebenso in einem Überlappbereich (B) miteinander seriell verschaltet sein, dabei bildet die zweite Solarzelle (II) mit der dritten Solarzelle (III) ebenso ein Paar. Das jeweilige Paar von Dünnschichtsolarzellen (I-II, II-III) weist dabei jeweils einen Übergangsbereich auf, der in der jeweiligen zweiten Solarzelle des jeweiligen Paares, also beim Paar der Solarzelle (I-II) in der Solarzelle (II) sowie beim Paar der Solarzellen (II-III) in der Solarzelle (III), ausgebildet ist. In diesem Übergangsbereich wird die zweite Solarzelle desjeweiligen Paares in eine darunter liegende Lage überführt.

Die jeweiligen Solarzellen sind dabei in mindestens zwei Lagen ausgebildet.

Es kann beispielsweise vorgesehen sein, dass die Mehrzahl von Dünnschichtsolarzellen in zwei Lagen (n, n+1) angeordnet sind, wobei jeweils die zweite Dünnschichtsolarzelle (II, III, ...) eines Paares aus jeweils erster und jeweils zweiter Dünnschichtsolarzelle (I-II, II-III, ...) einen Übergangsbereich ($A^{I}$, $A^{II}$, ...) aufweist, in dem die in der zweiten Lage (n+1) ausgebildete Rückseitenelektrode $\left(1^{II}_{n+1}, 1^{III}_{n+1}, ...\right)$, die photoaktive Schicht $\left(2^{II}_{n+1}, 2^{III}_{n+1}, ...\right)$ und die zweite Elektrode und/oder die Konversionsschicht $\left(3^{II}_{n+1}, 3^{III}_{n+1} ...\right)$ der jeweils zweiten Dünnschichtsolarzelle (II, III, ...) in jeweils eine, in der ersten Lage (n, ...) ausgebildete Rückseitenelektrode $\left(1^{II}_{n}, 1^{III}_{n}, ...\right)$, eine photoaktive Schicht $\left(2^{II}_{n}, 2^{III}_{n}, ...\right)$ und eine zweite Elektrode und/oder eine Konversionsschicht $\left(3^{II}_{n}, 3^{III}_{n} ...\right)$ überführt wird.

Diese Ausführungsform sieht vor, dass mindestens zwei Solarzellen auf die zuvor beschriebene Weise paarweise nebeneinander versetzt angeordnet sind, und sämtliche Solarzellen in genau zwei Lagen ausgebildet sind. Die erste Solarzelle des Paares aus zwei Solarzellen ist dabei in einer ersten Ebene (n), die zweite Solarzelle des Paares aus zwei Solarzellen in einer Ebene (n+1) ausgebildet; in diesem Bereich liegt der Überlappbereich (B) der beiden Solarzellen. Im Übergangsbereich erfolgt eine Überführung der zweiten Solarzelle in die Lage der ersten Solarzelle des Paares (n). Der in dieser Lage (n) ausgebildete Bereich der zweiten Solarzelle kann somit genutzt werden, um eine dritte Solarzelle (III) durch Überlapp und Ausbilden eines weiteren Überlappbereichs (B) weiter seriell zu verschalten. Es ist eine iterative Anordnung von beliebig vielen Solarzellen möglich.

Eine weitere Ausführungsform sieht vor, dass die Mehrzahl von Dünnschichtsolarzellen in drei Lagen (n, n+1, n+2) angeordnet sind, wobei jeweils die zweite Dünnschichtsolarzelle (II, III, ...) eines Paares aus jeweils erster und jeweils zweiter Dünnschichtsolarzelle (I-II, II-III, ...) zwei stufenweise angeordnete Übergangsbereiche aufweist, wobei im ersten Übergangsbereich die in der dritten Lage (n+2) ausgebildete Rückseitenelektrode, die photoaktive Schicht und die zweite Elektrode und/oder die Konversionsschicht derjeweils zweiten Dünnschichtsolarzelle (II, III, ...) in jeweils eine, in der zweiten Lage (n+1) und im zweiten Übergangsbereich in eine in der ersten Lage (n) ausgebildete Rückseitenelektrode, eine photoaktive Schicht und eine zweite Elektrode und/oder eine Konversionsschicht überführt wird.

Gemäß dieser bevorzugten Ausführungsform sind die jeweiligen Dünnschichtsolarzellen in drei Lagen ausgebildet. Dabei findet eine stufenweise Überführung der Solarzelle, die in der obersten Lage (n+2) ausgebildet ist, durch zwei Übergangsbereiche auf die unterste Lage (n). In den zwischen den jeweiligen Übergangsbereichen (A) ausgebildeten Bereichen erfolgt zumindest bereichsweise eine serielle Verschaltung (Überlappbereiche B) mit unter oder über dieser Solarzelle angeordneten Solarzellen.

Weiter kann es möglich sein, dass die Mehrzahl von Dünnschichtsolarzellen in vier Lagen (n, n+1, n+2, n+3) angeordnet sind, wobei jeweils die zweite Dünnschichtsolarzelle (II, III, ...) eines Paares aus jeweils erster und jeweils zweiter Dünnschichtsolarzelle (I-II, II-III, ...) drei stufenweise angeordnete Übergangsbereiche aufweist, wobei im ersten Übergangsbereich die in der vierten Lage (n+3) ausgebildete Rückseitenelektrode, die photoaktive Schicht und die zweite Elektrode und/oder die Konversionsschicht derjeweils zweiten Dünnschichtsolarzelle (II, III, ...) in jeweils eine, in der dritten Lage (n+2), im zweiten Übergangsbereich in eine in der zweiten Lage (n+1) und im dritten Übergangsbereich in eine in der ersten Lage (n) ausgebildete Rückseitenelektrode, eine photoaktive Schicht und eine zweite Elektrode und/oder eine Konversionsschicht überführt wird.

Eine derartige Anordnung ist die Fortführung des bereits weiter oben beschriebenen Konzepts, bei dem die Dünnschichtsolarzellen in drei Lagen angeordnet sind. Hier erfolgt eine stufenweise Überführung der Dünnschichtsolarzelle, ausgehend von der obersten Lage (n+3) in die jeweils darunter liegenden Lagen (n+2, n+1 sowie n) in entsprechenden Übergangsbereichen (A). Zwischen den jeweiligen Übergangsbereichen (A) erfolgt eine serielle Verschaltung dieser Solarzelle jeweils paarweise mit darüber und/oder darunter ausgebildeten Solarzellen.

Bevorzugt beträgt die Breite (in x-Richtung) eines jeden Überlappbereichs (B) eines jeden Paares aus jeweils erster und jeweils zweiter Dünnschichtsolarzelle (I-II, II-III, ...) zwischen dem 0,01 und 0,99-fachen, bevorzugt zwischen dem 0,01 und dem 0,1-fachen, dem 0,4 bis 0,6-fachen, oder dem 0,9 bis 0,99-fachen der Länge derjeweils zweiten Dünnschichtsolarzelle (II, III, ...).

Falls ein kleines Breitenverhältnis, das beispielsweise zwischen dem 0,01- und dem 0,1-fachen für den Überlappbereich gewählt ist, kann dieser Überlappbereich zur seriellen Verschaltung der einzelnen Solarzellen eines jeweiligen Paares aus Dünnschichtsolarzellen verwendet werden. Dabei ist über die restliche Breite im Wesentlichen lediglich eine Solarzelle vollflächig im Dünnschichtsolarzellenmodul ausgebildet. Sofern ein größeres Breitenverhältnis gewählt wird, beispielsweise zwischen dem 0,9- und 0,99-fachen der Länge derjeweils zweiten Dünnschichtsolarzelle eines Paares aus Dünnschichtsolarzellen, sind über die gesamte Breite der Dünnschichtsolarzellenanordnung im Wesentlichen mehrere übereinander angeordnete Lagen von Solarzellen angeordnet.

Ebenso ist es möglich, den Überlappbereich zur seriellen Verschaltung der einzelnen Solarzellen eines jeweiligen Paares aus Dünnschichtsolarzellen zwischen einem breiten Verhältnis, das beispielsweise zwischen dem 0,4 bis 0,6-fachen beträgt, auszugestalten. Dies ist insbesondere dann von Vorteil, wenn die Länge derjeweiligen Dünnschichtsolarzellen in Bereichen liegt, in denen Toleranzfehler der Länge dieser Dünnschichtsolarzellen zum Tragen kommen bzw. die Länge derartiger Dünnschichtsolarzellen in Bereichen der minimal möglichen Strukturdimensionen liegt.

Die Verbindung der einzelnen Bereiche der jeweiligen Dünnschichtsolarzellen eines Paares aus zwei Dünnschichtsolarzellen erfolgt im Überlappbereich (B) dabei bevorzugt durch direkten Verbund der zweiten Elektrode und/oder der Konversionsschicht $\left(3_n^I, 3_n^{II}, ...\right)$ der jeweils ersten Dünnschichtsolarzelle (I, II, ...) mit einer Rückseitenelektrode $\left(1_{n+1}^{II}, 1_{n+1}^{III}, ...\right)$ der jeweils zweiten Dünnschichtsolarzelle (II, III, ...) des Paares aus jeweils erster und jeweils zweiter Dünnschichtsolarzelle (I-II, II-III, ...).

Ebenso kann vorgesehen sein, dass die Verbindung durch einen elektrisch leitenden Verbund der zweiten Elektrode und/oder der Konversionsschicht $\left(3_n^I, 3_n^{II}, ...\right)$ der jeweils ersten Dünnschichtsolarzelle (I, II, ...) mit einer Rückseitenelektrode $\left(1_{n+1}^{II}, 1_{n+1}^{III}, ...\right)$ der jeweils zweiten Dünnschichtsolarzelle (II, III, ...) des Paares aus jeweils erster und jeweils zweiter Dünnschichtsolarzelle (I-II, II-III, ...) mittels einer elektrisch leitenden Klebeschicht (K') realisiert ist.

Eine weitere, ebenso bevorzugte Möglichkeit sieht vor, dass die Verbindung der jeweiligen Solarzellen im Überlappbereich durch einen elektrisch isolierenden Verbund der zweiten Elektrode und/oder der Konversionsschicht $\left(3_n^I, 3_n^{II}, ...\right)$ derjeweils ersten Dünnschichtsolarzelle (I, II, ...) mit einer Rückseitenelektrode $\left(1_{n+1}^{II}, 1_{n+1}^{III}, ...\right)$ derjeweils zweiten Dünnschichtsolarzelle (II, III, ...) des Paares aus jeweils erster und jeweils zweiter Dünnschichtsolarzelle (I-II, II-III, ...) mittels einer elektrisch isolierenden Klebeschicht (K) realisiert ist, wobei die elektrische Kontaktierung der zweiten Elektrode und/oder der Konversionsschicht $\left(3_n^I, 3_n^{II}, ...\right)$ der jeweils ersten Dünnschichtsolarzelle (I, II, ...) mit der Rückseitenelektrode $\left(1_{n+1}^{II}, 1_{n+1}^{III}, ...\right)$ der jeweils zweiten Dünnschichtsolarzelle (II, III, ...) durch eine elektrisch leitende Verbindung (7) realisiert ist.

Im Übergangsbereich (A) kann die jeweils erste Dünnschichtsolarzelle (I, II, ...) des Paares aus jeweils erster und jeweils zweiter Dünnschichtsolarzelle (I-II, II-III, ...) mit der jeweils zweiten Dünnschichtsolarzelle (II, III, ...) monolithisch verschaltet sein. Gemäß dieser Ausführungsform findet im Übergangsbereich (A) eine parallele Verschaltung des in einer Lage (n+1) angeordneten Bereichs der zweiten Dünnschichtsolarzelle des Paares aus erster und zweiter Dünnschichtsolarzelle mit dem auf der weiter unten liegenden Lage (n) angeordneten Bereich der zweiten Dünnschichtsolarzelle des Paares aus erster und zweiter Dünnschichtsolarzelle statt. Diese Ausgestaltungsform kann beispielsweise dadurch realisiert sein, dass die jeweiligen Schichten dieser zweiten Dünnschichtsolarzelle übereinander liegend von einer höher liegenden Lage (n+1) in die darunter liegende Lage (n) überführt werden.

Ebenso ist es bevorzugt, dass im Übergangsbereich (A) die Rückseitenelektrode ($1^I$, $1^{II}$, ...), die photoaktive Schicht ($2^I$, $2^{II}$, ...) und die zweite Elektrode und/oder die Konversionsschicht ($3^I$, 3", ...) der jeweils ersten Dünnschichtsolarzelle (I, II, ...) des Paares aus jeweils erster und jeweils zweiter Dünnschichtsolarzelle (I-II, II-III, ...) terminiert und elektrisch von der zweiten Dünnschichtsolarzelle (II, III, ...) isoliert sind, wobei die Terminierung bevorzugt durch einen elektrischen Isolator (4) realisiert ist. Gemäß dieser Ausführungsform ist eine Terminierung der jeweiligen Schichten der ersten Solarzelle des Paares aus erster und zweiter Solarzelle vorhanden, um beispielsweise einen elektrischen Kurzschluss der aktiven Schichten der ersten Dünnschichtsolarzelle und/oder etwaige Kurzschlüsse der Solarzellen untereinander (z.B. Kurzschluss zwischen den Rückseitenelektroden $1_n^I$ und $1_{n+1}^{II}$ )zu verhindern.

Eine weitere vorteilhafte Ausgestaltung sieht vor, dass im Übergangsbereich (A) die Rückseitenelektrode ($1^{II}$, $1^{III}$, ...), die photoaktive Schicht ($2^{II}$, $2^{III}$, ...) und die zweite Elektrode und/oder die Konversionsschicht ($3"$, $3^{III}$, ...) der jeweils zweiten Dünnschichtsolarzelle (II, III, ...) des Paares aus jeweils erster und jeweils zweiter Dünnschichtsolarzelle (I-II, II-III, ...) zumindest bereichsweise senkrecht zum Substrat (S), S-förmig oder geradlinig in die erste Lage (n, ...) überführt wird.

Die Verbindung der einzelnen Dünnschichtsolarzellen der Dünnschichtsolarzellenanordnung erfolgt dabei bevorzugt derart, dass die einzelnen Solarzellen in der untersten Lage (n), die mit dem Substrat (S) in Verbindung steht die jeweiligen Rückseitenelektroden der einzelnen Dünnschichtsolarzellen vollflächig mit dem Substrat verbunden sind. Zusätzlich ist es ebenso möglich, dass auch im Übergansbereich (A) die jeweiligen Schichten der jeweiligen zweiten Dünnschichtsolarzelle eines Paares aus erster und zweiter Dünnschichtsolarzelle verbunden sind.

Der angesprochene Verbund kann dabei durch direktes Abscheiden (z.B. Laminierung) der Rückseitenelektrode $\left(1^I, 1_n^I, 1_n^{II}, 1_n^{III}, ...\right)$ auf dem Substrat (S), durch eine elektrisch leitfähige Klebeschicht (K') oder eine elektrisch isolierende Klebeschicht (K) realisiert sein.

Insbesondere sind die Dünnschichtsolarzellen der Dünnschichtsolarzellenanordnung jeweils anorganische oder organische Dünnschichtsolarzellen.

Weiter ist es bevorzugt, wenn jeweils unabhängig voneinander die Schichtdicken der Rückseitenelektrode ($1^I$, $1^{II}$, $1^{III}$, ...) zwischen 1nm und 5$\mu$m, bevorzugt zwischen 5nm und 1 $\mu$m, besonders bevorzugt zwischen 10nm und 200nm, der zweiten Elektrode und/oder der Konversionsschicht ($3^I$, $3"$, $3^{III}$, ...) zwischen 1nm und 5$\mu$m, bevorzugt zwischen 5nm und 1 $\mu$m, besonders bevorzugt zwischen 10nm und 200nm, und/oder der photoaktiven Schicht ($2^I$, $2^{II}$, $2^{III}$, ...) zwischen 1nm und 5$\mu$m, bevorzugt zwischen 5nm und 1 $\mu$m, besonders bevorzugt zwischen 10nm und 200nm betragen.

Zudem ist es vorteilhaft, wenn unabhängig voneinander die Rückseitenelektrode ($1^I$, $1^{II}$, $1^{III}$, ...) und/oder die zweiten Elektrode und/oder die Konversionsschicht ($3^I$, $3^{II}$, $3^{III}$, ...) aus Metallen (z.B. Al, Ag, Cu), Metallnanostrukturen, Metalloxiden (z.B. ZnO, $TiO_2$,

$MoO_3$, $V_2O_5$), Dotierten Halbleitern mit hoher Bandlücke (Indium-Zinn-Oxid, Al:ZnO), Leitfähigen Polymeren wie Poly-Anilin oder Poly-(Ethylen-Dioxythiophen):Poly-(styrol-sulfonsäure) oder Kombinationen hieraus, und/oder die photoaktive Schicht ($2^I$, $2^{II}$, $2^{III}$, ...) aus anorganischen Halbleitern wie beispielsweise Si, a-Si:H, CuZnSnS, CuZnSnSe, GaAs, CuInS, CuInSe, CuInGeS, CuInGeSe, Ge, CdTe, Metalloxide wie $TiO_2$, ZnO, oder organischen Halbleitern wie beispielsweise poly-(3-Hexylthiophen), MetallPhtalozyaninen, Dicyanovinyl (DCV)-substituierte Quaterthiophenen, Fullerenderivaten oder hybriden Halbleitern wie Perovskiten, beispielsweise $CH_3NH_3PbI_3$ und Nanopartikeln der verschiedenen Materialien sowie Kombinationen hiervon gebildet ist oder derartige Materialien enthält.

Die Herstellung der erfindungsgemäßen Struktur kann durch verschiedene Abscheideverfahren sowohl aus der Gasphase mittels Physikalischer- und Chemischer Gasphasenabscheidung, als auch aus der Flüssigphase mittels Filmgießen, Sprühbeschichtung, Rakeln, sowie Druckverfahren wie Tiefdruck, Offsetdruck, Siebdruck oder Tintenstrahldruck erfolgen. Beispielsweise kann das Abscheiden der zumindest einen Rückseitenelektrode ($1^1$, $1^{II}$, $1^{III}$, ...), der photoaktiven Schicht ($2^I$, $2"$, $2^{III}$, ...) sowie der zweiten Elektrode und/oder Konversionsschicht ($3^I$, $3"$, $3^{III}$, ...) durch Abscheiden von flüssigen Precursormaterialien erfolgen, die in einem nachgelagerten Schritt zur jeweiligen Rückseitenelektrode ($1^I$, $1^{II}$, $1^{III}$, ...), der photoaktiven Schicht ($2^I$, $2^{II}$, $2^{III}$, ...) sowie der zweiten Elektrode und/oder Konversionsschicht ($3^I$, $3"$, $3^{III}$, ...) ausgehärtet und/oder getrocknet werden.

Derartige Precursor-materialen sind dabei bevorzugt flüssige Materialien, sodass ein Abscheiden beispielsweise mittels Filmgießen, Sprühbeschichtung und/oder Druckverfahren wie Tiefdruck, Offsetdruck, Siebdruck oder Tintenstrahldruck erfolgen kann.

Bevorzugte Precursor-Materialien bzw. Beschichtungsmassen/-medien für die Herstellung der einzelnen Schichten sind dabei für die

a) Rückseitenelektrode und/oder Konversionschicht ($1^I$, $1^{II}$, $1^{III}$, ...) und/oder die zweite Elektrode und/oder Konversionsschicht ($3^I$, $3"$, $3^{III}$ ...) Lösungen, Emulsionen oder Suspensionen von Poly(ethylendioxythiophen):Poly(Styrolsulfonsäure) in Wasser und Lösemitteln wie Isopropanol, Ethanol und anderen, ZnO Nanopartikel in Chloroform oder Aceton aus Zinkacetat-Dihydrat, ZnO Nanopartikel in Chloroform aus Diethylzink, Zincacetylacetonat-Hydrat in Ethanol, Titan-isopropoxid in Alkohol (Methanol, isopropanol, ethanol), $TiO_x$ NPs aus Titan(IV) isopropoxid in Isopropanol, $MoO_3$ NPs aus Ammonium-molybdat in wässriger Lösung, Molybden-(V)-isopropoxid in Butanol, Molybdentricarbonyl-trispropionitril in Acetonitril, Bis(2,4-pentandionato)-molybdendioxid in Isopropanol, $V_2O_5$ NPs in Isopropanol, Vanadium(V)-oxiisopropoxid in Isopropanol, Aluminium dotiertes Zinkoxid aus Zinkacetat und Aluminiumhydroxit-Acetat in Ethanol und Monoethanolamin, und/oder

b) die photoaktive Schicht ($2^I$, $2^{II}$, $2^{III}$, ...) Lösungen, Suspensionen, Emulsionen von anorganischen Halbleitern, wie beispielsweise Si, a-Si:H, CuZnSnS, CuZnSnSe, GaAs, CulnS, CulnSe, CulnGeS, CulnGeSe, Ge, CdTe, Metalloxide wie $TiO_2$, ZnO, oder organischen Halbleitern wie beispielsweise Poly-(3-hexylthiophen), Metall-Phtalocyaninen, Dicyanovinyl (DCV)-substituierte Quaterthiophenen, Fullerenderivaten und Nanopartikeln der verschiedenen Materialien sowie Kombinationen hiervon und/oder halbleitenden Polymeren und Fullerenderivaten und/oder anorgnischen Metall- oder Halbleiter-Nanopartikeln (Au, Ag, Al, $Al_2O_3$, ZnO, $TiO_2$, $MoO_3$, $V_2O_5$, CdS, CdSe, PbS, PbSe, CulnS, CulnSe, CulnGeS, CulnGeSe, CuZnSnS, CuZnSnSe) und/oder hybriden Halbleitern wie Perovskiten, beispielsweise $CH_3NH_3PbI_3$ oder Precursoren von organischen und anorganischen Halbleitern in Lösungsmitteln wie Chlorbenzol, Dichlorbenzol, Xylol, Toluol, Alkoholen, Wasser und Mischungen hiervon.

Eine erste bevorzugte Variante des erfindungsgemäßen Verfahrens sieht vor, dass in einer ersten Lage (n, ...) mindestens zwei Teildünnschichtsolarzellen ($I_n$, $II_n$, ...), die jeweils zumindest eine erste, dem Substrat (S) zugewandte Rückseitenelektrode, eine zweite Elektrode und/oder eine Konversionsschicht sowie eine zwischen der Rückseitenelektrode und der zweiten Elektrode und/oder der Konversionsschicht angeordnete photoaktive Schicht umfassen, vorgefertigt werden und mindestens eine weitere Teildünnschichtsolarzelle ($II_{n+1}$, $III_{n+1}$, ...), die jeweils zumindest eine erste, dem Substrat (S) zugewandte Rückseitenelektrode, eine zweite Elektrode und/oder eine Konversionsschicht sowie eine zwischen der Rückseitenelektrode und der zweiten Elektrode und/oder der Konversionsschicht angeordnete photoaktive Schicht umfasst, in einer zweiten Lage (n+1) versetzt auf die in der ersten Lage (n, ...) angeordneten mindestens zwei Teildünnschichtsolarzellen ($I_n$, $II_n$, ...) abgeschieden wird, wobei mindestens ein Überlappbereich (B) zwischen mindestens einer in der ersten Lage angeordneten Teildünnschichtsolarzelle ($I_n$) und einer in einer zweiten Lage abgeschiedenen Teildünnschichtsolarzelle ($II_{n+1}$) sowie mindestens ein Übergangsbereich (A) durch Kontaktieren der Rückseitenelektrode, der photoaktiven Schicht sowie der zweiten Elektrode und/oder der Konversionsschicht der in der zweiten Lage (n+1) abgeschiedenen Teildünnschichtsolarzelle ($II_{n+1}$) mit der Rückseitenelektrode, der photoaktiven Schicht sowie der zweiten Elektrode und/oder der Konversionsschicht der in der ersten Lage (n) angeordneten Teildünnschichtsolarzelle ($II_n$) ausgebildet wird.

Diese erfindungsgemäße Variante sieht vor, dass zunächst die unterste Lage (n) des Substrates mit Teildünnschichtsolarzellen, die in x-Richtung nebeneinander liegend angeordnet sind, beschichtet wird, beispielsweise durch sukzessives Abscheiden der die jeweiligen Teildünnschichtsolarzellen bildenden Funktionsschichten auf das Substrat. In einem nachfolgenden Schritt werden weitere Teildünnschichtsolarzellen in einer über der ersten Lage (n) liegenden Lage (n+1) abgeschieden, wobei die Funktionsschichten dieser Teildünnschichtsolarzellen versetzt und mit geeignetem Überlapp zu den in den ersten Lage (n) ausgebildeten Funktionsschichten der Teildünnschichtsolarzellen abgeschieden werden. Durch das Abscheiden bzw. Auflaminieren entstehen der Überlappbereich (B) und der Übergangsbereich (A) in dem jeweils zwei Teildünnschichtsolarzellen parallel zu einer in der erfindungsgemäßen Dünnschichtsolarzellenanordnung enthaltenen Dünnschichtsolarzelle verschaltet werden. Durch die erfindungsgemäße Wahl der räumlichen Anordnung der einzelnen Funktionsschichten entsteht in den Überlappbereichen B eine serielle Verschaltung der Teilsolarzellen und in den Übergangsbereichen A eine parallele Verschaltung bzw. Verbindung der Teilsolarzellen aus Lage n+1 und Lage n.

Bei der zuvor vorgestellten Verfahrensführung ist es besonders vorteilhaft, wenn die jeweiligen Bestandteile einer einzelnen Teildünnschichtsolarzelle, d.h. erste Elektrode, photoaktive Schicht, zweite Elektrode und/oder Konversionsschicht für jeweils in einer Lage vorhandener Teildünnschichtsolarzellen gleichzeitig abgeschieden werden. D.h. für die Mehrzahl von Teildünnschichtsolarzellen, die in einer Lage n angeordnet sind, wird zuerst die erste Elektrode (für den Fall, dass die Lage n die unterste Lage der Dünnschichtsolarzellenanordnung darstellt, wird die Elektrode dann direkt auf das Substrat abgeschieden) erzeugt, hierauf wird die photoaktive Schicht und darauf die zweite Elektrode abgeschieden. Die jeweiligen Schichten werden somit sukzessive für eine jeweilige einzelne Teildünnschichtsolarzelle abgeschieden, jedoch simultan und gleichzeitig für die Vielzahl der Teildünnschichtsolarzellen, die in einer jeweiligen Lage angeordnet sind.

Die einzelnen aktiven Schichten (d.h. erste Elektrode, photoaktive Schicht, zweite Elektrode und Konversionsschicht) werden dabei bevorzugt versetzt zueinander abgeschieden. Hierbei entsteht beispielsweise ein Überlapp zwischen erster Elektrode und photoaktiver Schicht. Während die erste Elektrode beispielsweise auf der einen Seite der Teildünnschichtsolarzelle nicht zur Gänze von der photoaktiven Schicht bedeckt ist, überragt die photoaktive Schicht die erste Elektrode auf der anderen Seite und kommt dort auf der gemeinsamen Unterlage von erster Elektrode und photoaktiver Schicht zum Liegen. Auf die gleiche Art und Weise kann die zweite Elektrode bzw. an deren Stelle und/ oder zusätzlich die Konversionsschicht abgeschieden werden. Insbesondere die zweite Elektrode und/oder die Konversionsschicht wird dabei so abgeschieden, dass sie mit der ersten Elektrode der benachbarten Teildünnschichtsolarzelle kontaktiert wird, so dass die beiden die Teildünnschichtsolarzellen seriell verschaltet werden.

Ebenso ist es möglich, die jeweiligen Bestandteile der einzelnen Teildünnschichtsolarzellen lediglich auf einer Seite überlappend abzuscheiden und/oder zu strukturieren, d.h. die erste Elektrode länger als die photoaktive Schicht und diese wiederum länger als die zweite Elektrode zu wählen, so dass sämtliche Bestandteile der jeweiligen Teildünnschichtsolarzelle auf einer Seite mit einer scharfen Kante abschließen. In diesem Fall ist es bevorzugt, eine Terminierung der zuvor genannten Schichten, d.h. erste Elektrode, photoaktive Schicht und zweite Elektrode vorzunehmen, beispielsweise kann hierzu ein isolierendes Material über die gemeinsame Kante dieser drei Schichten abgeschieden werden, so dass Kurzschlüsse der Schichten untereinander, insbesondere zwischen der ersten Elektrode der ersten Teilsolarzelle und der ersten Elektrode der zweiten Solarzelle eines Paares vermieden werden können. In diesem Fall kann zusätzlich, nach Abscheiden der Terminierung, eine weitere Konversionsschicht, die ebenso elektrisch leitend ist, auf dem Verbund abgeschieden werden, diese Konversionsschicht wird dabei so geführt, dass einerseits die zweite Elektrode einer ersten, in einer Lage n angebrachten Teildünnschichtsolarzelle, kontaktiert wird und auf eine erste Elektrode einer benachbarten, ebenso in einer Lage n angebrachten Teildünnschichtsolarzelle geführt wird. Auch dadurch ist die serielle Verschaltung der zwei Teildünnschichtsolarzellen in einer Lage n gewährleistet. Eine serielle Verschaltung ist ebenso mit der ersten Elektrode der weiteren Teildünnschichtsolarzelle der nächsten Schicht (n+1) möglich.

Über dem hergestellten Verbund aus Teildünnschichtsolarzellen in einer ersten Schicht n wird nunmehr anschließend durch versetztes Aufbringen weiterer erster Elektroden, photoaktiver Schichten, zweiter Elektroden und/oder Konversionsschichten (sowie ggfs. weiterer Terminierungen) eine weitere Dimension des Dünnschichtsolarzellenverbandes aufgebaut, wobei dann die einzelnen Dünnschichtsolarzellen sowie die Übergangsbereiche A und Überlappbereiche B ausgebildet werden.

Vorteilhaft hierbei ist, dass das Abscheiden und/oder Vorfertigen der Dünnschichtsolarzellen, Teildünnschichtsolarzellen und/oder der ersten, dem Substrat (S) zugewandten Rückseitenelektroden, der zweiten Elektroden und/oder Konversionsschichten sowie den photoaktiven Schicht der Dünnschichtsolarzellen und/oder Teildünnschichtsolarzellen aus der Gasphase oder der Flüssigphase erfolgt, insbesondere durch Aerosoldruck, Vakuumabscheiden, Tintenstrahldruck, Filmgießen und/oder Klebeverfahren erfolgt.

Bei dieser Verfahrensvariante ist somit bevorzugt, wenn beim Vorfertigen bzw. Abscheiden der mindestens zwei Teildünnschichtsolarzellen ($I_n$, $II_n$, ...) und/oder der mindestens einen weiteren Teildünnschichtsolarzelle ($II_{n+1}$, $III_{n+1}$, ...) die zumindest eine erste, dem Substrat (S) zugewandte Rückseitenelektrode, die zweite Elektrode und/oder die Konversionsschicht sowie die zwischen der Rückseitenelektrode und der zweiten Elektrode und/oder der Konversionsschicht angeordnete photoaktive Schicht für jede Teildünnschichtsolarzelle ($I_n$, $II_n$, ..., bzw. $II_{n+1}$, $III_{n+1}$, ...) sukzessive und für die jeweiligen Teildünnschichtsolarzellen ($I_n$, $II_n$, ..., bzw. $II_{n+1}$, $III_{n+1}$, ...) gleichzeitig abgeschieden werden.

Zudem ist es bevorzugt, wenn nach Abscheiden der ersten, dem Substrat (S) zugewandten Rückseitenelektrode, der photoaktiven Schicht sowie der zweiten Elektrode einer jeweiligen Teildünnschichtsolarzelle ($I_n$, $II_n$, ...) in der ersten Lage (n, ...) die erste, dem Substrat (S) zugewandten Rückseitenelektroden, photoaktive Schicht und/oder zweite Elektrode der jeweiligen Teildünnschichtsolarzelle ($I_n$, $II_n$, ...) terminiert wird, insbesondere durch Abscheiden eines elektrischen Isolators (4), und anschließend eine Konversionsschicht zur elektrischen Kontaktierung der zweiten Elektrode einer ersten Teildünnschichtsolarzelle ($I_n$, ...) mit der ersten Elektrode einer benachbarten zweiten Teildünnschichtsolarzelle ($II_n$, ...) und zur Ausbildung eines Überlappbereichs (A) abgeschieden wird.

Eine besondere Variante dieser Verfahrensführung sieht vor, dass das gleichzeitig oder nacheinander erfolgende Abscheiden der zumindest einen ersten Rückseitenelektrode ($1^I$, $1^{II}$, $1^{III}$, ...), der darüber angeordneten photoaktiven Schicht ($2^I$, $2^{II}$, $2^{III}$, ...) sowie der darüber angeordneten zweiten Elektrode und/oder Konversionsschicht ($3^I$, $3^{II}$, $3^{III}$, ...) durch Filmgießen erfolgt, bei dem die Precursormaterialien mittels eines eine Mehrzahl an Gießschlitzen (a, b, ...) aufweisenden Gießkopfes (G') auf das Substrat (S) gegossen und/oder gepresst werden, wobei die Gießschlitze (a, b, ...) jeweils in mehrere Kompartimente (a2, a2, a3, a4, ...; b1, b2, b3, b4, b5, b6, b7, ...) unterteilt sind, durch die jeweils die Precursormaterialien derjeweiligen Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$,...) der einzelnen Dünnschichtsolarzellen (I, II, III, ...) gegossen und/oder gepresst werden, wobei die Kompartimente (a2, a2, a3, a4, ...; b1, b2, b3, b4, b5, b6, b7, ...) so zueinander angeordnet sind, dass die Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$, ...) einer jeweiligen einzelnen Dünnschichtsolarzelle (I, II, III, ...) zumindest bereichsweise übereinanderliegend gegossen werden und fürjeweils ein Paar (I-II, II-III, ...) aus erster (I, II, ...) und zweiter Dünnschichtsolarzelle (II, III, ...) die jeweilige Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$, ...) versetzt zueinander gegossen werden, so dass ein Überlappbereich (B) und ein Übergangsbereich (A) entsteht.

Diese bevorzugte Variante beruht z.B. auf einem Filmgießverfahren, das sich ebenso eines Gießkopfes bedient, der mehrere Schlitze zum Austrag der Precursor-Materialen derjeweiligen Schichten derjeweiligen Solarzellen verfügt. Im Gegensatz zum obenstehend genannten Filmgießverfahren sind die Gießschlitze dieses Gießkopfes allerdings nicht durchgehend über die gesamte Breite derjeweiligen Schichten der einzelnen Dünnschichtsolarzellen ausgebildet, sondern in einzelne, voneinander getrennte Kompartimente unterteilt. Eine derartige Unterteilung kann beispielsweise mittels eines Trennbleches etc. erfolgen. Durch die einzelnen Kompartimente können unterschiedliche Precursor-Materialien für die einzelnen Schichten, also beispielsweise Precursor-Materialien für die Rückseitenelektrode, die photoaktive Schicht bzw. die zweite Elektrode und/oder Konversionsschicht ausgetragen werden, sodass dadurch ein entsprechender Schichtaufbau der jeweils entstehenden Dünnschichtsolarzellen realisiert werden kann. Die Geometrie der Kompartimente und der Gießschlitze dieses modifizierten Gießkopfes entspricht dabei bereits der entsprechenden Geometrie der abgeschiedenen Schichten der jeweiligen Dünnschichtsolarzellen. Mit diesem Verfahren kann in einem einzigen Schritt eine komplette Dünnschichtsolarzellenanordnung gemäß der vorliegenden Erfindung hergestellt werden.

Durch Versorgen derjeweiligen Kompartimente des Gießkopfes mit entsprechend unterschiedlichen Precursor-Lösungen können somit ebenso in einer Schicht n verschiedene Teildünnschichtsolarzellen abgeschieden werden, durch iteratives Aufbringen weiterer Schichten entstehen somit die Teildünnschichtsolarzellen und somit weiter die Dünnschichtsolarzellenanordnung.

Eine zweite bevorzugte Variante des erfindungsgemäßen Verfahrens sieht vor, dass das gleichzeitig oder nacheinander erfolgende Abscheiden der zumindest einen ersten Rückseitenelektrode ($1^I$, $1^{II}$, $1^{III}$, ...), der darüber angeordneten photoaktiven Schicht ($2^I$, $2^{II}$, $2^{III}$, ...) sowie der darüber angeordneten zweiten Elektrode und/oder Konversionsschicht ($3^I$, $3''$, $3^{III}$, ...) durch Filmgießen erfolgt, bei dem die Precursormaterialien mittels eines eine Mehrzahl an Gießschlitzen

$$\left( X_1^I, X_2^I, X_3^I, X_1^{II}, X_2^{II}, X_3^{II}, X_1^{III}, X_2^{III}, X_3^{III}, ... \right)$$

aufweisenden Gießkopfes (G) auf das Substrat (S) gegossen und/oder gepresst werden, wobei die Gießschlitze

$$\left( X_1^I, X_2^I, X_3^I, X_1^{II}, X_2^{II}, X_3^{II}, X_1^{III}, X_2^{III}, X_3^{III}, ... \right)$$ jeweils einer Rückseitenelektrode ($1^I$, $1^{II}$, $1^{III}$, ...), einer photoaktiven Schicht ($2^I$, $2^{II}$, $2^{III}$, ...) sowie einer zweiten Elektrode und/oder Konversionsschicht ($3^I$, $3^{II}$, $3^{III}$, ...) einer jeweiligen Dünnschichtsolarzelle (I, II, III, ...) zugeordnet, durchgängig über die gesamte Breite der jeweiligen Rückseitenelektrode ($1^I$, $1^{II}$, $1^{III}$, ...), der photoaktiven Schicht ($2^I$, $2^{II}$, $2^{III}$, ...) sowie der zweiten Elektrode und/oder Konversionsschicht ($3^I$, $3''$, $3^{III}$, ...) der jeweiligen Dünnschichtsolarzelle (I, II, III, ...) ausgebildet und so im Gießkopf (G) angeordnet sind, dass die Rückseitenelektrode ($1^I$, $1^{II}$, $1^{III}$, ...), die photoaktive Schicht ($2^I$,

$2^{II}$, $2^{III}$, ...) sowie die zweite Elektrode und/oder Konversionsschicht ($3^I$, $3^{II}$, $3^{III}$, ...) einer jeweiligen einzelnen Dünnschichtsolarzelle (I, II, III, ...) zumindest bereichsweise übereinanderliegend gegossen werden und für jeweils ein Paar (I-II, II-III, ...) aus erster (I, II, ...) und zweiter Dünnschichtsolarzelle (II, III, ...) die jeweilige Rückseitenelektrode ($1^I$, $1^{II}$, $1^{III}$, ...), die photoaktive Schicht ($2^I$, $2^{II}$, $2^{III}$,...) sowie die zweite Elektrode und/oder Konversionsschicht ($3^I$, $3^{II}$, $3^{III}$, ...) versetzt zueinander gegossen werden, so dass ein Überlappbereich (B) und ein Übergangsbereich (A) entsteht.

Mit dieser bevorzugten Variante wird mittels eines Gießkopfes, der eine Mehrzahl an Gießschlitzen aufweist, ein Film der jeweiligen Precursor-Materialen auf ein Substrat gegossen. Die Gießschlitze sind dabei so angeordnet, dass die einzelnen aktiven Schichten einer jeden Dünnschichtsolarzelle auf dem Substrat übereinander liegend abgeschieden werden, wodurch die jeweilige Dünnschichtsolarzelle ausgebildet wird. Dies kann beispielsweise dadurch erfolgen, dass die jeweiligen, der Anzahl an Schichten für eine Solarzelle entsprechende Anzahl an Gießschlitzen im Gießkopf übereinander liegend angeordnet sind, beispielsweise ein Paar aus drei Gießschlitzen für die Precursor-Materialien für die Rückseitenelektrode, die photoaktive Schicht sowie die zweite Elektrode und/oder Konversionsschicht einerjeweiligen Dünnschichtsolarzelle. Die jeweiligen Gießschlitze für eine weitere, zweite Dünnschichtsolarzelle sind versetzt zu den Gießschlitzen für die erste Dünnschichtsolarzelle angeordnet, sodass diese Schichten teilweise mit den Schichten der ersten Dünnschichtsolarzelle überlappen. In diesem Überlapp entsteht somit der Überlappbereich eines jeweiligen Paares aus erster und zweiter Dünnschichtsolarzelle. Zudem sind die Gießschlitze derart angeordnet, dass ein Bereich entsteht, in dem lediglich die Schichten der zweiten Dünnschichtsolarzelle eines Paares aus erster und zweiter Dünnschichtsolarzelle abgeschieden werden, sodass die dadurch ausgetragenen Filme für die jeweiligen aktiven Schichten einer Dünnschichtsolarzelle das Ende der Schichten derjeweils ersten Dünnschichtsolarzelle eines Paares aus erster und zweiter Dünnschichtsolarzelle überragend abgeschieden werden. Durch dieses Überragen legt sich der Filmverbund der aktiven Schichten der zweiten Dünnschichtsolarzellen des Paares auf einer darunter liegenden Ebene ab, wodurch der Übergangsbereich (A) entsteht. Durch entsprechend iterative Anordnung der jeweiligen Gießschlitze für die einzelnen Dünnschichtsolarzellen können somit die erfindungsgemäße Dünnschichtsolarzellenanordnung erzeugt werden.

Eine dritte bevorzugte Variante des erfindungsgemäßen Verfahrens sieht vor, dass das gleichzeitig oder nacheinander erfolgende Abscheiden der zumindest einen ersten Rückseitenelektrode ($1^I$, $1^{II}$, $1^{III}$, ...), der darüber angeordneten photoaktiven Schicht ($2^I$, $2^{II}$, $2^{III}$, ...) sowie der darüber angeordneten zweiten Elektrode und/oder Konversionsschicht ($3^I$, $3''$, $3^{III}$, ...) durch Tintenstrahl- und/oder Aerosoldruck auf das Substrat (S) erfolgt, wobei die Rückseitenelektrode (1$^I$, 1$^{II}$, 1$^{III}$, ...), die photoaktive Schicht (2$^I$, 2$^{II}$, 2$^{III}$, ...) sowie die zweite Elektrode und/oder Konversionsschicht (3$^I$, 3", 3$^{III}$, ...) einer jeweiligen einzelnen Dünnschichtsolarzelle (I, II, III, ...) zumindest bereichsweise übereinanderliegend gedruckt werden und für jeweils ein Paar (I-II, II-III, ...) aus erster (I, II, ...) und zweiter Dünnschichtsolarzelle (II, III, ...) die jeweilige Rückseiten-elektrode (1$^I$, 1$^{II}$, 1$^{III}$, ...), die photoaktive Schicht (2$^I$, 2$^{II}$, 2$^{III}$, ...) sowie die zweite Elektrode und/oder Konversionsschicht (3$^I$, 3", 3$^{III}$, ...) versetzt zueinander gedruckt werden, so dass ein Überlappbereich (B) und ein Übergangsbereich (A) entsteht.

Gemäß dieser bevorzugten Ausführungsform können die einzelnen Schichten einer jeweiligen Dünnschichtsolarzelle durch Tintenstrahl- und/oder Aerosoldruck der jeweiligen Precursor-Materialien auf dem Substrat abgeschieden werden. Die aktiven Schichten der einzelnen Solarzellen können dabei mittels eines entsprechenden Tintenstrahl- oder Aerosoldruckwerkzeuges, beispielsweise eines Auftragswerkes abgeschieden werden. Dabei ist es möglich, dass das Auftragswerk lediglich einen Druckkopf aufweist, sodass die einzelnen Schichten nacheinander erzeugt werden müssen. Ebenso ist es möglich, dass beispielsweise sämtliche der Schichten einer einzelnen Solarzelle durch einen jeweiligen Auftragskopf gleichzeitig erzeugt werden, sodass eine jeweilige Einzelsolarzelle in einem Schritt auf dem Substrat abgeschieden werden kann. Zudem ist es möglich, dass bereits für die mehreren Dünnschichtsolarzellen jeweils eine der aktiven Schichten entsprechende Anzahl von Auftragsköpfen vorhanden ist, sodass in einem Schritt mehrere Dünnschichtsolarzellen gemäß der erfindungsgemäßen Dünnschichtsolarzellenanordnung abgeschieden werden können.

Eine vierte erfindungsgemäße Variante zur Herstellung einer erfindungsgemäßen Dünnschichtsolarzellenanordnung sieht vor, dass auf dem Substrat (S) eine Mehrzahl von Dünnschichtsolarzellen, die jeweils zumindest eine erste, dem Substrat (S) zugewandte Rückseitenelektrode, eine zweite Elektrode und/oder eine Konversionsschicht sowie eine zwischen der Rückseitenelektrode und der zweiten Elektrode und/oder der Konversionsschicht angeordnete photoaktive Schicht umfassen, sukzessive teilweise überlappend abgeschieden bzw. auflaminiert werden.

Bei diesem erfindungsgemäßen Verfahren werden jeweils vorgefertigte Dünnschichtsolarzellen teilweise überlappend übereinander laminiert, im überlappenden Bereich resultiert der Überlappbereich (B), im nicht überlappenden Bereich wird eine Dünnschichtsolarzelle auf eine darunterliegende Schicht abgeschieden bzw. auflaminiert, wobei der Übergangsbereich (A) resultiert.

Bei beiden zuvor genannten beschriebenen Varianten des erfindungsgemäßen Verfahrens ist es bevorzugt, wenn Verfahren nach einem der beiden vorhergehenden Ansprüche, dadurch gekennzeichnet, dass die abgeschieden bzw. auflaminierten Teildünnschichtsolarzellen bzw. die Dünnschichtsolarzellen vor dem Abscheiden bzw. Auflaminieren auf einem temporären Träger (T), der bevorzugt eine Kunststofffolie ist, befestigt sind, der nach dem Abscheiden bzw. Auflaminieren entfernt wird.

Zudem kann es bei beiden zuvor beschriebenen Varianten vorgesehen sein, dass die Teildünnschichtsolarzellen bzw. die Dünnschichtsolarzellen über eine isolierende Klebeschicht (K) oder leitfähige Klebeschicht (K') abgeschieden bzw. auflaminiert werden.

Die vorliegende Erfindung wurde anhand der nachfolgend beschriebenen Figuren näher erläutert, ohne die Erfindung jedoch auf die dargestellten speziellen Varianten und Parameter zu beschränken.

Die Figuren zeigen:

Figur 1: Eine gewöhnliche monolithische Serienverschaltung zweier nebeneinander abgeschiedener Dünnschichtsolarzellen gemäß dem Stand der Technik,

Figur 2: Eine erste Dünnschichtsolarzellenanordnung, die mit dem erfindungsgemäßen Verfahren hergestellt werden kann,

Figur 3: Eine zweite Dünnschichtsolarzellenanordnung mit monolithischer Verschaltung im Übergangsbereich (A), die mit dem erfindungsgemäßen Verfahren hergestellt werden kann,

Figur 4: eine dritte Dünnschichtsolarzellenanordnung mit optimierter monolithischer Verschaltungen im Übergangsbereich (A), die mit dem erfindungsgemäßen Verfahren hergestellt werden kann,

Figur 5: eine makroskopische Perspektive einer erfindungsgemäß hergestellten Dünnschichtsolarzellenanordnung,

Figur 6: verschiedene Breitenverhältnisse der Übergangsbereiche (B) bezogen auf die einzelnen Dünnschichtsolarzellen einer Dünnschichtsolarzellenanordnung, die mit dem erfindungsgemäßen Verfahren hergestellt werden kann,

Figur 7: eine Dünnschichtsolarzellenanordnung mit insgesamt vier Lagen aus Dünnschichtsolarzellen, die mit dem erfindungsgemäßen Verfahren hergestellt werden kann,

Figurenfolge 8: eine bevorzugte Ausführungsform eines erfindungsgemäßen Verfahrens zur Herstellung einer Dünnschichtsolarzellenanordnung, die Öffnungen können durch direktes strukturiertes Abscheiden oder großflächiges Abscheiden mit anschließenden selektiven oder teilselektiven Abtrag sowie Kombinationen hiervon erzeugt werden.

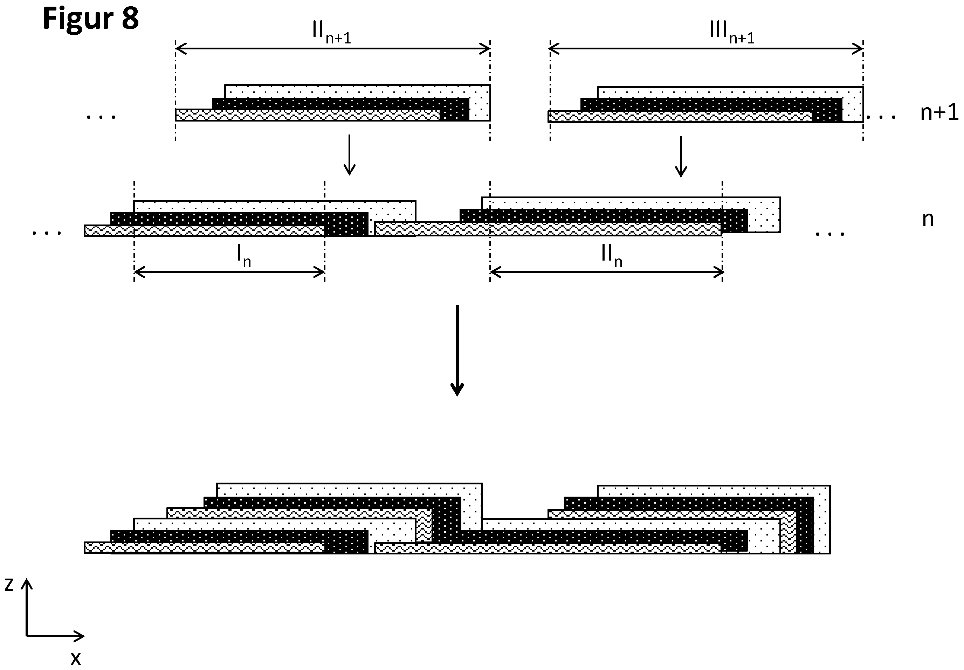

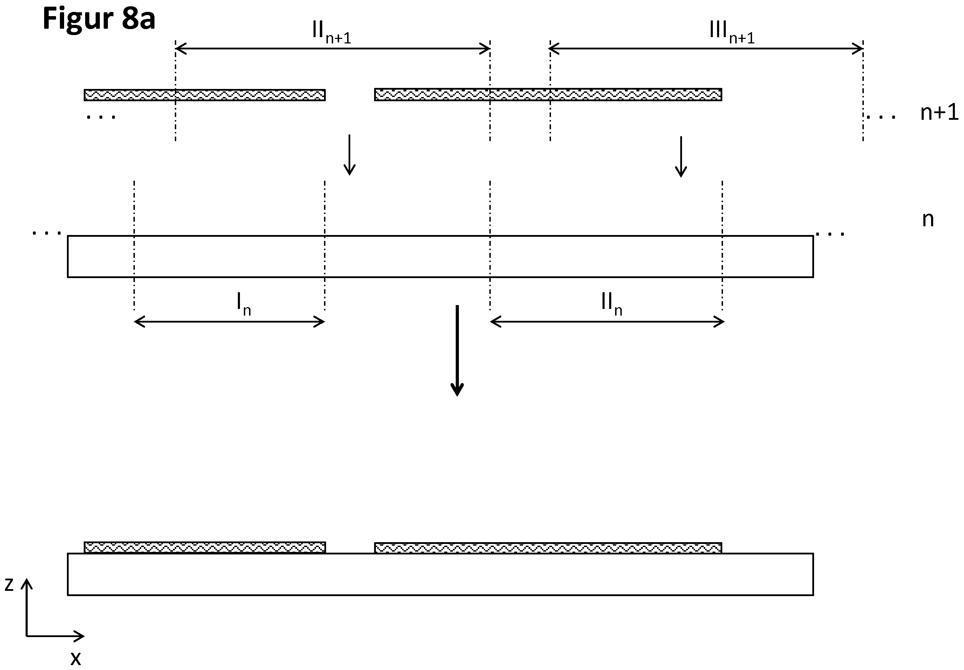

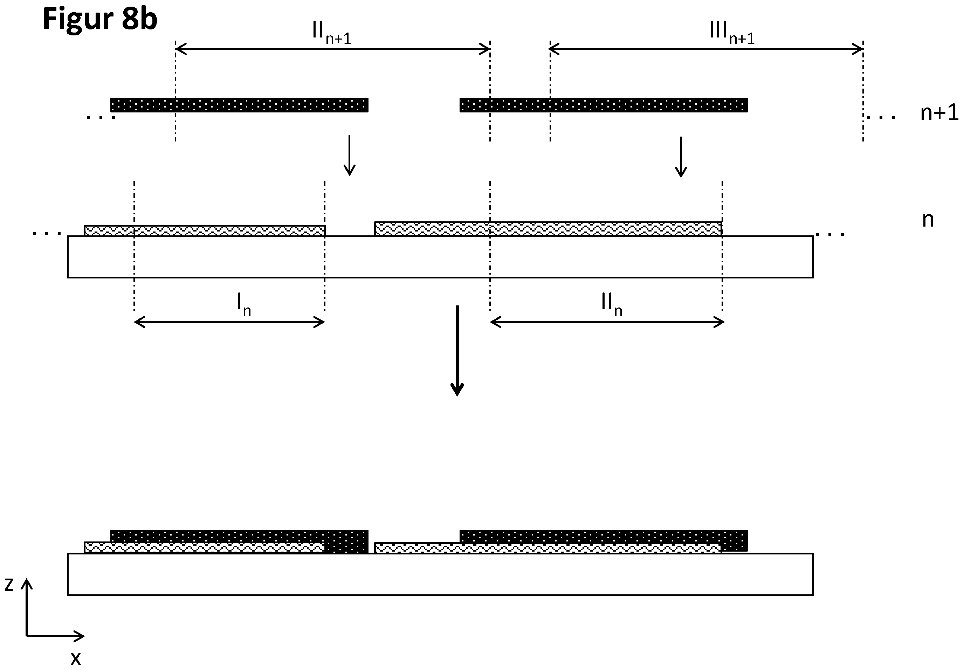

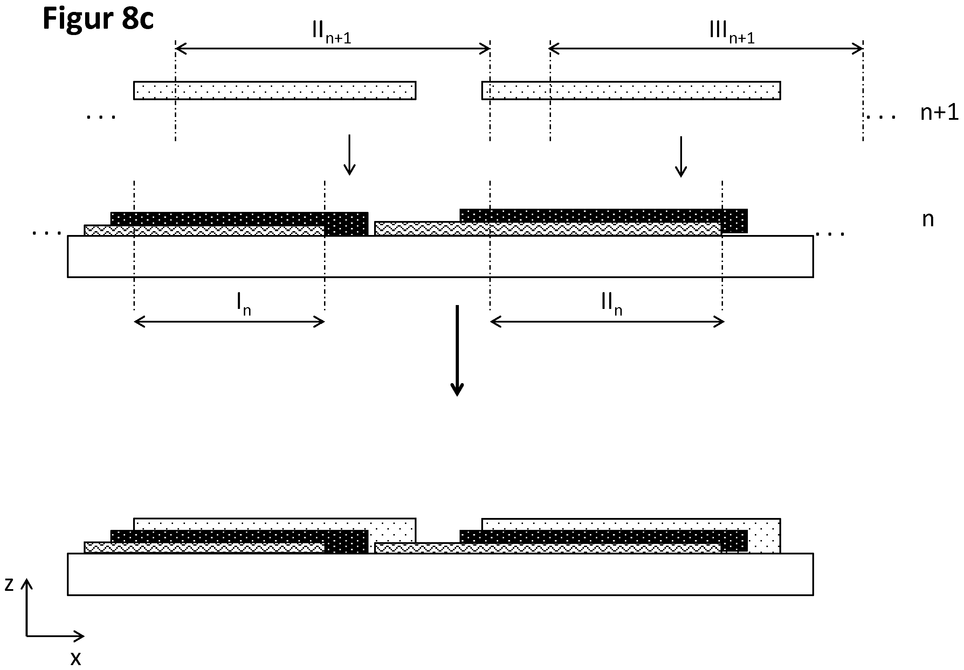

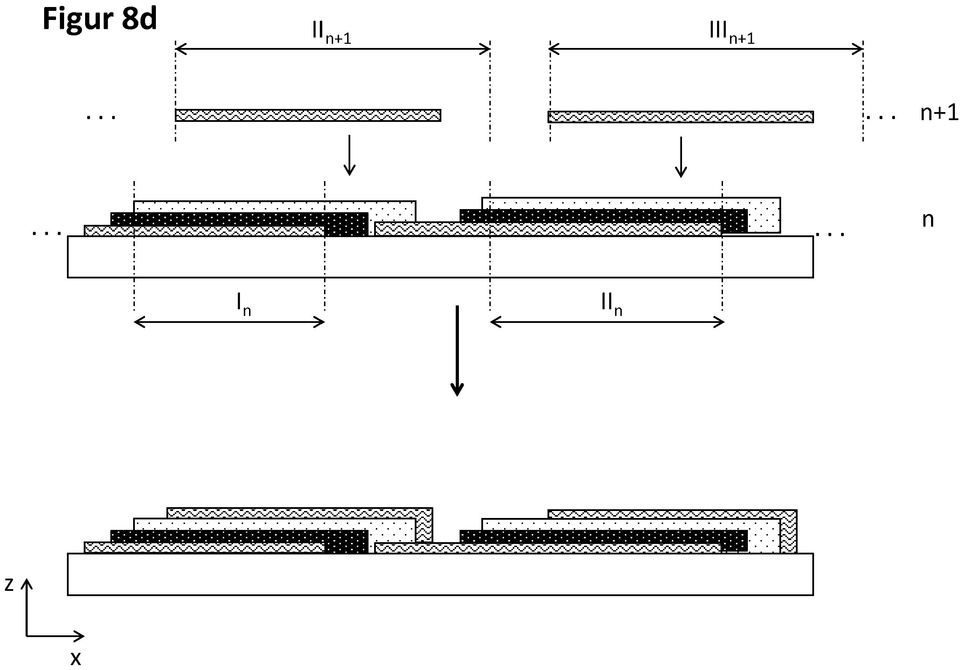

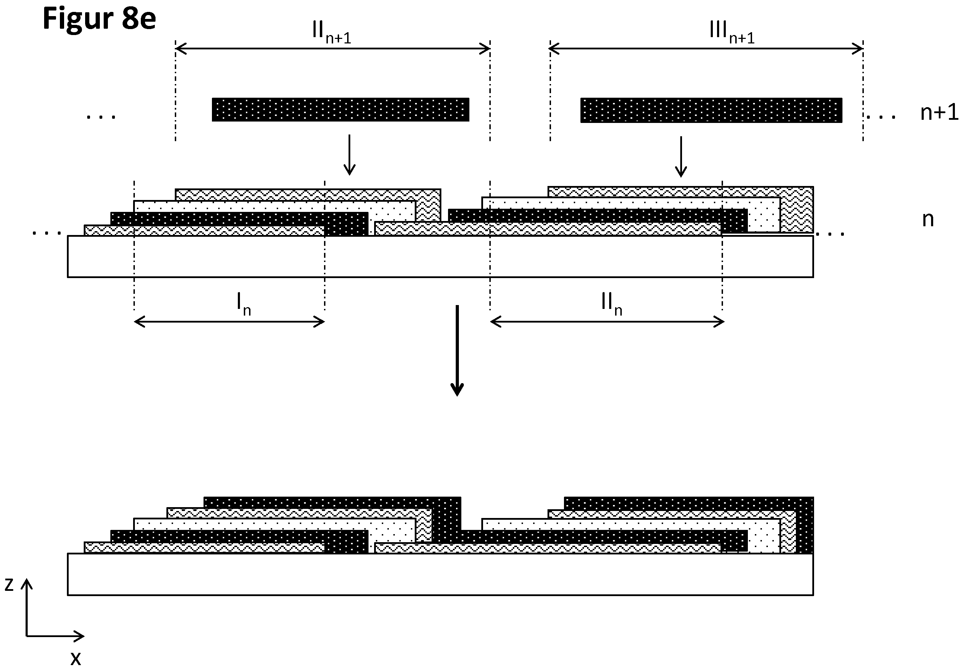

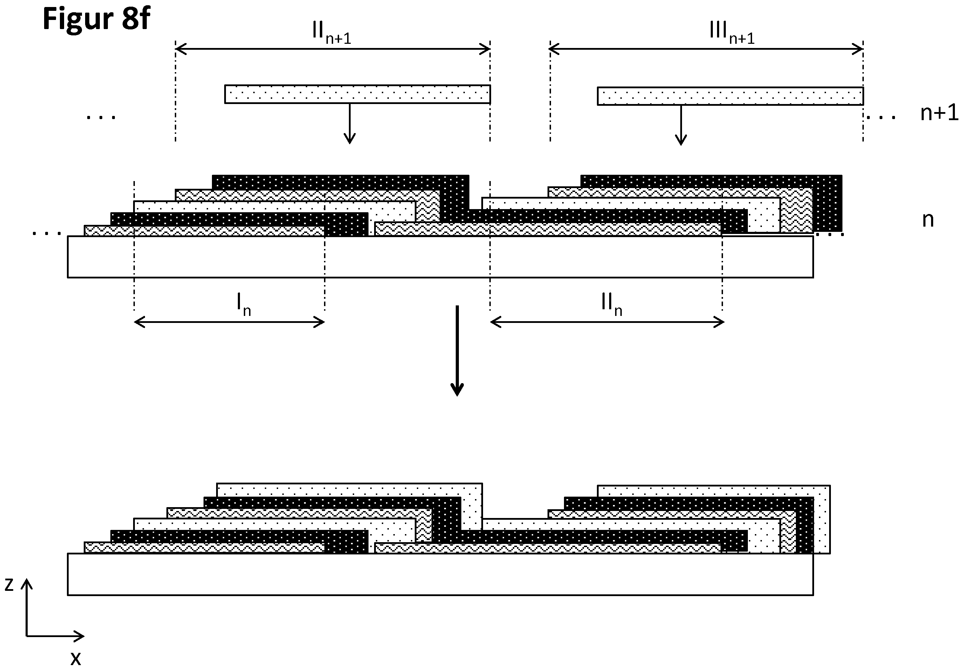

Figurenfolge 9: eine Variante des in Figur 8 dargestellten Verfahrens,

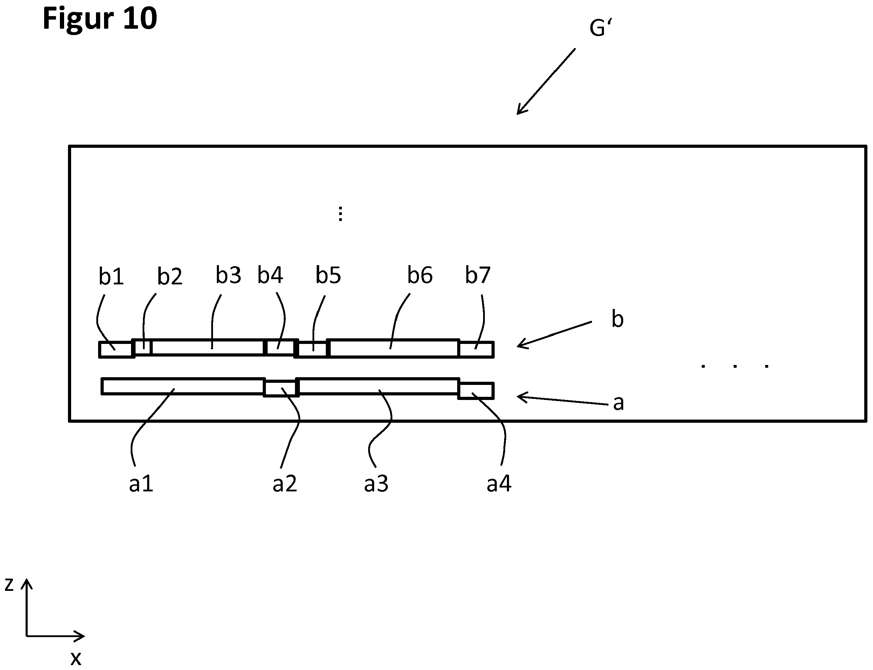

Figur 10: Einen Gießkopf zur Herstellung einer erfindungsgemäßen Dünnschichtsolarzellenanordnung,

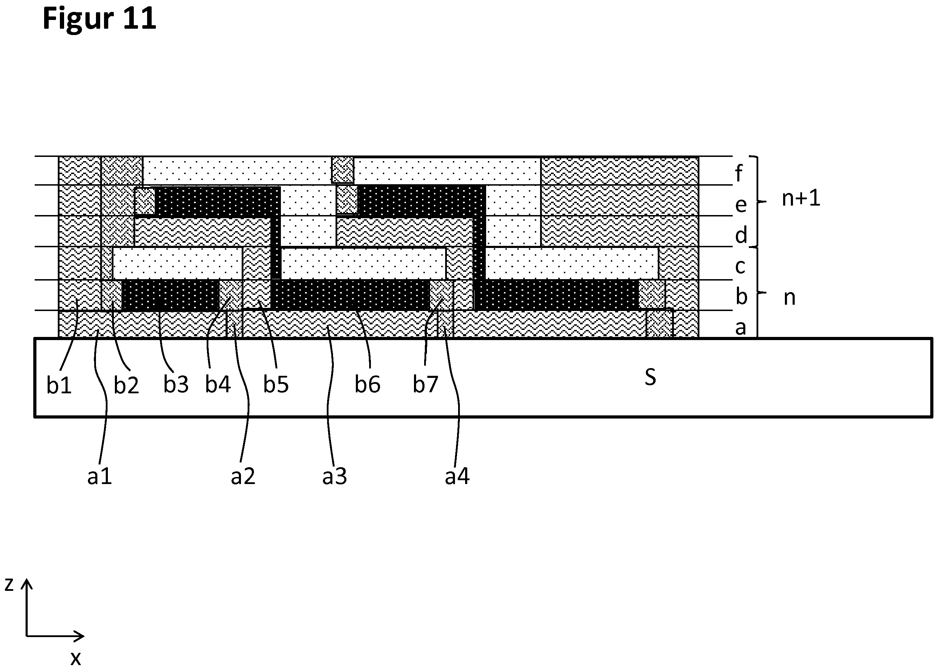

Figur 11: eine Dünnschichtsolarzellenanordnung, die mittels eines Verfahrens, das sich eines in Figur 10 dargestellten Gießkopfes bedient, hergestellt werden kann,

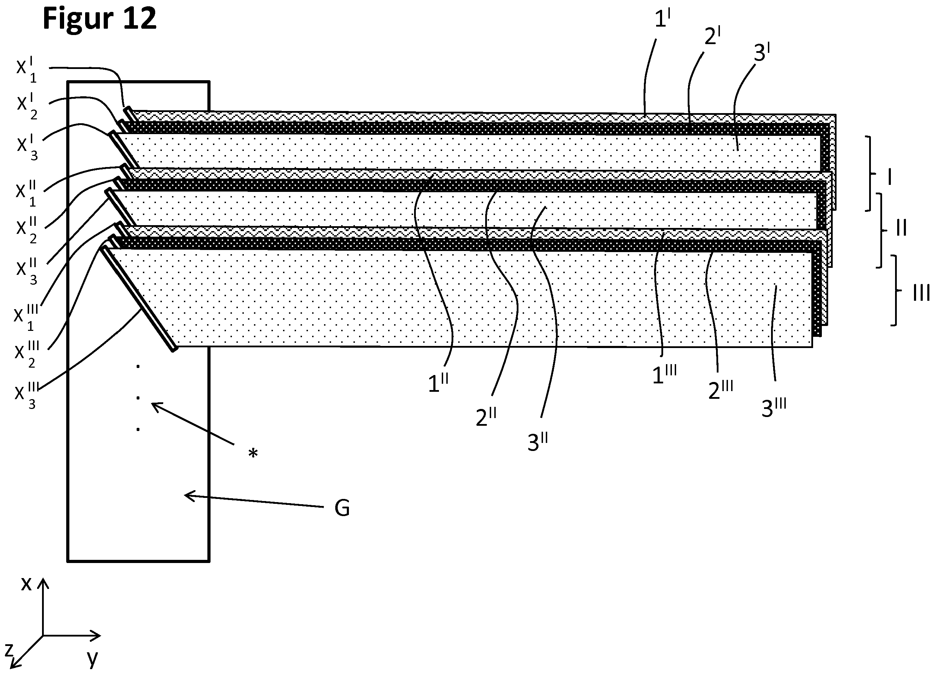

Figur 12: eine erste Verfahrensvariante zur Herstellung einer erfindungsgemäßen Dünnschichtsolarzellenanordnung mittels Filmgießens,

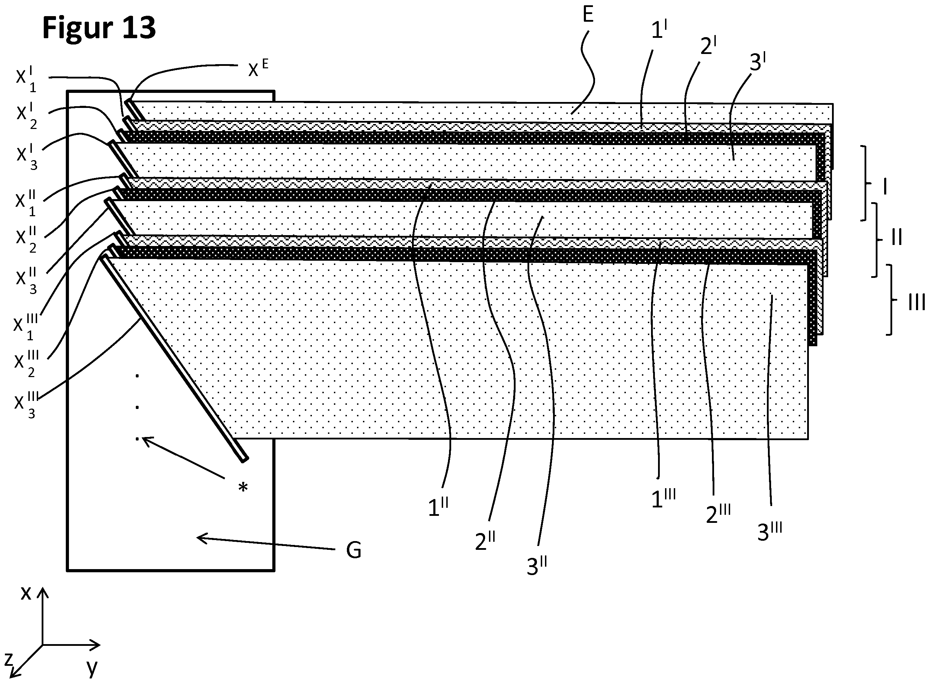

Figur 13: eine Variante eines in Figur 12 dargestellten erfindungsgemäßen Verfahrens,

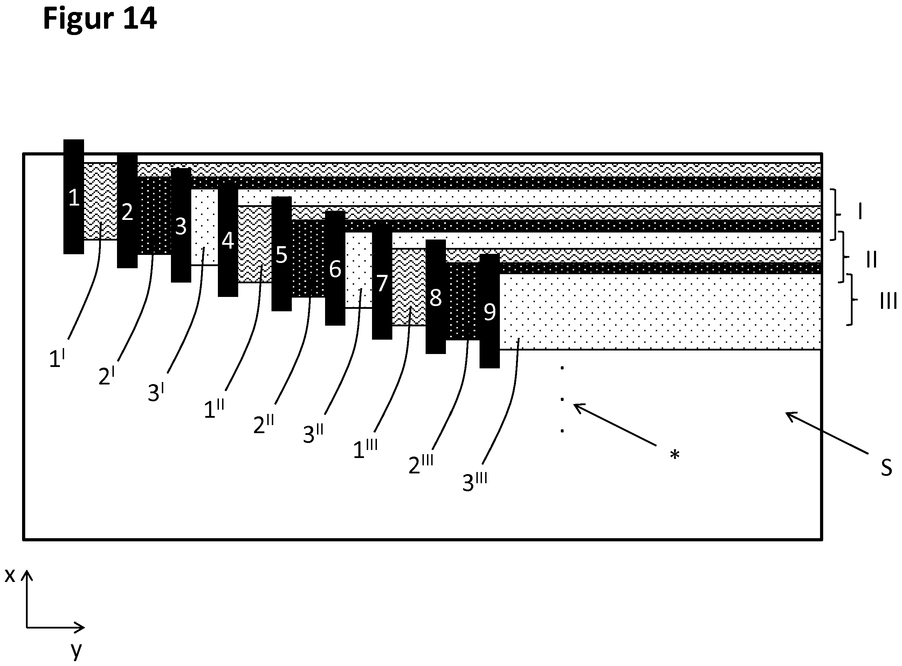

Figur 14: ein erfindungsgemäßes Verfahren zur Herstellung der Dünnschichtsolarzellenanordnung mittels Tintenstrahl- bzw. Aerosoldruck,

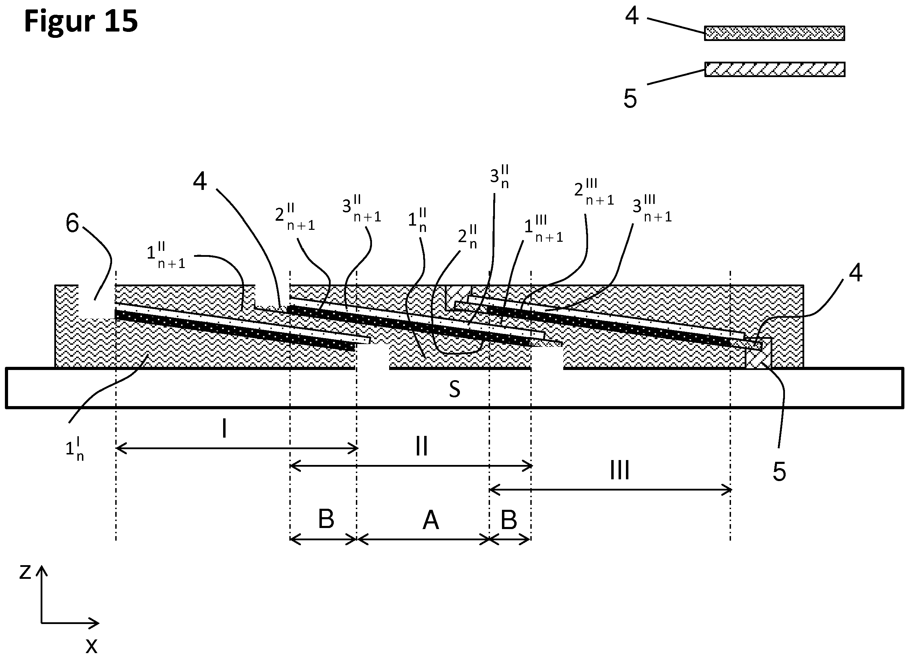

Figur 15: eine weitere Dünnschichtsolarzellenanordnung, die mit dem erfindungsgemäßen Verfahren hergestellt werden kann,

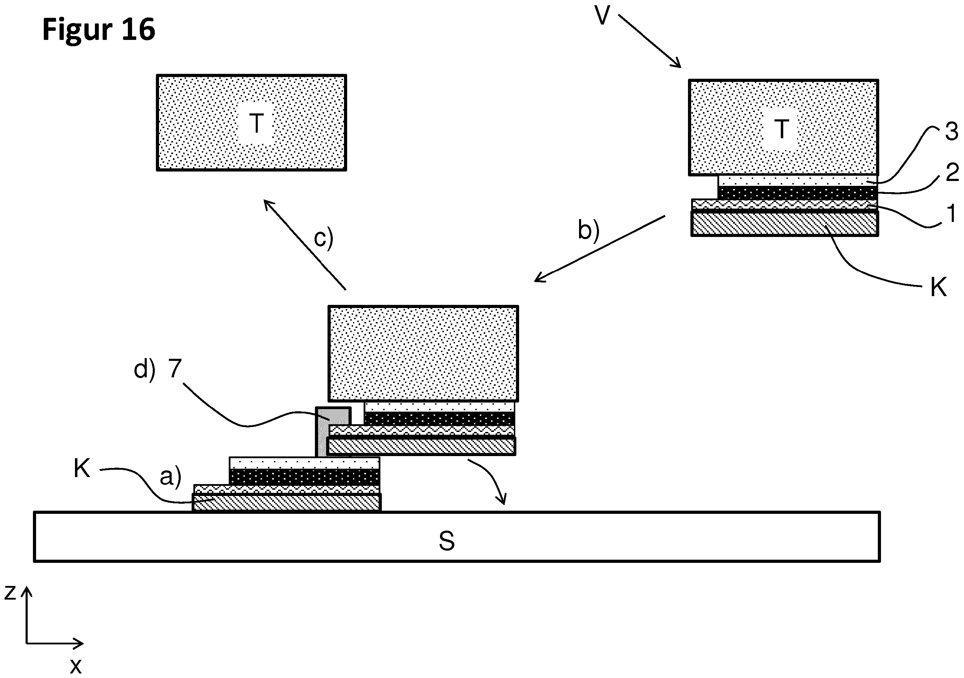

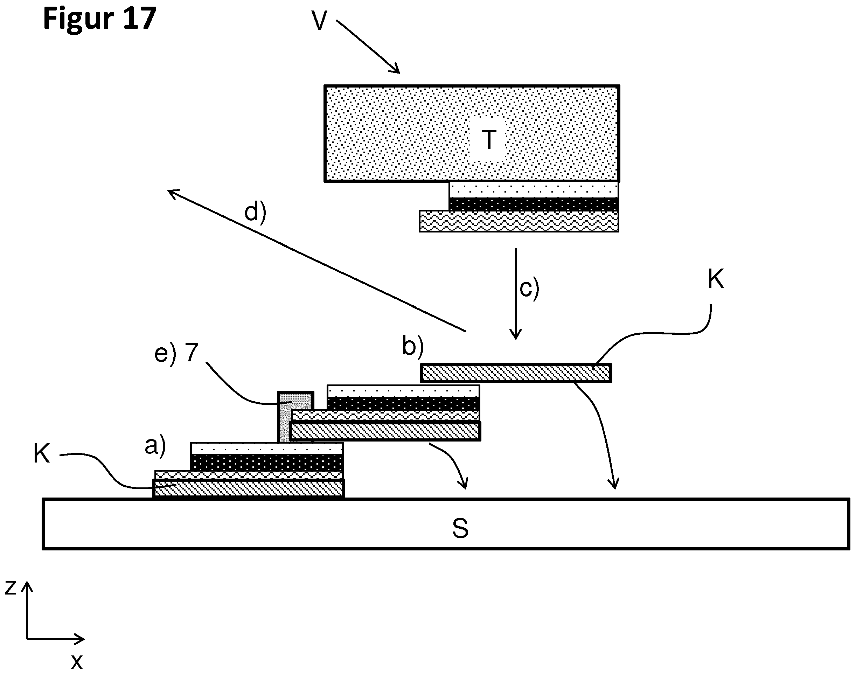

Figur 16: eine weitere bevorzugte Ausführungsform des erfindungsgemäßen Verfahrens, bei dem eine Laminierung der jeweiligen Solarzellen erfolgt, Figur 17: eine Variante des in Figur 16 dargestellten Verfahrens,

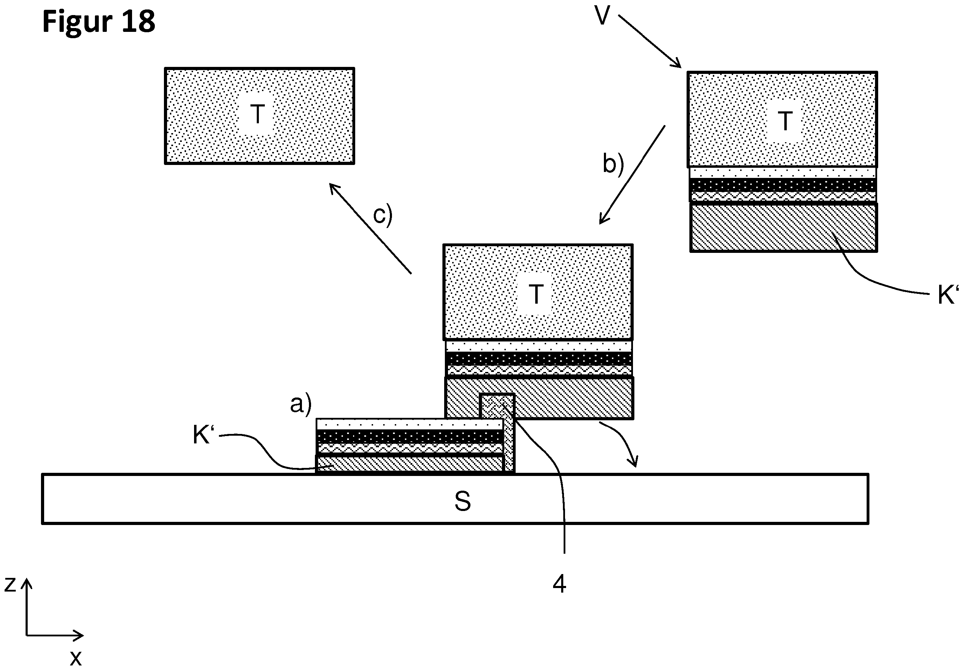

Figur 18: eine weitere Ausgestaltungsform eines erfindungsgemäßen Verfahrens durch Laminieren verschiedener Solarzellen, sowie

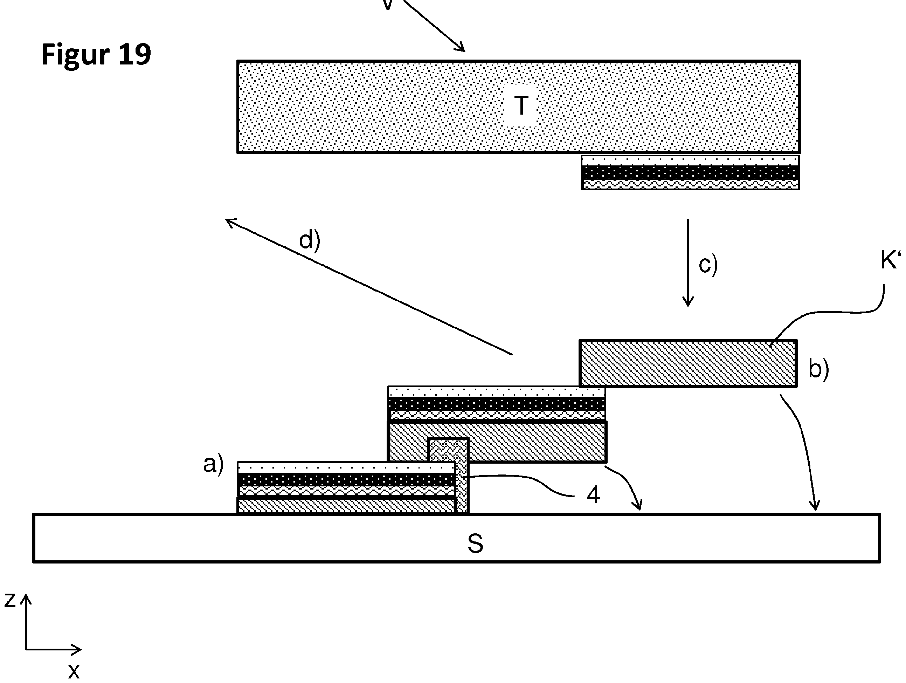

Figur 19: eine Variante des in Figur 18 dargestellten Verfahrens.

Figur 1 zeigt eine bereits eingangsbeschriebene Dünnschichtsolarzellenanordnung, wie sie aus dem Stand der Technik bekannt ist. In Figur 1 sind dabei zwei einzelne Solarzellen (I, II) nebeneinander in x-Richtung auf ein nicht dargestelltes Substrat abgeschieden. Die Solarzellen (I, II) sind dabei jeweils durch eine Rückseitenelektrode (1), eine photoaktive Schicht (2) sowie eine oben angebrachte Elektrode (3) gebildet. Die farbliche Gestaltung der aktiven Schichten (1, 2, 3) ist auch in den folgenden Figuren gleich gewählt, sodass die entsprechenden Schichten auch über die farbliche Gestaltung der jeweiligen Schichten ohne die entsprechenden Bezugszeichen identifiziert werden können. Die einzelnen aktiven Schichten (1, 2, 3) sind dabei in z-Richtung übereinander abgeschieden, die Verbindung mit dem nicht dargestellten Substrat erfolgt auf der Seite, auf der die Rückseitenelektroden 1 angebracht sind. Eine entsprechende Abscheidung bzw. Aufbringung auf das Substrat der jeweiligen Solarzellen (I, II) ist dabei direkt, aber auch über isolierende oder leitende Klebeverbindungen möglich. Die jeweiligen Schichten einer jeweiligen Solarzelle sind dabei zur Kennzeichnung mit der Nummer der jeweiligen Solarzelle überschrieben, sodass die Rückseitenelektrode (1) der ersten Solarzelle (I) mit $1^I$ angegeben ist usw. Bei einer aus dem Stand der Technik bekannten Anordnung von Solarzellen kann nur derjenige Bereich zur Stromerzeugung genutzt werden, in dem sämtliche aktiven Schichten einer Solarzelle (1, 2, 3) simultan vorhanden sind. Der zur monolithischen Verschaltung der Solarzellen (I, II) benutzte Bereich (L) dient somit nicht der Stromerzeugung, sodass dieser Bereich die Effizienz einer derartigen Dünnschichtsolarzellenanordnung beeinträchtigt. In $\gamma$-Richtung kann die Länge der jeweiligen aktiven Schichten (1, 2, 3) der jeweiligen Dünnschichtsolarzellen beliebig gewählt sein, diese Ausführung gilt auch für sämtliche, insbesondere im nachfolgenden dargestellte erfindungsgemäße Dünnschichtsolarzellenanordnungen.

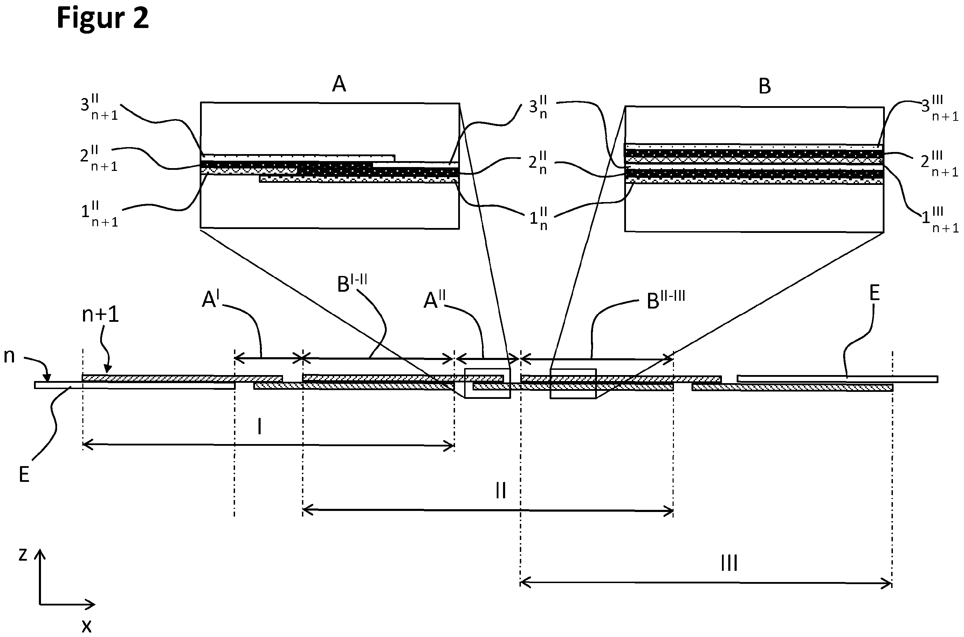

Figur 2 zeigte eine erste Ausgestaltungsform einer mit dem erfindungsgemäßen Verfahren hergestellten Dünnschichtsolarzellenanordnung, die aus einer Mehrzahl einzelner Dünnschichtsolarzellen (I, II, III) gebildet ist. Jede der dargestellten Solarzellen (I, II, III) ist dabei sowohl in einer ersten Lage (n) sowie einer darüber liegenden Lage (n+1) ausgebildet. Die Lage (n) kann direkt oder mittels einer isolierenden oder leitfähigen Klebeschicht auf einem nicht dargestellten Substrat (S) abgeschieden sein. Jede der Solarzellen (I, II, III) weist dabei eine Rückseitenelektrode (1), eine photoaktive Schicht (2) sowie eine zweite Elektrode und/oder Konversionsschicht (3) auf. Die jeweiligen aktiven Schichten (1, 2, 3) der jeweiligen Dünnschichtsolarzellen sind dabei in Figur 2 (sowie in allen weiteren Figuren) der jeweiligen Solarzelle und der jeweiligen Lage zugeordnet. Beispielsweise ist die Rückseitenelektrode (1) der zweiten Solarzelle (II), die in der zweiten Lage (n+1) vorhanden ist mit $1^{II}_{n+1}$ bezeichnet. Die in der ersten Lage (n) vorhandene Rückseitenelektrode (1) der zweiten Solarzelle (II) wird hingegen mit $1^{II}_n$ bezeichnet. Über die gewählte Nomenklatur kann eine eindeutige Zuordnung der jeweiligen Bereiche der aktiven Schichten bezüglich der einzelnen Solarzellen sowie der Lagen, in denen die Solarzellen ausgebildet sind, vorgenommen werden. Die jeweiligen Solarzellen sind dabei paarweise seriell elektrisch verschaltet, in Figur 2 bildet beispielsweise die Solarzelle (I) mit der Solarzelle (II) ein seriell verschaltetes Paar von Dünnschichtsolarzellen, ebenso bildet die dargestellte Solarzelle (II) mit der Solarzelle (III) ein seriell verschaltetes Paar von Solarzellen. Die serielle Verschaltung erfolgt dabei in einem Überlappbereich (B), der in Figur 2 explizit für die beiden Paaren vorhandener Solarzellen (I-II) und (II-II) mit $B^{I-II}$ bzw. $B^{II-III}$ angegeben ist. Im rechts oben in Figur 2 dargestellten vergrößerten Ausschnitt dieser als Überlappbereich B bezeichneten seriellen Verschaltung sind die einzelnen Schichten der jeweiligen Solarzellen (II, III) dargestellt. Die serielle Verschaltung erfolgt durch elektrische Kontaktierung in der zweiten Elektrode und/oder Konversionsschicht $3_n^{II}$ der zweiten Solarzelle (II) mit der Rückseitenelektrode $1_{n+1}^{III}$ der dritten Solarzelle (III). Die jeweiligen einzelnen Solarzellen (I, II, III) weisen dabei jeweils einen Übergangsbereich (A) auf, der in Figur 2 explizit für die erste Solarzelle (I) als Übergangsbereich (A$^I$) sowie für die zweite Solarzelle (II) als Übergangsbereich (A$^{II}$) dargestellt ist. In Figur 2 links oben ist ein vergrößerter Ausschnitt eines Übergangsbereichs (A) dargestellt. Erkennbar ist, dass die einzelnen aktiven Schichten der jeweiligen Solarzelle (im Beispielsfall für die Solarzelle (II)) aus der zweiten Lage (n+1) in die erste Lage (n) überführt werden. Hierbei findet eine Parallelverschaltung der einzelnen aktiven Lagen statt. Die erfindungsgemäße Anordnung der einzelnen Solarzellen (I, II, III) sieht somit vor, dass die Solarzellen bereichsweise überlappend in einem Überlappbereich (B) ausgebildet sind, ebenso sind Übergangsbereiche (A) vorhanden, in denen jeweils nur eine Solarzelle von einer zweiten Lage (n+1) in eine erste Lage (n) geführt wird. Auf die gesamte Breite (in x-Richtung) der Dünnschichtsolarzellenanordnung ist somit an jeder Stelle zumindest eine durchgängig ausgebildete Dünnschichtsolarzelle vorhanden, somit kann die gesamte in Figur 2 dargestellte erfindungsgemäße Dünnschichtsolarzellenanordnung in ihrer gesamten Breite (d.h. in x-Richtung) zur Stromgewinnung genutzt werden. Der durch die seriell verschaltete Dünnschichtsolarzellenanordnung gewonnene Strom kann beispielsweise mittels zweier Elektroden (E) von der jeweiligen Rückseitenelektrode (1) der ersten Solarzelle (I) bzw. der zweiten Elektrode bzw. Konversionsschicht (3) der dritten Solarzelle (III) abgegriffen werden.

Die jeweilige Überführung der einzelnen aktiven Schichten (1, 2, 3) aus einer höheren Lage (n+1) auf eine darunter liegende Lage (n) erfolgt gemäß dem Beispiel der Figur 2 durch jeweilige versetzte Anordnung der einzelnen aktiven Schichten in den jeweiligen Lagen (n) bzw. (n+1). Wie aus dem vergrößerten Ausschnitt des Übergangsbereichs (A) der Figur 2 ersichtlich, sind die aktiven Schichten (1, 2, 3) der zweiten Solarzelle (II) in der obenliegenden Lage (n+1) gestuft ausgebildet, in denen beispielsweise jeweils die photoaktive Schicht (2), die auf der Rückseitenelektrode abgeschieden ist, bzw. die zweite Elektrode und/oder Konversionsschicht (3), die in z-Richtung auf der photoaktiven Schicht (2) abgeschieden ist, in x-Richtung die jeweiligen, darunter liegenden Schichten überragen. Durch eine spiegelverkehrte Anordnung derselben Schichten in der darunter liegenden Lage ist somit eine Kontaktierung durch Übereinanderschichten der jeweiligen aktiven Schichten (1, 2, 3) möglich.

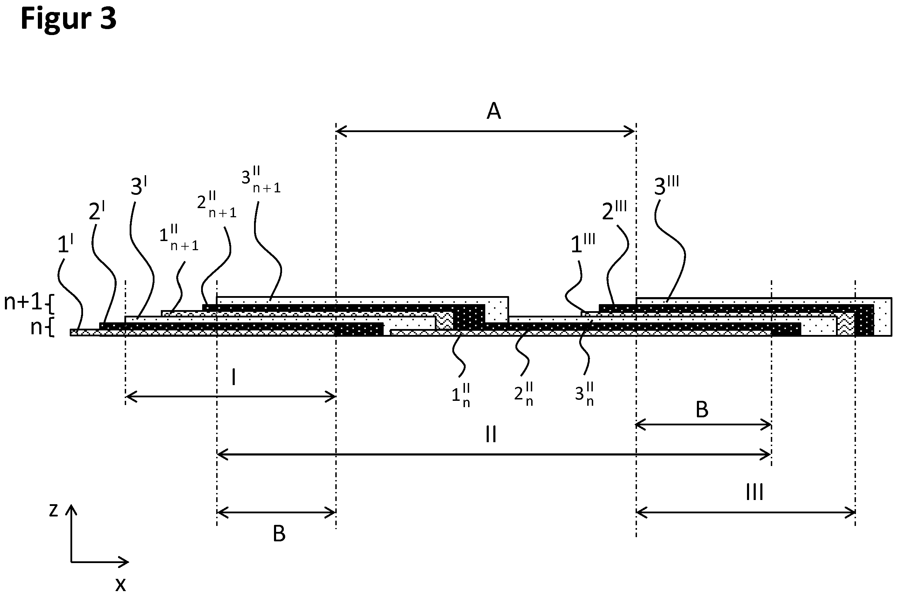

Figur 3 zeigt eine alternative Ausführungsform einer mit dem erfindungsgemäßen Verfahren hergestellten Dünnschichtsolarzellenanordnung. Wie bereits in Figur 2 bestehen dabei die jeweilig dargestellten Dünnschichtsolarzellen (I, II, III) aus den entsprechenden aktiven Schichten (1, 2, 3). In der in Figur 3 dargestellten Ausführungsform weist die Solarzelle (II) einen Übergangsbereich (A) auf, in dem die jeweiligen Schichten dieser zweiten Solarzelle (II) aus einer oben liegenden Lage (n+1) in eine untere Lage (n) überführt werden. In den Überlappbereichen (B) sind jeweils zwei Solarzellen paarweise ausgebildet, also im in Figur 3 dargestellten linken Überlappbereich ein Paar aus der Dünnschichtsolarzelle (I) mit (II) sowie im rechten Überlappbereich aus Solarzelle (II) und Solarzelle (III). Die Überführung der aktiven Schichten der Dünnschichtsolarzelle (II) Im Übergangsbereich (A) erfolgt dabei durch Führung der jeweiligen Schichten in z-Richtung. Auch hier sind die jeweiligen aktiven Schichten (1, 2, 3) der unten liegenden Lage (n) der zweiten Solarzelle (II) in x-Richtung versetzt ausgeführt, sodass eine entsprechend versetzte Kontaktierung der aktiven Schichten (1, 2, 3) der oberen Lage (n+1) der zweiten Solarzelle (II) mit den entsprechenden, in der Lage (n) angeordneten aktiven Schichten (1, 2, 3) möglich ist. Bei der Kontaktierung werden im Beispielsfall der Figur 3 die aktiven Lagen (1, 2, 3) in z-Richtung ausgebildet.

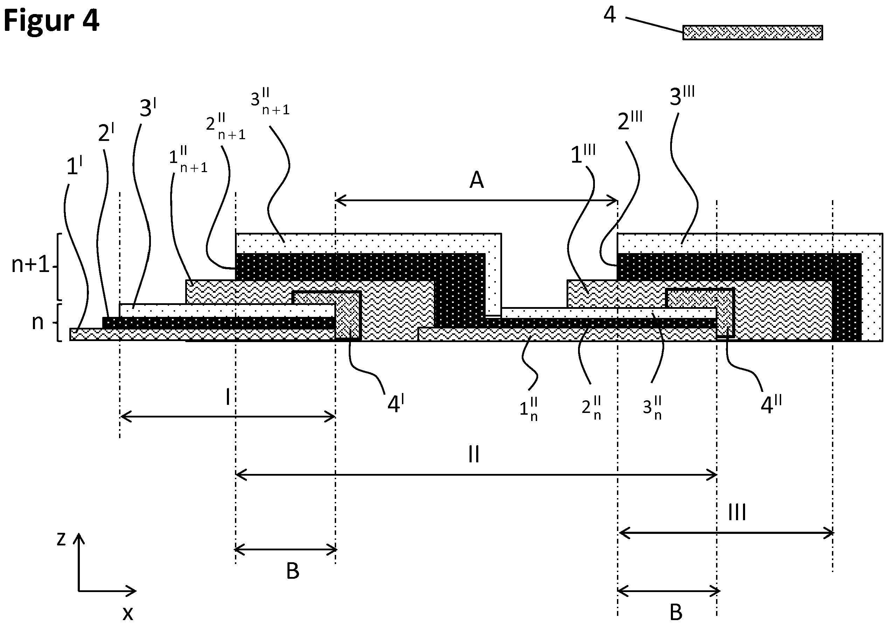

Figur 4 stellt eine weitere Variante einer erfindungsgemäßen Dünnschichtsolarzellenanordnung dar. Diese Ausführungsform entspricht im Wesentlichen der in Figur 3 dargestellten Ausführung. Im Unterschied zur Ausführung gemäß Figur 3 sind allerdings die in der Lage (n) ausgebildeten aktiven Schichten (1, 2, 3) der Solarzelle (I,II) am in Figur 4 dargestellten rechten Ende (in x-Richtung) nicht versetzt zueinander angeordnet, sondern an der gleichen Position (in x-Richtung) beendet und/oder abgetragen. Diese Enden der Schichten (1, 2, 3) können dabei mit einem elektrisch isolierenden Material (4) terminiert werden. Dadurch können effektiv Kurzschlüsse der jeweiligen Solarzellen unterbunden werden. Die serielle Verschaltung erfolgt hierbei beispielsweise durch Kontaktierung der Rückseitenelektrode (1) der zweiten Solarzelle (II) in der oben liegenden Lage (n+1) mit der zweiten Elektrode und/oder Konversionsschicht (3) der ersten Solarzelle (I), die in der ersten Lage (n) angeordnet ist.

In allen zuvor beschriebenen Ausführungsformen gemäß Figuren 2 und 4 kann die Dünnschichtsolarzellenanordnung durch iterative Anordnung weiterer Solarzellen in x-Richtung erweitert werden.

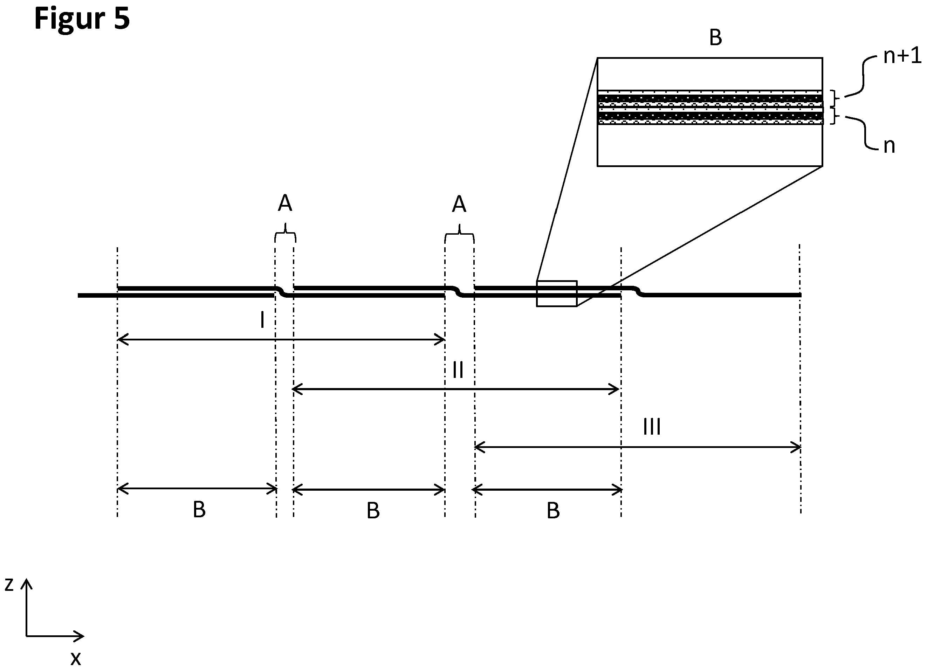

Figur 5 zeigt eine makroskopische Darstellung einer Dünnschichtsolarzellenanordnung hergestellt gemäß der vorliegenden Erfindung, in denen mehrere Überlappbereiche zwischen jeweils Paaren von Solarzellen (I, II) bzw. (II, III) dargestellt sind. Die einzelnen Solarzellen weisen dabei jeweils einen Übergangsbereich auf, in denen die oben liegenden aktiven Schichten der jeweiligen Solarzelle in die unten liegende Schicht überführt werden. Im Übergangsbereich erfolgt dabei eine S-förmige Führung der aktiven Schichten der jeweiligen Solarzelle.

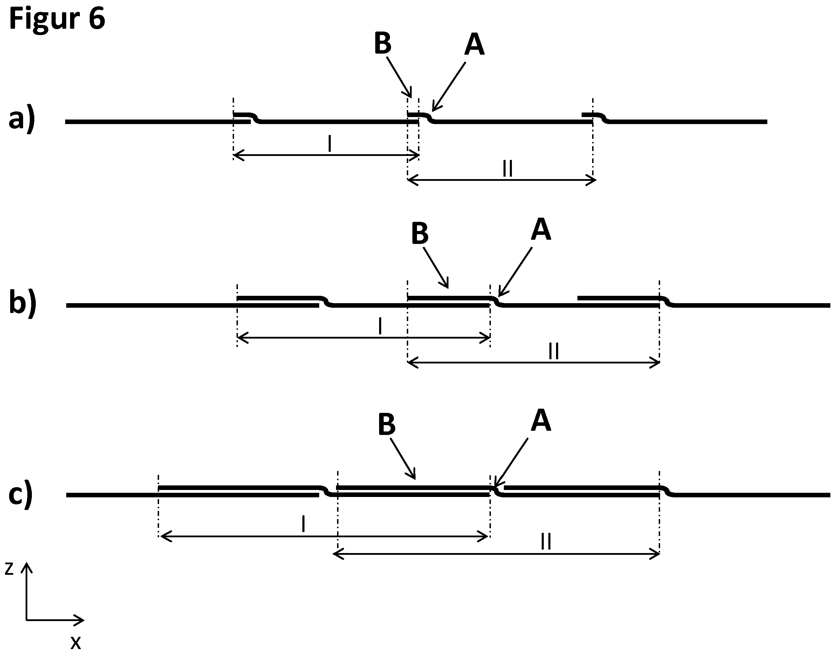

Figur 6 zeigt weitere Ausführungsformen der erfindungsgemäß hergestellten Dünnschichtsolarzellenanordnung, in denen die Breite des Überlappbereiches (B) variiert ist. Gemäß der in Figur 6a) dargestellten Ausführungsform ist der Überlappbereich (B), bezogen auf die gesamte Breite (in x-Richtung) der jeweiligen Dünnschichtsolarzellen (I) bzw. (II) relativ gering. In einer derartigen Dünnschichtsolarzellenanordnung ist somit vornehmlich lediglich eine einzige Lage einer Dünnschichtsolarzelle ausgebildet. Der Überlappbereich kann jedoch, wie in Figur 6b) bzw. Figur 6c) dargestellt, vergrößert werden, sodass eine Dünnschichtsolarzellenanordnung resultiert, bei der fast die vollständige Breite (in x-Richtung) der gesamten Dünnschichtsolarzellenanordnung vom Vorhandensein von zwei Dünnschichtsolarzellen geprägt ist.

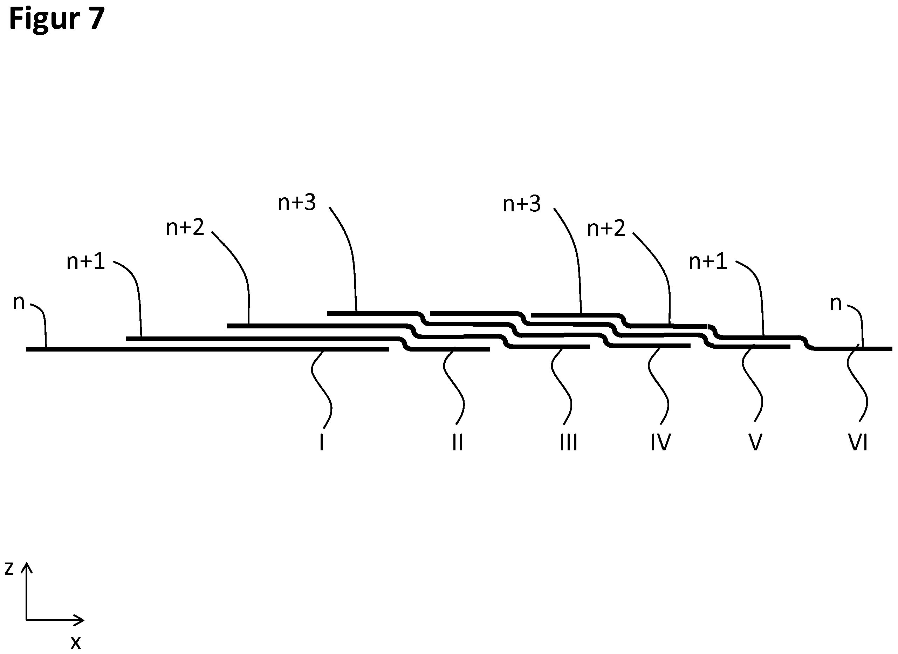

Figur 7 zeigt eine Ausführungsform einer mit dem erfindungsgemäßen Verfahren hergestellten Dünnschichtsolarzellenanordnung, bei der eine Mehrzahl einzelner Dünnschichtsolarzellen (I, II, III, IV, V, VI) in insgesamt vier Lagen (n, n+1, n+2, n+3) angeordnet sind. Jede Solarzelle weist dabei drei Übergangsbereiche auf, die entsprechend den Ausführungen in Figur 5 und 6 mit einem S-förmigen Bereich der jeweiligen aktiven Lagen der Dünnschichtsolarzellen gekennzeichnet sind. Der Übersichtlichkeit halber sind die Überlappbereiche (B) und die Übergangsbereich (A) in Figur 7 nicht näher gekennzeichnet, entsprechen aber den Ausführungen wie sie auch in zu Figur 5 und 6 gewählt wurden. Durch die jeweiligen Übergangsbereich (A) erfolgt eine Überführung der jeweiligen aktiven Lagen einer Dünnschichtsolarzelle aus einer bestimmten Lage in eine unterhalb dieser Lage angeordneten Lage. Diese Ausführungsform ist allerdings nicht auf die dargestellten vier Lagen beschränkt, vielmehr können gemäß dem vorgestellten konstruktiven Konzept beliebig viele Dünnschichtsolarzellen übereinander abgeschieden werden, wobei dann n+x Lagen (mit x > 3) resultieren.

Figur 8 zeigt eine weitere Verfahrensvariante zur Herstellung der erfindungsgemäßen Dünnschichtsolarzellenanordnung. Dabei werden Teilsolarzellen ($I_n$, $II_n$) in einer ersten Lage (n) abgeschieden und seriell verschaltet. Die dabei entstehende Solarzellenanordnung mit einer in Figur 8 dargestellten monolithischen seriellen Verschaltung entspricht der aus Figur 1. Auf diese Lage von Teilsolarzellen ($I_n$, $II_n$) wird in einer zweiten, über der ersten Lage (n) liegenden Lage (n+1) eine weitere Lage von Teilsolarzellen ($II_{n+1}$, $III_{n+1}$) abgeschieden. Beim Abscheiden erfolgt dabei eine parallele Verschaltung der Teilsolarzellen ($II_{n+1}$) in der zweiten Lage (n+1) mit der in der ersten Lage (n) bereits abgeschiedenen Teilsolarzelle ($II_n$), sodass dabei eine Gesamtdünnschichtsolarzellenanordnung wie in Figur 8 unten abgebildet, entsteht. Die dort abgebildete Dünnschichtsolarzellenanordnung entspricht derjenigen aus Figur 3. Wie in Figur 8 dargestellt kann das Abscheiden der Teilsolarzelle $II_{n+1}$ mit einem gewissen Überlapp zur Teilsolarzelle $II_n$ erfolgen. Ein besonderer Vorteil dieses Verfahrens ist, dass mit sehr großen Toleranzen gearbeitet werden kann.

Wie in Figur 8 dargestellt, kann die zweite Lage n+1 (bzw. jede weitere zusätzliche Lage) von Teildünnschichtsolarzellen bereits als vorgefertigter Verbund der ersten Elektrode, photoaktiver Schicht sowie zweite Elektrode abgeschieden werden. Diese Möglichkeit ist in Figur 8 dargestellt.

Bevorzugt ist allerdings, dass die einzelnen Bestandteile der Teildünnschichtsolarzellen separat auf dem Substrat bzw. übereinander abgeschieden werden. Eine entsprechende Sequenz ist in den Figuren 8a bis 8f dargestellt. Die farbliche Kennzeichnung der verwendeten Materialien orientiert sich dabei an den bereits in den Figuren 1 bzw. 3 verwendeten Definitionen.

Wie in Figur 8a dargestellt, wird die erste Elektrode zweier Teildünnschichtsolarzellen $1^I_n$ bzw. $1^{II}_n$, die in der ersten Lage n angeordnet sind, auf einem Substrat abgeschieden. In Figur 8a oben ist der Prozessschritt abgebildet, unten in Figur 8a ist das erhaltene Ergebnis dargestellt. Die beiden ersten Elektroden werden dabei in x-Richtung versetzt zueinander abgeschieden und sind räumlich voneinander getrennt.

Als nächster Schritt wird, wie in Figur 8b dargestellt, die photoaktive Schicht versetzt zu den im ersten Schritt abgeschiedenen Elektroden aufgebracht. Hierbei wird die photoaktive Schicht der ersten Teilsolarzelle $2^I_n$ nicht mit der ersten Elektrode der zweiten Teilsolarzelle $1^{II}_n$ kontaktiert.

Im dritten Schritt, wie in Figur 8c dargestellt, wird die zweite Elektrode 3 abgeschieden, so dass nach diesem Schritt beide Teildünnschichtsolarzellen $I_n$ bzw. $II_n$ fertiggestellt sind. Die zweite Elektrode der linken Teildünnschichtsolarzelle $I_n$ kontaktiert dabei die erste Elektrode der rechten Teildünnschichtsolarzelle $II_n$.

In den nächsten Schrittfolgen werden die weiteren Dünnschichtsolarzellen, die in einer darüberliegenden Lage n+1 angeordnet sind, abgeschieden. Dies geschieht wiederum dadurch, dass iterativ erste Elektrode, photoaktives Material bzw. zweite Elektrode versetzt zueinander abgeschieden werden. Die Sequenz ist in den Figuren 8d bis 8f abgebildet. Durch jeweiliges Überlappen der einzelnen Lagen an Elektroden bzw. photoaktiven Schichten und Überführen in die darunterliegende Lage erfolgt dabei eine parallele Verschaltung und somit die Ausbildung des Übergangsbereichs A (in den Figuren 8 nicht dargestellt). Das Ergebnis, das in Figur 8f erhalten wird, entspricht der bereits im Detail in Figur 3 dargestellten Dünnschichtsolarzellenanordnung.

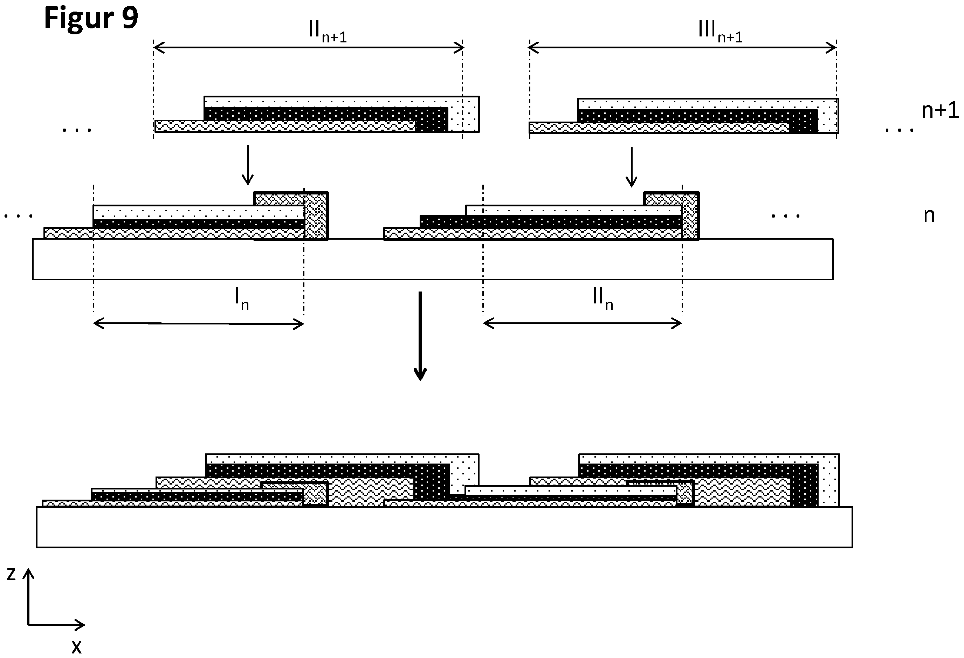

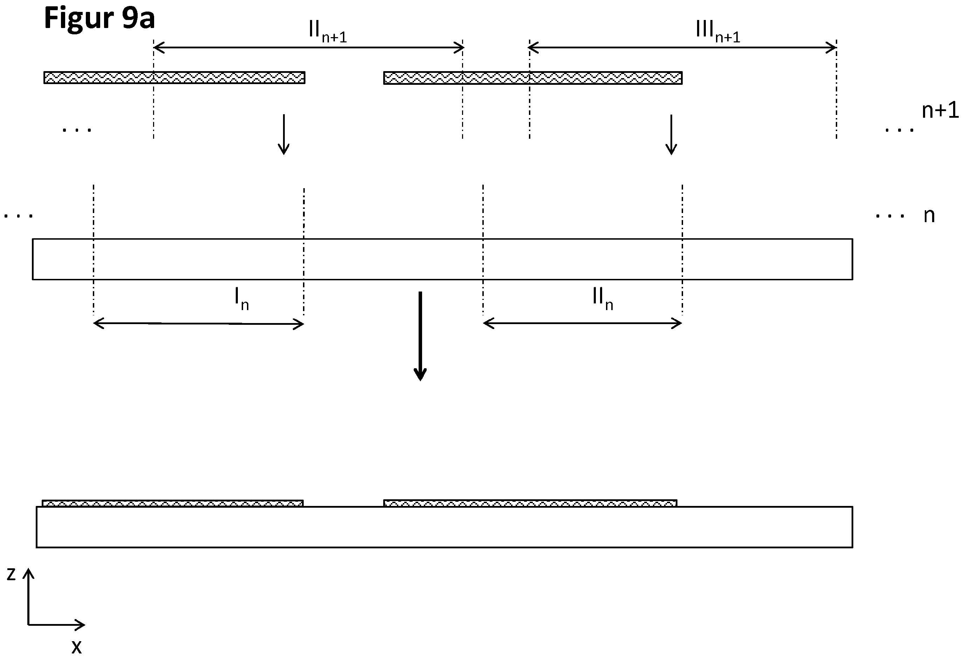

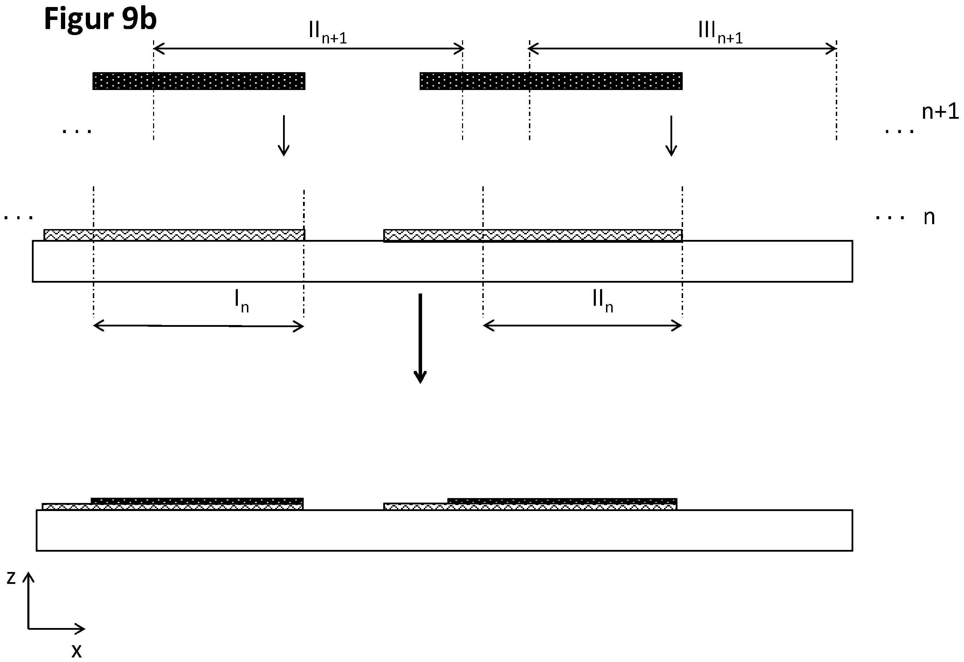

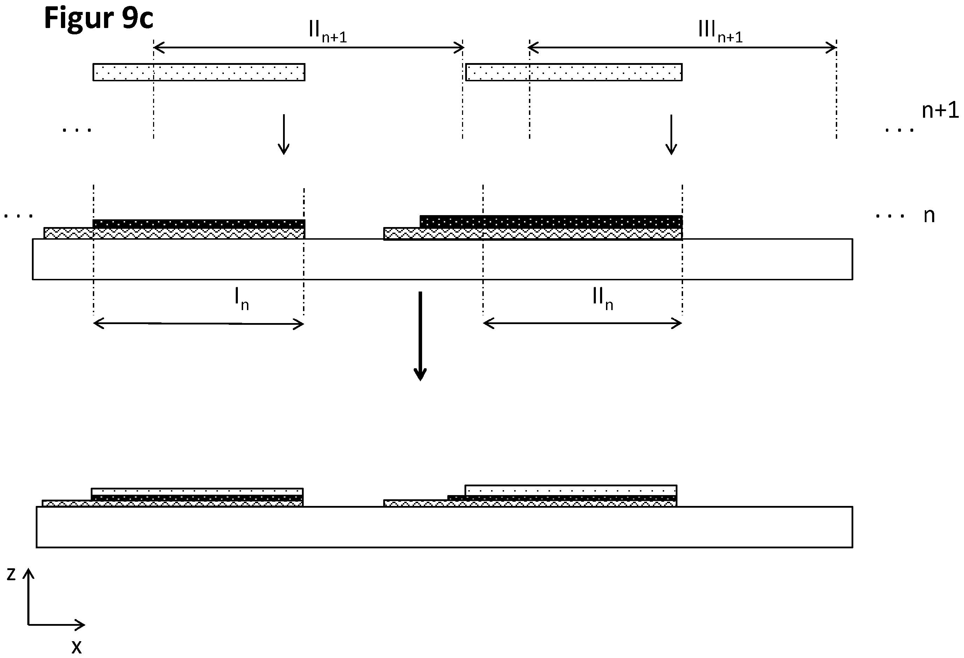

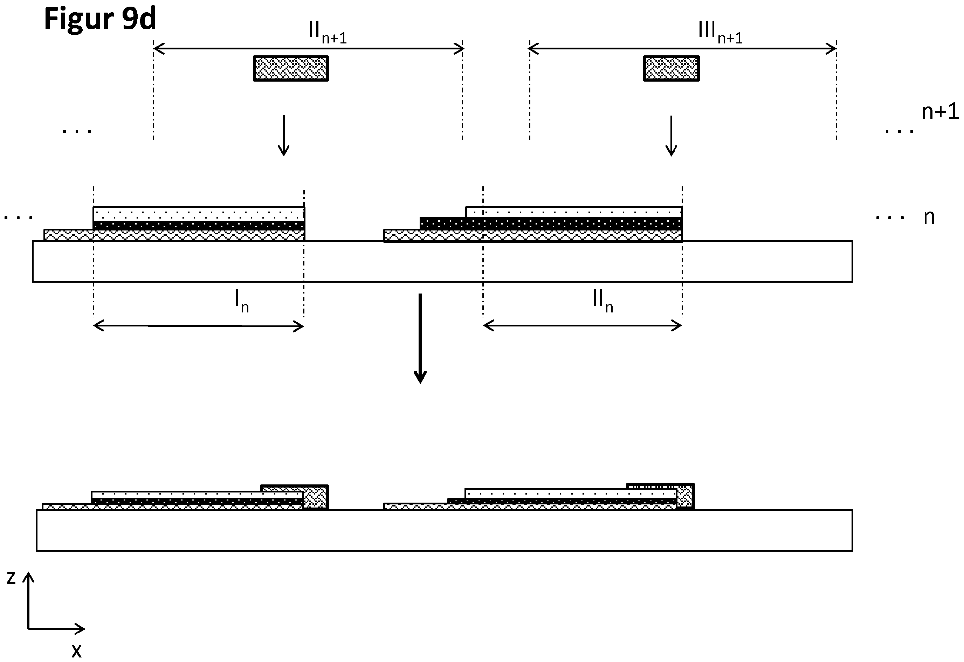

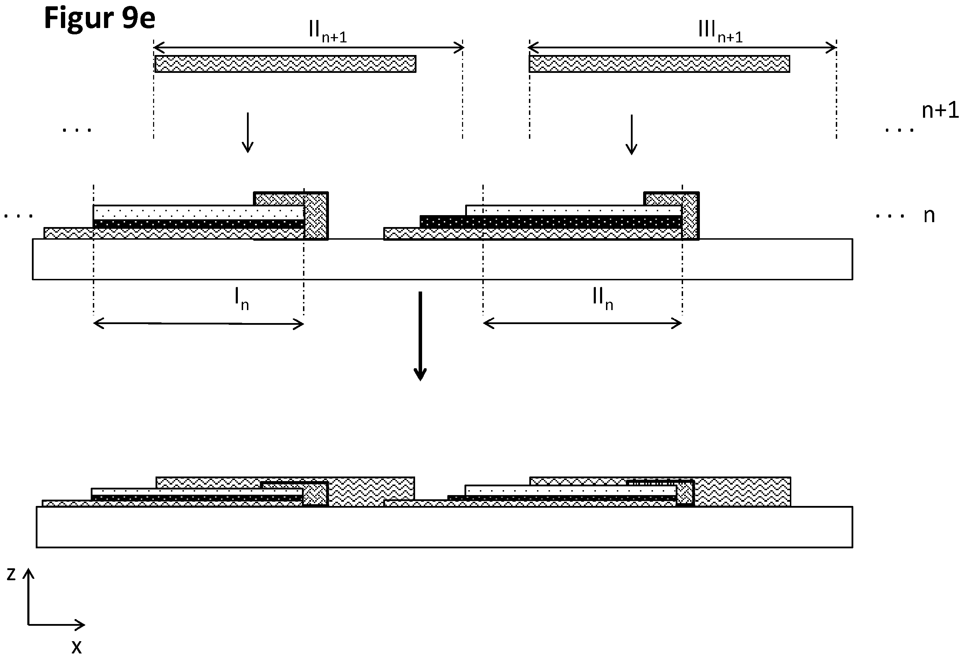

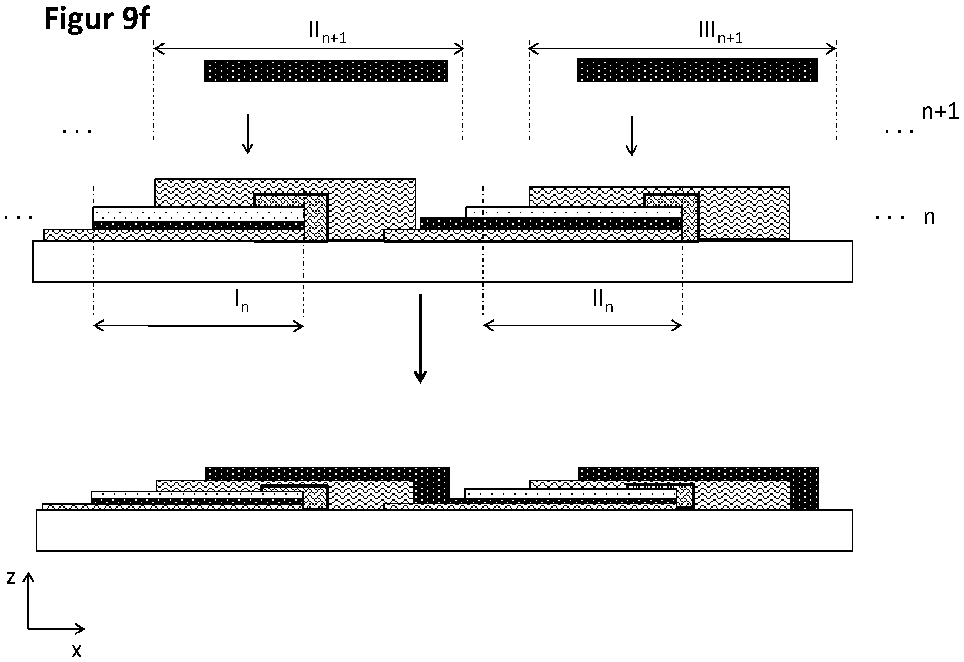

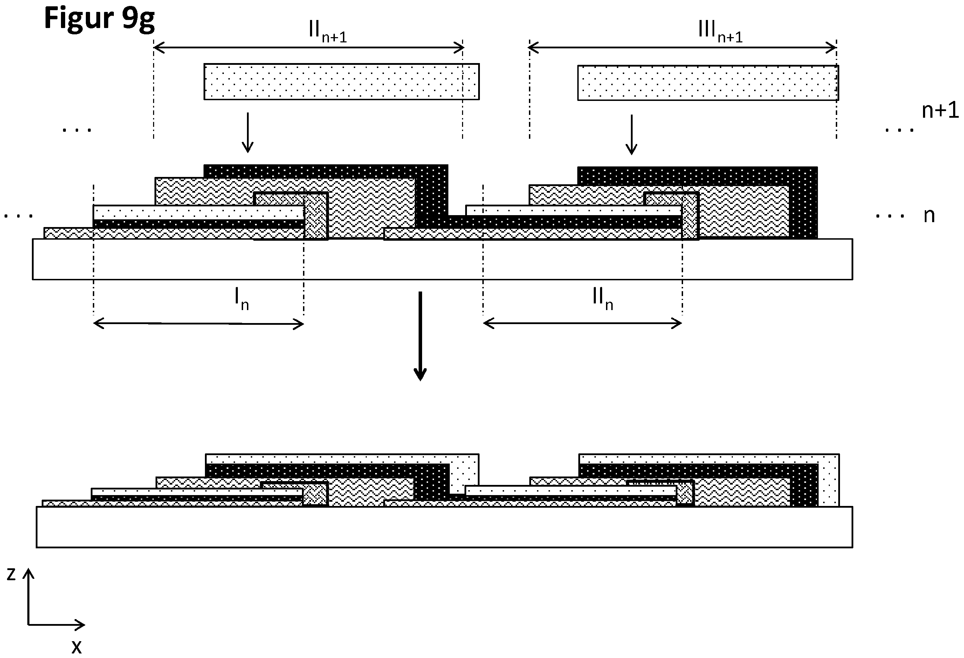

Figur 9 zeigt eine Verfahrensvariante des in Figur 8 dargestellten Verfahrens. Vor Aufbringen der zweiten Lage (n+1) von Teildünnschichtsolarzellen erfolgt dabei eine isolierende Terminierung der in der ersten Lage (n) aufgebrachten Teildünnschichtsolarzellen. Durch entsprechende parallele Verschaltung der Teildünnschichtsolarzellen ($II_{n+1}$, $II_n$) resultiert dabei eine Gesamt-Dünnschichtsolarzellenanordnung (siehe Figur 9 unten), die der in Figur 4 dargestellten Dünnschichtsolarzellenanordnung entspricht.

Wie bereits bei Figur 8 diskutiert, ist es möglich, einen Verbund aus weiteren Schichten, d.h. erste Elektrode, photoaktiver Schicht und zweite Elektrode auf in einer Lage n befindlichen, vorgefertigten Teildünnschichtsolarzellen abzuscheiden, wie dies in Figur 9 dargestellt ist.

Bevorzugt ist allerdings eine sukzessive Abscheidung der einzelnen Schichten, wie dies in der Figurenfolge 9a bis 9g dargestellt ist.

Das Abscheiden der einzelnen Schichten, d.h. erste Elektrode etc. erfolgt dabei auf analoge Weise, wie in den Figuren 8a bis 8f dargestellt.

Als wesentlichster Unterschied zur Verfahrensführung gemäß der Figurenfolge 8 werden hierbei allerdings die einzelnen Bestandteile der jeweiligen Teildünnschichtsolarzelle, d.h. erste Elektrode, photoaktive Schicht und zweite Elektrode, auf einer Seite (in Figur 9 die jeweilig rechte Seite einer Teildünnschichtsolarzelle) gleichlang ausgeführt und nicht überlappend. Dies wird insbesondere bei den Figuren 9b und 9c ersichtlich, hierbei wird die photoaktive Schicht bzw. die zweite Elektrode stets gleichlang auf der rechten Seite ausgeführt, wie die darunterliegende erste Elektrode, so dass eine abschließende Kante der jeweiligen Teildünnschichtsolarzelle entsteht. Zur Vermeidung von Kurzschlüssen wird diese Seite terminiert, indem beispielsweise ein elektrisch isolierendes Material zur Terminierung der einzelnen Schichten abgeschieden wird (siehe Figur 9d).

Die serielle Verschaltung der einzelnen Teildünnschichtsolarzellen $I_n$ und $II_n$ erfolgt durch Abscheiden einer weiteren Lage, die hier gleichzeitig die erste Elektrode der Teildünnschichtsolarzellen der zweiten Lage n+1 darstellt (siehe Figuren 9e). Diese abgeschiedene Elektrode wird einerseits mit der zweiten Elektrode bzw. Konversionsschicht der ersten Teildünnschichtsolarzelle $I_n$ kontaktiert, andererseits soweit in x-Richtung nach rechts geführt, dass dort eine Kontaktierung und somit serielle Verschaltung mit der ersten Elektrode der zweiten Teildünnschichtsolarzelle $II_n$ ermöglicht wird. In den Figuren 9f und 9g ist die Abscheidung der weiteren Bestandteile der Teildünnschichtsolarzellen, die in der Lage n+1 angeordnet sind ($II_{n+1}$ und $III_{n+1}$) dargestellt. Durch jeweilige Überlappung wird hierbei eine Kontaktierung mit der Teildünnschichtsolarzelle in der darunterliegenden Schicht ermöglicht und somit eine Parallelverschaltung der Teildünnschichtsolarzelle aus der zweiten Lage n+1 und einer Teildünnschichtsolarzelle in einer darunterliegenden Lage n. Es resultiert eine Dünnschichtsolarzellenanordnung, wie sie bereits in Figur 4 im Detail beschrieben ist.

Sowohl bei der Verfahrensführung gemäß Figur 8 und Figuren 8a bis 8f bzw. Figuren 9a bis 9g ist es möglich und bevorzugt, dass die jeweiligen Teildünnschichtsolarzellen in einer Lage simultan abgeschieden werden, d.h. die jeweiligen, sie bildenden Schichten (erste Elektrode, photoaktive Schicht, zweite Elektrode bzw. Konversionsschicht) werden für alle Teildünnschichtsolarzellen jeweils simultan abgeschieden. Es ist jedoch ebenso möglich, jede einzelne Teildünnschichtsolarzelle bzw. Gruppen hiervon separat abzuscheiden.

In Figur 10 ist ein Gießkopf (G) dargestellt, mit dem z.B. die voranstehend beschriebene bevorzugte Ausführungsform des erfindungsgemäßen Verfahrens durch Filmgießen der jeweiligen Dünnschichtsolarzellen erfolgen kann. Der Gießkopf verfügt dabei über eine Vielzahl von Gießschlitzen (a, b...), von denen in Figur 10 lediglich zwei Gießschlitze (a, b) dargestellt sind. Die jeweiligen Gießschlitze (a, b) sind dabei in eine Mehrzahl von separaten Kompartimenten (a1, a2, a3, a4) bzw. (bl, b2,...b7) unterteilt. Dabei werden die jeweiligen Kompartimente mit unterschiedlichen Precursor-Materialien versorgt, aus denen die entsprechenden aktiven Schichten (1, 2, 3) einer jeweiligen Solarzelle gebildet sind.

Figur 11 zeigt ein Ergebnis eines mit einem Gießkopf ($G^l$) erfolgenden Filmgießverfahrens: Dargestellt ist eine Dünnschichtsolarzellenanordnung, bei denen die Dünnschichtsolarzellen in zwei Lagen (n) und in (n+1) angeordnet sind. Die jeweiligen Dünnschichtsolarzellen in einer Lage (n) sind dabei aus den einzelnen laminierten Schichten (a, b, c) bzw. (d, e, f für die Lage n+1) gebildet. Die jeweiligen laminierten Schichten entsprechen dabei den im Gießkopf (G') vorhandenen Gießschlitzen. Durch Wahl der Geometrie der Anordnung der Gießschlitze sowie der einzelnen Kompartimente kann die Geometrie der jeweiligen aktiven Schichten einer jeweiligen Solarzelle vordefiniert werden. Dies wird beispielsweise anhand der laminierten Schicht (b) verdeutlicht: Mit dem Kompartiment (b1) des Gießkopfes (G')wird beispielsweise ein Material für eine Rückseitenelektrode (1) abgeschieden, über das Kompartiment (b2) kann eine isolierenden Stoppschicht abgeschieden werden. Im Kompartiment (b3) wird ein Material für eine photoaktive Schicht abgeschieden. Mit einem entsprechend ausgestatteten Gießkopf (G') kann in einem Schritt somit die gesamte Dünnschichtsolarzellenanordnung erzeugt werden.

Figur 12 stellt eine zweite Variante eines erfindungsgemäßen Verfahrens zur Herstellung einer erfindungsgemäßen Dünnschichtsolarzellenanordnung vor. Gemäß dem in Figur 12 dargestellten Verfahren erfolgt die Erzeugung der jeweiligen aktiven (1, 2, 3) Schichten oder Lagen der jeweiligen Dünnschichtsolarzellen (I, II, III) mittels Filmgießens, wobei ein Gießkopf (G) verwendet wird. Der Gießkopf (G) weist eine Vielzahl von Gießschlitzen (X) auf, wobei jeder Gießschlitz einer aktiven Lage (1, 2, 3) einer jeweiligen Dünnschichtsolarzelle (I, II, III) zugeordnet ist. Im Beispielsfalle der Figur 12 weisen die Dünnschichtsolarzellen dabei jeweils drei aktive Schichten auf, entsprechend verfügt der Gießkopf (G) über jeweils drei Gießschlitze zur Erzeugung jeweils einer einzelnen Dünnschichtsolarzelle. Die Gießschlitze sind dabei jeweils für die einzelnen aktiven Lagen (1, 2, 3) einer jeden Dünnschichtsolarzelle versetzt zueinander angeordnet, sodass die einzelnen Schichten in x-Richtung mit geringem Versatz zueinander abgeschieden werden können. Zusätzlich sind die Gießschlitze für die entsprechenden aktiven Schichten (1, 2, 3) einer jeden weiteren Solarzelle versetzt zu den Gießschlitzen für die aktiven Schichten (1, 2, 3) der vorhergehenden Dünnschichtsolarzellen angeordnet, sodass ein teilweiser Überlapp gewährleistet ist. Wie mit (*) in Figur 12 dargestellt können auch weitere Gießschlitze vorhanden sein. Das erfindungsgemäße Verfahren sieht nun vor, dass jeder Gießschlitz mit einem entsprechenden Material für die entsprechende aktive Schicht einer jeden Dünnschichtsolarzelle versorgt wird, in dem das entsprechende Material durch den entsprechenden Gießschlitz gegossen oder gepresst wird. Dadurch entsteht ein Flüssigkeitsvorhang, der auf einem Substrat (nicht dargestellt) abgeschieden werden kann, in dem beispielsweise der Gießkopf in $\gamma$-Richtung über das Substrat oder das Substrat in $\gamma$-Richtung unterhalb dem Gießkopf durchgeführt wird. Mit einem derartigen erfindungsgemäßen Verfahren lassen sich insbesondere Dünnschichtsolarzellenanordnungen, wie in den Figuren 5 und 6 dargestellt, erzeugen.

Figur 13 zeigt eine Abwandlung des in Figur 12 dargestellten Verfahrens, hierbei ist ein zusätzlicher Gießschlitz (X$^E$) vorhanden, über den beispielsweise zusätzlich eine Elektrode abgeschieden werden kann. Im Beispielsfall der Figur 13 ist die Elektrode aus dem gleichen Material wie die jeweilige zweite Elektrode und/oder Konversionsschicht (3) derjeweiligen Solarzellen gebildet. Zudem ist die Breite des Gießschlitzes $\left( X_3^{\mathrm{III}} \right)$ etwas verbreitert, sodass dadurch ebenso am überstehenden Bereich eine Kontaktierung entstehen kann.

Figur 14 zeigt eine weitere erfindungsgemäße Verfahrensvariante, bei dem die einzelnen aktiven Schichten (1, 2, 3) der jeweiligen Dünnschichtsolarzellen (I, II, III) mittels eines Tintelstrahldruckverfahrens abgeschieden werden. Dargestellt ist eine Verfahrensvariante, bei dem mehrere Druckköpfe (1, 2,...9) gleichzeitig drei Dünnschichtsolarzellen (I, II, III) mit jeweiligen aktiven Schichten (1, 2, 3) auf ein Substrat (S) aufdrucken. Dabei kann das Substrat in $\gamma$-Richtung relativ unter den Druckwerkzeugen durchgezogen werden, ebenso ist es möglich, die Druckwerkzeuge in $\gamma$-Richtung über das unbewegte Substrat (S) zu führen. Wie mit (*) angedeutet, können auch weitere Druckwerkzeuge vorhanden sein, um gleichzeitig weitere Solarzellen abzuschalten.

Figur 15 zeigt eine weitere prinzipielle Ausgestaltungsform einer erfindungsgemäßen Dünnschichtsolarzellenanordnung wie sie insbesondere mit den in den Figuren 12 bis 14 vorgestellten Verfahren erzeugt werden kann. Diese kann dadurch erzeugt werden, dass die photoaktive Schicht (2) bzw. die zweite Elektrode und/oder Konversionsschicht (3) der jeweiligen Solarzellen (I, II, III) in das Elektrodenmaterial der Rückseitenelektrode (1) durchgängig eingebracht werden, beispielsweise in dem die entsprechenden Schichten eingegossen werden. Die jeweiligen photoaktiven Schichten (2) bzw. die zweiten Elektroden und/oder Konversionsschichten (3) verlaufen dabei geradlinig und versetzt zueinander. Eine serielle Verschaltung der einzelnen Dünnschichtsolarzellen (I, II, III) erfolgt dabei durch Materialabtrag an Stellen (6), wobei ggf. isolierende Materialien (4) als isolierenden Stoppschicht bzw. lokalisolierte Elektroden (5) voneinander getrennt werden können. Die Strukturierung an Stellen (6) kann durch Abtrag der jeweiligen Schicht oder durch Zerstörung der Leitfähigkeit erfolgen, beispielsweise in dem Material durch Laserablation abgetragen wird. Gemäß den prinzipiellen Ausführungen zu Figur 2 und Figur 3 sind auch bei der Ausführungsform gemäß Figur 8 die jeweiligen aktiven Schichten (1, 2, 3) einer jeweiligen Solarzelle (I, II, III) in zwei Lagen (n+1, n) angeordnet; dies sei am Beispiel der Dünnschichtsolarzelle (II) verdeutlicht: Durch die schrägverlaufende Anordnung in der zx-Ebene der einzelnen aktiven Schichten (1, 2, 3) der Dünnschichtsolarzelle (II) sind die im linken Bereich (in x-Richtung) angeordneten Schichten (1, 2, 3) der Dünnschichtsolarzelle (II) in z-Richtung weiter oben liegend angeordnet als die entsprechenden Schichten am rechten Ende der Dünnschichtsolarzelle am rechten Ende der Dünnschichtsolarzelle (II). Die entsprechenden aktiven Schichten (1, 2, 3) sind dabei zusätzlich überhalb der entsprechenden aktiven Schichten der Dünnschichtsolarzelle (I) angeordnet, also in einer überhalb der Solarzelle (I) angeordneten Lage (n+1). Durch iterative Anordnung sämtlicher aktiver Schichten der jeweiligen Dünnsichtsolarzellen auf die zuvor beschriebene Weise resultiert somit eine Wiederholung des Überlapps der einzelnen aktiven Schichten (1, 2, 3) der jeweiligen Solarzellen, sodass sich ein jeweiliger Übergangsbereich (B) ausbildet. Im Übergangsbereich (A) sind lediglich aktive Schichten einer Solarzelle, im in Figur 15 dargestellten Beispielsfall der Dünnschichtsolarzelle (II) vorhanden, wobei hier eine Überführung der jeweiligen aktiven Schichten in eine darunter liegende Lage (n) erfolgt. Es ist darauf hinzuweisen, dass der geradlinige Verlauf der einzelnen aktiven Schichten, insbesondere der Schichten 2 und 3 idealisiert dargestellt ist. Die Schichten können geradlinig in der zx-Ebene verlaufen, allerdings sind auch gebogene bzw. gekrümmte Verläufe, die beispielsweise aus dem Herstellungsverfahren durch Sentimentationsprozesse entstehen, oder Kombinationen aus gebogenen/gekrümmten und geradlinigen Verläufen dieser Schichten denkbar.

Eine weitere Verfahrensvariante ist in Figur 16 dargestellt. In einem ersten Schritt a) erfolgt dabei eine Auflaminierung einer ersten Dünnschichtsolarzelle auf ein Substrat (S). In der Ausführung gemäß Figur 16 wird die Solarzelle dabei über einen isolierenden Kleber (K) auf dem Substrat (S) aufgebracht.

In Schritt b) wird über diese bereits auf dem Substrat (S) auflaminierte erste Dünnschichtsolarzelle eine zweite Dünnschichtsolarzelle aufgebracht, in dem ein Verbund (V) aus einem temporären Träger (T) mit daran auflaminierter zweiter Dünnschichtsolarzelle mit den jeweiligen aktiven Schichten (1, 2, 3) sowie einer darunter angeordneten isolierenden Kleberschicht (K) über die bereits auf der ersten Substrat befindliche Dünnschichtsolarzelle auflaminiert wird. In einem Schritt c) erfolgt die Entfernung des temporären Trägers (T) der beispielsweise eine Grundstofffolie sein kann. Da die einzelnen Schichten dünn und flexibel ausgebildet sind, erfolgt ebenso eine Anhaftung der zweiten, in Schritt b) laminierten Dünnschichtsolarzelle auf dem Substrat mittels der isolierenden Kleberschicht (K) (durch den Pfeil angedeutet). In einem weiteren Schritt d) der temporäre Träger (T) wird in einem weiteren Schritt c) entfernt. In einem Schritt d) erfolgt über eine leitfähige Verbindung eine serielle Verschaltung der einzelnen Dünnschichtsolarzellen. Der temporäre Träger kann auch eine Flüssigkeit sein.

Figur 17 zeigt eine Variante des in Figur 16 dargestellten Verfahrens, hierbei erfolgt ebenso eine Laminierung einer Solarzelle über eine entsprechende isolierende Klebeschicht (K) auf einem Substrat (S). In Figur 17 ist ein Verfahrensstadium dargestellt, in dem bereits zwei Dünnschichtsolarzellen übereinander abgeschieden sind. Die Auflaminierung der dritten Dünnschichtsolarzelle erfolgt dabei, in dem zunächst eine separate Kleberschicht (K) auf dem bereits vorhandenen Dünnschichtsolarzellen teilweise überlappend abgeschieden und auf dem Substrat verklebt wird. Auf diese isolierende Klebeschicht (K) wird ein Verbund aus einem Träger sowie einer weiteren Dünnschichtsolarzelle mit entsprechenden aktiven Schichten aufgebracht (c)), in einem weiteren Schritt d) kann das temporäre Trägersubstrat (T) wieder entfernt werden. Abschließend erfolgt eine serielle Verschaltung der aufgebrachten Dünnschichtsolarzellen über eine elektrische Verbindung 7.

Figur 18 zeigt eine weitere erfindungsgemäße Verfahrensvariante, bei der die Dünnschichtsolarzellen auf einem Trägersubstrat (S) mittels eines leitenden Klebers (K') auflaminert werden. In einem ersten Schritt a) wird eine erste Dünnschichtsolarzelle auf einem Trägersubstrat (S) über eine elektrisch leitfähige Klebeverbindung (K') aufgebracht. Abschließend kann eine Terminierung der jeweiligen aktiven Schichten der aufgebrachten Dünnschichtsolarzelle mittels eines elektrischen Isolators (4) erfolgen. In einem Schritt b) erfolgt ein Auflaminieren eines Verbundes aus einem temporären Träger, auf dem eine Dünnschichtsolarzelle sowie eine elektrisch leitende Klebeverbindung (K') aufgebracht ist, in dem der Verbund partiell überlappend mit der bereits auf dem Substrat abgeschiedenen Dünnschichtsolarzelle verklebt wird. In Schritt c) wird der Träger (T) entfernt. Abschließend können erneut die freiliegenden Enden der jeweiligen aktiven Schichten der neu auflaminierten Dünnschichtsolarzelle mittels eines elektrischen Isolators (4) terminiert werden. Die elektrisch serielle Verschaltung erfolgt dabei durch den elektrisch leitfähigen Kleber (K'). Durch iteratives Wiederholen der Schritte b) und c) sowie ggf einer entsprechenden elektrischen Terminierung (4) der neuentstehenden Dünnschichtsolarzellen kann eine Anordnung aus mehreren, in x-Richtung nebeneinander auflaminierten Dünnschichtsolarzellen erzeugt werden.

Figur 19 zeigt eine weitere Variante eines in Figur 18 dargestellten Verfahrens. Im Unterschied zu Figur 18 wird hier die elektrisch leitfähige Klebeschicht (K') vor Auflaminieren einer weiteren Dünnschichtsolarzelle (vgl. mit den Ausführungen zu Figur 17) auflaminiert.

**Patentansprüche**

1. Verfahren zur Herstellung einer Dünnschichtsolarzellenanordnung, umfassend eine Mehrzahl von auf einem Substrat (S) aufgebrachten Dünnschichtsolarzellen (I, II, III, ...), die jeweils zumindest eine erste, dem Substrat (S) zugewandte Rückseitenelektrode ($1^I$, $1^{II}$, $1^{III}$, ...), eine zweite Elektrode und/oder eine Konversionsschicht ($3^I$, 3", $3^{III}$, ...) sowie eine zwischen der Rückseitenelektrode ($1^I$, $1^{II}$, $1^{III}$, ...) und der zweiten Elektrode und/oder der Konversionsschicht ($3^I$, $3^{II}$, $3^{III}$, ...) angeordnete photoaktive Schicht ($2^I$, $2^{II}$, $2^{III}$, ...) umfassen, wobei die Dünnschichtsolarzellenanordnung

   a) mindestens einen Überlappbereich (B) aufweist, in dem jeweils eine erste (I, II, ...) und eine zweite Dünnschichtsolarzelle (II, III, ...) in zwei Lagen (n, n+1, ...) paarweise (I-II, II-III, ...) übereinander liegend angeordnet sind, wobei ein Bereich der jeweils ersten Dünnschichtsolarzelle (I, II, ...) in einer ersten Lage (n, ...) und ein Bereich der jeweils zweiten Dünnschichtsolarzelle (II, III, ...), der auf der vom Substrat (S) abgewandten Seite der jeweils ersten Dünnschichtsolarzelle (I, II, ...) in einer über der jeweils ersten Dünnschichtsolarzelle (I, II, ...) liegenden Lage (n+1, ...) angeordnet ist, miteinander verbunden und elektrisch seriell verschaltet sind, und

   b) mindestens einen Übergangsbereich (A) aufweist, in dem jeweils nur die jeweils zweite Dünnschichtsolarzelle (II, III, ...) des Paares aus jeweils erster und jeweils zweiter Dünnschichtsolarzelle (I-II, II-III, ...) ausgebildet ist, wobei die in der über der ersten Lage liegende Lage (n+1, ...) ausgebildete Rückseitenelektrode ($1^{II}_{n+1}$, $1^{III}_{n+1}$, ...), die photoaktive Schicht ($2^{II}_{n+1}$, $2^{III}_{n+1}$, ...) und die zweite Elektrode und/oder die Konversionsschicht ($3^{II}_{n+1}$, $3^{III}_{n+1}$ ...) der jeweils zweiten Dünnschichtsolarzelle (II, III, ...) in jeweils eine, in der ersten Lage (n, ...) ausgebildete Rückseitenelektrode ($1^{II}_n$, $1^{III}_n$, ...), eine photoaktive Schicht ($2^{II}_n$, $2^{III}_n$, ...) und eine zweite Elektrode und/oder eine Konversionsschicht ($3^{II}_n$, $3^{III}_n$ ...)

überführt wird,

bei dem auf einem Substrat (S) gleichzeitig oder nacheinander mehrere Dünnschichtsolarzellen (I, II, III, ...) durch jeweiliges gleichzeitiges oder nacheinander erfolgendes Abscheiden zumindest einer ersten, dem Substrat (S) zugewandten Rückseitenelektrode ($1^I$, $1^{II}$, $1^{III}$, ...), einer darüber angeordneten photoaktiven Schicht ($2^I$, $2^{II}$, $2^{III}$, ...) sowie einer darüber angeordneten zweiten Elektrode und/oder einer Konversionsschicht ($3^I$, $3^{II}$, $3^{III}$, ...) auf dem Substrat (S) erzeugt werden,
wobei zumindest zwei Dünnschichtsolarzellen (I, II, III, ...) in mindestens einem Überlappbereich (B) paarweise (I-II, II-III, ...) in mindestens zwei Lagen (n, n+1, ...) übereinander liegend erzeugt werden, indem die jeweils zweite Dünnschichtsolarzelle (II, III, ...) eines jeden Paares (I-II, II-III, ...) aus erster (I, II, ...) und zweiter Dünnschichtsolarzelle (II, III, ...) bereichsweise in einer über der jeweils ersten Dünnschichtsolarzelle liegenden Lage (n+1, n+2, ...) abgeschieden wird und die jeweils erste (I, II, ...) und zweite Dünnschichtsolarzelle (II, III, ...) in diesem Bereich (B) elektrisch seriell verschaltet werden,
und die jeweils zweite Dünnschichtsolarzelle (II, III, ...) eines jeden Paares (I-II, II-III, ...) aus erster (I, II, ...) und zweiter Dünnschichtsolarzelle (II, III, ...) versetzt zur jeweils ersten Dünnschichtsolarzelle (I, II, ...) eines jeden Paares (I-II, II-III, ...) aus erster (I, II, ...) und zweiter Dünnschichtsolarzelle (II, III, ...) abgeschieden wird, so dass ein Übergangsbereich (A) ausgebildet wird, in dem die Rückseitenelektrode ($1^{II}$, $1^{III}$, ...), die darüber angeordnete photoaktive Schicht ($2^{II}$, $2^{III}$, ...) sowie die darüber angeordnete zweite Elektrode und/oder die Konversionsschicht ($3^{II}$, $3^{III}$, ...) der jeweils zweiten Dünnschichtsolarzelle eines jeden Paares (I-II, II-III, ...) aus erster (I, II, ...) und zweiter Dünnschichtsolarzelle (II, III, ...) aus der über der jeweils ersten Dünnschichtsolarzelle liegenden Lage (n+1, n+2, ...) auf eine darunterliegende Lage (n, n+1) überführt wird.

2. Verfahren nach Anspruch 1, **dadurch gekennzeichnet, dass** das Abscheiden und/oder Vorfertigen der Dünnschichtsolarzellen, Teildünnschichtsolarzellen und/oder der ersten, dem Substrat (S) zugewandten Rückseitenelektroden, der zweiten Elektroden und/oder Konversionsschichten sowie den photoaktiven Schicht der Dünnschichtsolarzellen und/oder Teildünnschichtsolarzellen aus der Flüssigphase oder der Gasphase erfolgt, insbesondere durch Aerosoldruck, Vakuumabscheiden, Tintenstrahldruck, Filmgießen und/oder Klebeverfahren erfolgt.

3. Verfahren nach einem der vorhergehenden Ansprüche, **dadurch gekennzeichnet, dass** in einer ersten Lage (n, ...) mindestens zwei Teildünnschichtsolarzellen ($I_n$, $II_n$, ...), die jeweils zumindest eine erste, dem Substrat (S) zugewandte Rückseitenelektrode, eine zweite Elektrode und/oder eine Konversionsschicht sowie eine zwischen der Rückseitenelektrode und der zweiten Elektrode und/oder der Konversionsschicht angeordnete photoaktive Schicht umfassen, vorgefertigt werden und mindestens eine weitere Teildünnschichtsolarzelle ($II_{n+1}$, $III_{n+1}$, ...), die jeweils zumindest eine erste, dem Substrat (S) zugewandte Rückseitenelektrode, eine zweite Elektrode und/oder eine Konversionsschicht sowie eine zwischen der Rückseitenelektrode und der zweiten Elektrode und/oder der Konversionsschicht angeordnete photoaktive Schicht umfasst, in einer zweiten Lage (n+1) versetzt auf die in der ersten Lage (n, ...) angeordneten mindestens zwei Teildünnschichtsolarzellen ($I_n$, $II_n$, ...) abgeschieden wird, wobei mindestens ein Überlappbereich (B) zwischen mindestens einer in der ersten Lage (n, ...) angeordneten Teildünnschichtsolarzelle ($I_n$) und einer in einer zweiten Lage (n+1, ...) abgeschiedenen Teildünnschichtsolarzelle ($II_{n+1}$) sowie mindestens ein Übergangsbereich (A) durch Kontaktieren der Rückseitenelektrode, der photoaktiven Schicht sowie der zweiten Elektrode und/oder der Konversionsschicht der in der zweiten Lage (n+1, ...) abgeschiedenen Teildünnschichtsolarzelle ($II_{n+1}$) mit der Rückseitenelektrode, der photoaktiven Schicht sowie der zweiten Elektrode und/oder der Konversionsschicht der in der ersten Lage (n, ...) angeordneten Teildünnschichtsolarzelle ($II_n$) ausgebildet wird,
wobei bevorzugt beim Vorfertigen bzw. Abscheiden der mindestens zwei Teildünnschichtsolarzellen ($I_n$, $II_n$, ...) und/oder der mindestens einen weiteren Teildünnschichtsolarzelle ($II_{n+1}$, $III_{n+1}$, ...) die zumindest eine erste, dem Substrat (S) zugewandte Rückseitenelektrode, die zweite Elektrode und/oder die Konversionsschicht sowie die zwischen der Rückseitenelektrode und der zweiten Elektrode und/oder der Konversionsschicht angeordnete photoaktive Schicht für jede Teildünnschichtsolarzelle ($I_n$, $II_n$, ..., bzw. $II_{n+1}$, $III_{n+1}$, ...) sukzessive und für die jeweiligen Teildünnschichtsolarzellen ($I_n$, $II_n$, ..., bzw. $II_{n+1}$, $III_{n+1}$, ...) gleichzeitig abgeschieden werden.

4. Verfahren nach einem der vorhergehenden Ansprüche, **dadurch gekennzeichnet, dass** nach Abscheiden der ersten, dem Substrat (S) zugewandten Rückseitenelektrode, der photoaktiven Schicht sowie der zweiten Elektrode einer jeweiligen Teildünnschichtsolarzelle ($I_n$, $II_n$, ...) in der ersten Lage (n, ...) die erste, dem Substrat (S) zugewandten Rückseitenelektroden, photoaktive Schicht und/oder zweite Elektrode der jeweiligen Teildünnschichtsolarzelle ($I_n$, $II_n$, ...) terminiert wird, insbesondere durch Abscheiden eines elektrischen Isolators (4), und anschließend eine Konversionsschicht zur elektrischen Kontaktierung der zweiten Elektrode einer

ersten Teildünnschichtsolarzelle ($I_n$, ...) mit der ersten Elektrode einer benachbarten zweiten Teildünnschichtsolarzelle ($II_n$, ...) und zur Ausbildung eines Überlappbereichs (A) abgeschieden wird.

5. Verfahren nach einem der vorhergehenden Ansprüche, **dadurch gekennzeichnet, dass** das gleichzeitig oder nacheinander erfolgende Abscheiden der zumindest einen ersten Rückseitenelektrode ($1^I$, $1^{II}$, $1^{III}$, ...), der darüber angeordneten photoaktiven Schicht ($2^I$, $2^{II}$, $2^{III}$, ...) sowie der darüber angeordneten zweiten Elektrode und/oder Konversionsschicht ($3^I$, $3^I$, $3^{III}$, ...)

    a) durch Filmgießen erfolgt, bei dem die Precursormaterialien mittels eines eine Mehrzahl an Gießschlitzen (a, b, ...) aufweisenden Gießkopfes (G') auf das Substrat (S) gegossen und/oder gepresst werden, wobei die Gießschlitze (a, b, ...) jeweils in mehrere Kompartimente (a2, a2, a3, a4, ...; b1, b2, b3, b4, b5, b6, b7, ...) unterteilt sind, durch die jeweils die Precursormaterialien der jeweiligen Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$, ...) der einzelnen Dünnschichtsolarzellen (I, II, III, ...) gegossen und/oder gepresst werden, wobei die Kompartimente (a2, a2, a3, a4, ...; b1, b2, b3, b4, b5, b6, b7, ...) so zueinander angeordnet sind, dass die Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$, ...) einer jeweiligen einzelnen Dünnschichtsolarzelle (I, II, III, ...) zumindest bereichsweise übereinanderliegend gegossen werden und für jeweils ein Paar (I-II, II-III, ...) aus erster (I, II, ...) und zweiter Dünnschichtsolarzelle (II, III, ...) die jeweilige Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$, ...) versetzt zueinander gegossen werden, so dass ein Überlappbereich (B) und ein Übergangsbereich (A) entsteht, und/oder

    b) durch Filmgießen erfolgt, bei dem die Precursormaterialien mittels eines eine Mehrzahl an Gießschlitzen

$$( X_1^I,\ X_2^I,\ X_3^I,\ X_1^{II},\ X_2^{II},\ X_3^{II},\ X_1^{III},$$
$$X_2^{III},\ X_3^{III},\ ...)$$ aufweisenden Gießkopfes (G) auf das Substrat (S) gegossen und/oder gepresst werden, wobei die Gießschlitze
$$( X_1^I,\ X_2^I,$$
$$X_3^I,\ X_1^{II},\ X_2^{II},\ X_3^{II},\ X_1^{III},\ X_2^{III},\ X_3^{III},\ ...)$$ jeweils einer Rückseitenelektrode

$$( 1^I,\ 1^{II},\ 1^{III},\ ...),$$ einer photoaktiven Schicht ($2^I$, $2^{II}$, $2^{III}$, ...) sowie einer zweiten Elektrode und/oder Konversionsschicht ($3^I$, $3''$, $3^{III}$, ...) einer jeweiligen Dünnschichtsolarzelle (I, II, III, ...) zugeordnet, durchgängig über die gesamte Breite der jeweiligen Rückseitenelektrode ($1^I$, $1^{II}$, $1^{III}$, ...), der photoaktiven Schicht ($2^I$, $2^{II}$, $2^{III}$, ...) sowie der zweiten Elektrode und/oder Konversionsschicht ($3^I$, $3^{II}$, $3^{III}$, ...) der jeweiligen Dünnschichtsolarzelle (I, II, III, ...) ausgebildet und so im Gießkopf (G) angeordnet sind, dass die Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$, ...) einer jeweiligen einzelnen Dünnschichtsolarzelle (I, II, III, ...) zumindest bereichsweise übereinanderliegend gegossen werden und für jeweils ein Paar (I-II, II-III, ...) aus erster (I, II, ...) und zweiter Dünnschichtsolarzelle (II, III, ...) die jeweilige Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3''$, $3^{III}$, ...) versetzt zueinander gegossen werden, so dass ein Überlappbereich (B) und ein Übergangsbereich (A) entsteht, und/oder

    c) durch Tintenstrahl- und/oder Aerosoldruck auf das Substrat (S) erfolgt, wobei die Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$, ...) einer jeweiligen einzelnen Dünnschichtsolarzelle (I, II, III, ...) zumindest bereichsweise übereinanderliegend gedruckt werden und für jeweils ein Paar (I-II, II-III, ...) aus erster (I, II, ...) und zweiter Dünnschichtsolarzelle (II, III, ...) die jeweilige Rückseitenelektrode ($1^I$, $1^{II}$, $1^{III}$, ...), die photoaktive Schicht ($2^I$, $2^{II}$, $2^{III}$, ...) sowie die zweite Elektrode und/oder Konversionsschicht ($3^I$, $3^{II}$, $3^{III}$, ...) versetzt zueinander gedruckt werden, so dass ein Überlappbereich (B) und ein Übergangsbereich (A) entsteht.

6. Verfahren nach einem der vorhergehenden Ansprüche, **dadurch gekennzeichnet, dass** auf dem Substrat (S) eine Mehrzahl von Dünnschichtsolarzellen, die jeweils zumindest eine erste, dem Substrat (S) zugewandte Rückseitenelektrode, eine zweite Elektrode und/oder eine Konversionsschicht sowie eine zwischen der Rückseitenelektrode und der zweiten Elektrode und/oder der Konversionsschicht angeordnete photoaktive Schicht umfassen, sukzessive teilweise überlappend abgeschieden werden.

7. Verfahren nach einem der vorhergehenden Ansprüche, **dadurch gekennzeichnet,**

**dass** die abgeschiedenen Teildünnschichtsolarzellen bzw. die Dünnschichtsolarzellen vor dem Auflaminieren auf einem temporären Träger (T), der bevorzugt eine Kunststofffolie ist, befestigt sind, der nach dem Abscheiden entfernt wird und/oder
**dass** die Teildünnschichtsolarzellen bzw. die Dünnschichtsolarzellen über eine isolierende Klebeschicht (K) oder leitfähige Klebeschicht (K') abgeschieden werden.

8. Verfahren nach einem der vorhergehenden Ansprüche, **dadurch gekennzeichnet, dass** mehrere Paare (I-II, II-III, ...) aus erster (I, II, ...) und zweiter Dünnschichtsolarzelle (II, III, ...) iterativ angeordnet werden, wobei mehrere Übergangsbereiche ($B^{I-II}$, $B^{II-III}$, ...) mit paarweise verbundenen Dünnschichtsolarzellen (I-II, II-III, ...) sowie mehrere Übergangsbereiche ($A^I$, $A^{II}$, ...) der jeweils zweiten Dünnschichtsolarzelle (II, III, ...) der mehreren Paare (I-II, II-III, ...) aus erster (I, II, ...) und zweiter Dünnschichtsolarzelle (II, III, ...) ausgebildet werden.

9. Verfahren nach einem der vorhergehenden Ansprüche, **dadurch gekennzeichnet, dass** die Mehrzahl von Dünnschichtsolarzellen (I, II, III, ...)

    a) in zwei Lagen (n, n+1) angeordnet werden, wobei jeweils die zweite Dünnschichtsolarzelle (II, III, ...) eines Paares aus jeweils erster und jeweils zweiter Dünnschichtsolarzelle (I-II, II-III, ...) einen Übergangsbereich ($A^I$, $A^{II}$, ...) aufweist, in dem die in der zweiten Lage (n+1) ausgebildete Rückseitenelektrode $(1^{II}_{n+1}, 1^{III}_{n+1}, ...)$, die photoaktive Schicht $(2^{II}_{n+1}, 2^{III}_{n+1}, ...)$ und die zweite Elektrode und/oder die Konversionsschicht $(3^{II}_{n+1}, 3^{III}_{n+1} ...)$ der jeweils zweiten Dünnschichtsolarzelle (II, III, ...) in jeweils eine, in der ersten Lage (n, ...) ausgebildete Rückseitenelektrode $(1^{II}_n, 1^{III}_n, ...)$, eine photoaktive Schicht $(2^{II}_n, 2^{III}_n, ...)$ und eine zweite Elektrode und/oder eine Konversionsschicht $(3^{II}_n, 3^{III}_n ...)$ überführt wird,
    b) in drei Lagen (n, n+1, n+2) angeordnet werden, wobei jeweils die zweite Dünnschichtsolarzelle (II, III, ...) eines Paares aus jeweils erster und jeweils zweiter Dünnschichtsolarzelle (I-II, II-III, ...) zwei stufenweise angeordnete Übergangsbereiche aufweist, wobei im ersten Übergangsbereich die in der dritten Lage (n+2) ausgebildete Rückseitenelektrode, die photoaktive Schicht und die zweite Elektrode und/oder die Konversionsschicht der jeweils zweiten Dünnschichtsolarzelle (II, III, ...) in jeweils eine, in der zweiten Lage (n+1) und im zweiten Übergangsbereich in eine in der ersten Lage (n) ausgebildete Rückseitenelektrode, eine photoaktive Schicht und eine zweite Elektrode und/oder eine Konversionsschicht überführt wird, oder
    c) in vier Lagen (n, n+1, n+2, n+3) angeordnet werden, wobei jeweils die zweite Dünnschichtsolarzelle (II, III, ...) eines Paares aus jeweils erster und jeweils zweiter Dünnschichtsolarzelle (I-II, II-III, ...) drei stufenweise angeordnete Übergangsbereiche aufweist, wobei im ersten Übergangsbereich die in der vierten Lage (n+3) ausgebildete Rückseitenelektrode, die photoaktive Schicht und die zweite Elektrode und/oder die Konversionsschicht der jeweils zweiten Dünnschichtsolarzelle (II, III, ...) in jeweils eine, in der dritten Lage (n+2), im zweiten Übergangsbereich in eine in der zweiten Lage (n+1) und im dritten Übergangsbereich in eine in der ersten Lage (n) ausgebildete Rückseitenelektrode, eine photoaktive Schicht und eine zweite Elektrode und/oder eine Konversionsschicht überführt wird.

10. Verfahren nach einem der vorhergehenden Ansprüche, **dadurch gekennzeichnet, dass** die Breite eines jeden Überlappbereichs (B) eines jeden Paares aus jeweils erster und jeweils zweiter Dünnschichtsolarzelle (I-II, II-III, ...) zwischen dem 0,01 und 0,99-fachen, bevorzugt zwischen dem 0,01 und dem 0,1-fachen, dem 0,4- bis 0,6-fachen oder dem 0,9 bis 0,99-fachen der Länge der jeweils zweiten Dünnschichtsolarzelle (II, III, ...) beträgt.

11. Verfahren nach einem der vorhergehenden Ansprüche, **dadurch gekennzeichnet, dass** die Verbindung des Bereichs der jeweils ersten Dünnschichtsolarzelle (I, II, ...) und des Bereichs der jeweils zweiten Dünnschichtsolarzelle (II, III, ...) im mindestens einen Überlappbereich (B)

    a) durch direkten Verbund der zweiten Elektrode und/oder der Konversionsschicht $(3^I_n, 3^{II}_n, ...)$ der jeweils ersten Dünnschichtsolarzelle (I, II, ...) mit einer Rückseitenelektrode $(1^{II}_{n+1}, 1^{III}_{n+1}, ...)$ der jeweils zweiten Dünnschichtsolarzelle (II, III, ...) des Paares aus jeweils erster und jeweils zweiter Dünnschichtsolarzelle (I-II, II-III, ...) realisiert wird,
    b) durch einen elektrisch leitenden Verbund der zweiten Elektrode und/oder der Konversionsschicht $(3^I_n, 3^{II}_n, ...)$ der jeweils ersten Dünnschichtsolarzelle (I, II, ...) mit einer Rückseitenelektrode $(1^{II}_{n+1}, 1^{III}_{n+1}, ...)$ der jeweils zweiten

Dünnschichtsolarzelle (II, III, ...) des Paares aus jeweils erster und jeweils zweiter Dünnschichtsolarzelle (I-II, II-III, ...) mittels einer elektrisch leitenden Klebeschicht (K') realisiert wird, oder

c) durch einen elektrisch isolierenden Verbund der zweiten Elektrode und/oder der Konversionsschicht $\left(3_n^I, 3_n^{II}, ...\right)$ der jeweils ersten Dünnschichtsolarzelle (I, II, ...) mit einer Rückseitenelektrode $\left(1_{n+1}^{II}, 1_{n+1}^{III}, ...\right)$ der jeweils zweiten Dünnschichtsolarzelle (II, III, ...) des Paares aus jeweils erster und jeweils zweiter Dünnschichtsolarzelle (I-II, II-III, ...) mittels einer elektrisch isolierenden Klebeschicht (K) realisiert ist, wobei die elektrische Kontaktierung der zweiten Elektrode und/oder der Konversionsschicht $\left(3_n^I, 3_n^{II}, ...\right)$ der jeweils ersten Dünnschichtsolarzelle (I, II, ...) mit der Rückseitenelektrode $\left(1_{n+1}^{II}, 1_{n+1}^{III}, ...\right)$ der jeweils zweiten Dünnschichtsolarzelle (II, III, ...) durch eine elektrisch leitende Verbindung (7) realisiert wird.

12. Verfahren nach einem der vorhergehenden Ansprüche, **dadurch gekennzeichnet, dass** im Übergangsbereich (A)

a) die jeweils erste Dünnschichtsolarzelle (I, II, ...) des Paares aus jeweils erster und jeweils zweiter Dünnschichtsolarzelle (I-II, II-III, ...) mit der jeweils zweiten Dünnschichtsolarzelle (II, III, ...) monolithisch verschaltet wird, oder

b) die Rückseitenelektrode (1$^I$, 1$^{II}$, ...), die photoaktive Schicht (2$^I$, 2$^{II}$, ...) und die zweite Elektrode und/oder die Konversionsschicht (3$^I$, 3$^{II}$, ...) der jeweils ersten Dünnschichtsolarzelle (I, II, ...) des Paares aus jeweils erster und jeweils zweiter Dünnschichtsolarzelle (I-II, II-III, ...) terminiert und elektrisch von der zweiten Dünnschichtsolarzelle (II, III, ...) isoliert sind, wobei die Terminierung bevorzugt durch einen elektrischen Isolator (4) realisiert wird.

13. Verfahren nach einem der vorhergehenden Ansprüche, **dadurch gekennzeichnet, dass** im Übergangsbereich (A) die Rückseitenelektrode (1$^{II}$, 1$^{III}$, ...), die photoaktive Schicht (2$^{II}$, 2$^{III}$, ...) und die zweite Elektrode und/oder die Konversionsschicht (3$^{II}$, 3$^{III}$, ...) der jeweils zweiten Dünnschichtsolarzelle (II, III, ...) des Paares aus jeweils erster und jeweils zweiter Dünnschichtsolarzelle (I-II, II-III, ...) zumindest bereichsweise senkrecht zum Substrat (S), S-förmig oder geradlinig in die erste Lage (n, ...) überführt wird und/oder im mindestens einen Überlappbereich (B) jeweils die in der untersten Lage (n) ausgebildete Rückseitenelektrode $\left(1^I, 1_n^I, 1_n^{II}, 1_n^{III}, ...\right)$ der Dünnschichtsolarzellen (I, II, III, ...) vollflächig mit dem Substrat (S) verbunden wird, wobei bevorzugt der Verbund durch direktes Abscheiden der Rückseitenelektrode $\left(1^I, 1_n^I, 1_n^{II}, 1_n^{III}, ...\right)$ auf dem Substrat (S), durch eine elektrisch leitfähige Klebeschicht (K') oder eine elektrisch isolierende Klebeschicht (K) realisiert wird.

14. Verfahren nach einem der vorhergehenden Ansprüche, **dadurch gekennzeichnet, dass** jeweils unabhängig voneinander die Schichtdicken der Rückseitenelektrode (1$^I$, 1$^{II}$, 1$^{III}$, ...) zwischen 1nm und 5$\mu$m, bevorzugt zwischen 5nm und 1 $\mu$m, besonders bevorzugt zwischen 10nm und 200nm, der zweiten Elektrode und/oder der Konversionsschicht (3$^I$, 3$^{II}$, 3$^{III}$, ...) zwischen 1nm und 5$\mu$m, bevorzugt zwischen 5nm und 1 $\mu$m, besonders bevorzugt zwischen 10nm und 200nm, und/oder der photoaktiven Schicht (2$^I$, 2$^{II}$, 2$^{III}$, ...) zwischen 1nm und 5$\mu$m, bevorzugt zwischen 5nm und 1 $\mu$m, besonders bevorzugt zwischen 10nm und 200nm betragen.

15. Verfahren nach einem der vorhergehenden Ansprüche, **dadurch gekennzeichnet, dass** die Precursor-Materialien bzw. Beschichtungsmassen/-medien für die Herstellung der

a) Rückseitenelektrode und/oder Konversionsschicht (1$^I$, 1$^{II}$, 1$^{III}$, ...) und/oder die zweite Elektrode und/oder Konversionsschicht (3$^I$, 3$^{II}$, 3$^{III}$ ...) Lösungen, Emulsionen oder Suspensionen von Poly(ethylendioxythiophen):Poly(Styrolsulfonsäure) in Wasser und Lösemitteln wie Isopropanol, Ethanol und anderen, ZnO Nanopartikel in Chloroform oder Aceton aus Zinkacetat-Dihydrat, ZnO Nanopartikel in Chloroform aus Diethylzink, Zincacetylacetonat-Hydrat in Ethanol, Titan-isopropoxid in Alkohol (Methanol, isopropanol, ethanol), TiO$_x$ NPs aus Titan(IV) isopropoxid in Isopropanol, MoO$_3$ NPs aus Ammonium-molybdat in wässriger Lösung, Molybden-(V)-isopropoxid in Butanol, Molybdentricarbonyl-trispropionitril in Acetonitril, Bis(2,4-pentandionato)-molybdendioxid in Isopropanol, V$_2$O$_5$ NPs in Isopropanol, Vanadium(V)-oxiisopropoxid in Isopropanol, Aluminium dotiertes Zinkoxid aus Zinkacetat und Aluminiumhydroxit-Acetat in Ethanol und Monoethanolamin, und/oder

b) die photoaktive Schicht (2$^I$, 2$^{II}$, 2$^{III}$, ...) Lösungen, Suspensionen, Emulsionen von anorganischen Halbleitern, wie beispielsweise Si, a-Si:H, CuZnSnS, CuZnSnSe, GaAs, CuInS, CuInSe, CuInGeS, CuInGeSe, Ge, CdTe, Metalloxide wie TiO$_2$, ZnO, oder organischen Halbleitern wie beispielsweise Poly-(3-hexylthiophen), Metall-Phtalocyaninen, Dicyanovinyl (DCV)-substituierte Quaterthiophenen, Fullerenderivaten und Nanopartikeln der verschiedenen Materialien sowie Kombinationen hiervon und/oder halbleitenden Polymeren und Fullerenderivaten und/oder anorgnischen Metall- oder Halbleiter-Nanopartikeln (Au, Ag, Al, $Al_2O_3$, ZnO, $TiO_2$, $MoO_3$, $V_2O_5$, CdS, CdSe, PbS, PbSe, CuInS, CuInSe, CuInGeS, CuInGeSe, CuZnSnS, CuZnSnSe) und/oder hybriden Halbleitern wie Perovskiten, beispielsweise $CH_3NH_3PbI_3$ oder Precursoren von organischen und anorganischen Halbleitern in Lösungsmitteln wie Chlorbenzol, Dichlorbenzol, Xylol, Toluol, Alkoholen, Wasser und Mischungen hiervon sind.

## Claims

1. Method for the production of a thin-film solar cell array, comprising a plurality of thin-film solar cells (I, II, III, ...) applied on a substrate (S), which comprise respectively at least one first rear-side electrode ($1^I$, $1^{II}$, $1^{III}$, ...), which is orientated towards the substrate (S), and a second electrode and/or a conversion layer ($3^I$, $3^{II}$, $3^{III}$, ...) and also a photoactive layer ($2^I$, $2^{II}$, $2^{III}$, ...) disposed between the rear-side electrode ($1^I$, $1^{II}$, $1^{III}$, ...) and the second electrode and/or the conversion layer ($3^I$, $3^{II}$, $3^{III}$, ...), the thin-film solar cell array

    a) having at least one overlapping region (B) in which respectively one first (I, II, ...) and one second thin-film solar cell (II, III, ...) are disposed in two layers (n, n+1, ...) and in pairs (I-II, II-III, ... ) situated one above the other, one region of the respectively first thin-film solar cell (I, II, ...) in a first layer (n, ...) and one region of the respectively second thin-film solar cell (II, III, ...), which is disposed on the side of the respectively first thin-film solar cell (I, II, ...) orientated away from the substrate (S) in a layer (n+1, ...) situated above the respectively first thin-film solar cell (I, II, ...), being connected to each other and connected electrically in series, and
    b) having at least one transition region (A) in which respectively only the respectively second thin-film solar cell (II, III, ...) of the pair of respectively first and respectively second thin-film solar cell (I-II, II-III, ...) is configured, configured in the layer (n+1, ...) situated above the first layer, the rear-side electrode ($1^{II}_{n+1}$, $1^{III}_{n+1}$, ...), the photoactive layer ($2^{II}_{n+1}$, $2^{III}_{n+1}$, ...) and the second electrode and/or the conversion layer ($3^{II}_{n+1}$, $3^{III}_{n+1}$, ...) of the respectively second thin-film solar cell (II, III, ...) being converted, configured in the first layer (n, ...), into respectively one rear-side electrode ($1^{II}_n$, $1^{III}_n$, ...), a photoactive layer ($2^{II}_n$, $2^{III}_n$, ...) and a second electrode and/or a conversion layer ($3^{II}_n$, $3^{III}_n$, ...),

in which there are produced on a substrate (S), simultaneously or successively, a plurality of thin-film solar cells (I, II, III, ...) by means of respective simultaneous or successive deposition of at least one first rear-side electrode ($1^I$, $1^{II}$, $1^{III}$, ...), which is orientated towards the substrate (S), and one photoactive layer ($2^I$, $2^{II}$, $2^{III}$, ...) disposed above and also one second electrode and/or one conversion layer ($3^I$, $3^{II}$, $3^{III}$, ...) disposed above on the substrate (S), at least two thin-film solar cells (I, II, III, ...) being produced in at least one overlapping region (B) in pairs (I-II, II-III, ...) in at least two layers (n, n+1, ...) situated one above the other, by the respectively second thin-film solar cell (II, III, ...) of each pair (I-II, II-III, ...) of first (I, II, ...) and second thin-film solar cell (II, III, ...) being deposited in regions in a layer (n+1, n+2, ...) situated above the respectively first thin-film solar cell, and the respectively first (I, II, ...) and second thin-film solar cell (II, III, ...) in this region (B) being connected electrically in series, and the respectively second thin-film solar cell (II, III, ...) of each pair (I-II, II-III) of first (I, II, ...) and second thin-film solar cell (II, III, ...) being deposited offset relative to the respectively first thin-film solar cell (I, II, ...) of each pair (I-II, II-III, ...) of first (I, II, ...) and second thin-film solar cell (II, III, ...) so that a transition region (A) is configured, in which the rear-side electrode ($1^{II}$, $1^{III}$, ...), the photoactive layer ($2^{II}$, $2^{III}$, ...) disposed above and also the second electrode and/or the conversion layer ($3^{II}$, $3^{III}$, ...) disposed above, of the respectively second thin-film solar cell of each pair (I-II, II-III, ...) of first (I, II, ...) and second thin-film solar cell (II, III, ...) being converted from the layer (n+1, n+2, ...) situated above the respectively first thin-film solar cell onto a layer (n, n+1) situated below.

2. Method according to claim 1, **characterised in that** the deposition and/or premanufacture of the thin-film solar cells, partial thin-film solar cells and/or of the first rear-side electrodes orientated towards the substrate (S), of the second electrodes and/or conversion layers and also of the photoactive layer of the thin-film solar cells and/or partial thin-film solar cells is effected from the liquid phase or the vapour phase, in particular by means of aerosol printing, vacuum deposition, inkjet printing, film casting and/or adhesion processes.

3. Method according to one of the preceding claims, **characterised in that**, in a first layer (n, ...), at least two partial thin-film solar cells ($I_n$, $II_n$, ...), which comprise respectively at least one first rear-side electrode, which is orientated towards the substrate (S), and a second electrode and/or a conversion layer and also a photoactive layer disposed between the rear-side electrode and the second electrode and/or the conversion layer, are premanufactured and at least one further partial thin-film solar cell ($II_{n+1}$, $III_{n+1}$, ...), which comprises respectively at least one first rear-side electrode, which is orientated towards the substrate (S), and a second electrode and/or a conversion layer and also a photoactive layer disposed between the rear-side electrode and the second electrode and/or the conversion layer, are deposited in a second layer (n+1) offset on the at least two partial thin-film solar cells ($I_n$, $II_n$, ...) disposed in the first layer (n, ...), at least one overlapping region (B) being configured between at least one partial thin-film solar cell ($I_n$) disposed in the first layer (n, ...) and one partial thin-film solar cell ($II_{n+1}$) deposited in a second layer (n+1, ...) and also at least one transition region (A) by contracting the rear-side electrode, the photoactive layer and also the second electrode and/or the conversion layer of the partial thin-film solar cell ($II_{n+1}$) deposited in the second layer (n+1, ...) with the rear-side electrode, the photoactive layer and also the second electrode and/or the conversion layer of the partial thin-film solar cell ($II_n$) disposed in the first layer (n, ...), wherein preferably during premanufacture or deposition of the at least two partial thin-film solar cells ($I_n$, $II_n$, ...) and/or of the at least one further partial thin-film solar cell ($II_{n+1}$, $III_{n+1}$, ...), the at least one first rear-side electrode, which is orientated towards the substrate (S), and the second electrode and/or the conversion layer and also the photoactive layer, disposed between the rear-side electrode and the second electrode and/or the conversion layer, for each partial thin-film solar cell ($I_n$, $II_n$, ... or $II_{n+1}$, $III_{n+1}$, ...) are deposited successively and, for the respective partial thin-film solar cells (In, $II_n$, ... or $II_{n+1}$, $III_{n+1}$, ...), simultaneously.

4. Method according to one of the preceding claims, **characterised in that**, after deposition of the first rear-side electrode, which is orientated towards the substrate (S), of the photoactive layer and also of the second electrode of a respective partial thin-film solar cell ($I_n$, $II_n$, ...) in the first layer (n, ...), the first rear-side electrode, which is orientated towards the substrate (S), and the photoactive layer and/or the second electrode of the respective partial thin-film solar cell ($I_n$, $II_n$, ...) is terminated, in particular by deposition of an electrical insulator (4), and subsequently a conversion layer is deposited for electrical contacting of the second electrode of a first partial thin-film solar cell ($I_n$, ...) with the first electrode of an adjacent second partial thin-film solar cell ($II_n$, ...) and for formation of an overlapping region (A).

5. Method according to one of the preceding claims, **characterised in that** the deposition, effected simultaneously or successively, of the at least one first rear-side electrode ($1^I$, $1^{II}$, $1^{III}$, ...), of the photoactive layer ($2^I$, $2^{II}$, $2^{III}$, ...) disposed above and also of the second electrode and/or conversion layer ($3^I$, $3^{II}$, $3^{III}$, ...) disposed above is effected

a) by film casting in which the precursor materials are cast and/or pressed by means of a casting head (G') which has a plurality of casting slots (a, b, ...) onto the substrate (S), the casting slots (a, b, ...) respectively being subdivided into a plurality of compartments (a2, a2, a3, a4, ...; b1, b2, b3, b4, b5, b6, b7, ...), through which respectively the precursor materials of the respective rear-side electrode ($1^I$, $1^{II}$, $1^{III}$, ...), the photoactive layer ($2^I$, $2^{II}$, $2^{III}$, ...) and also the second electrode and/or conversion layer ($3^I$, $3^{II}$, $3^{III}$, ...) of the individual thin-film solar cells (I, II, III, ...) are cast and/or pressed, the compartments (a2, a2, a3, a4, ...; b1, b2, b3, b4, b5, b6, b7, ...) being disposed relative to each other such that the rear-side electrode ($1^I$, $1^{II}$, $1^{III}$, ...), the photoactive layer ($2^I$, $2^{II}$, $2^{III}$, ...) and also the second electrode and/or conversion layer ($3^I$, $3^{II}$, $3^{III}$, ...) of a respective individual thin-film solar cell (I, II, III...) being cast situated one above the other at least in regions and, for respectively one pair (I-II, II-III, ...) of first (I, II, ...) and second thin-film solar cell (II, III, ...), the respective rear-side electrode ($1^I$, $1^{II}$, $1^{III}$, ...), the photoactive layer ($2^I$, $2^{II}$, $2^{III}$, ...) and also the second electrode and/or conversion layer ($3^I$, $3^{II}$, $3^{III}$, ...) being cast offset relative to each other so that an overlapping region (B) and a transition region (A) are produced, and/or

b) by film casting, in which the precursor materials are cast and/or pressed onto the substrate (S) by means of a casting head (G) which has a plurality of casting slots ($X^I_1$, $X^I_2$, $X^I_3$, $X^{II}_1$, $X^{II}_2$, $X^{II}_3$, $X^{III}_1$, $X^{III}_2$, $X^{III}_3$, ...), the casting slots ($X^I_1$, $X^I_2$, $X^I_3$, $X^{II}_1$, $X^{II}_2$, $X^{II}_3$, $X^{III}_1$, $X^{III}_2$, $X^{III}_3$, ...) respectively of one rear-side electrode ($1^I$, $1^{II}$, $1^{III}$, ...), of a photoactive layer ($2^I$, $2^{II}$, $2^{III}$, ...) and also of a second electrode and/or conversion layer ($3^I$, $3^{II}$, $3^{III}$, ...) being assigned to a respective thin-film solar cell (I, II, III, ...), being configured continuously over the entire width of the respective rear-side electrode ($1^I$, $1^{II}$, $1^{III}$, ...), of the photoactive layer ($2^I$, $2^{II}$, $2^{III}$, ...) and also of the second electrode and/or conversion layer ($3^I$, $3^{II}$, $3^{III}$, ...) of the respective thin-film solar cell (I, II, III, ...) and being disposed such in the casting head (G) that the rear-side electrode ($1^I$, $1^{II}$, $1^{III}$, ...), the photoactive layer ($2^I$, $2^{II}$, $2^{III}$, ...) and also the second electrode and/or conversion layer ($3^I$, $3^{II}$, $3^{III}$, ...) of a respective individual thin-film solar cell (I, II, III, ...) are cast one above the other at least in regions and, for respectively one pair (I-II, II-III, ...) of first (I, II, ...) and second thin-film solar cell (II, III, ...), the respective rear-side electrode ($1^I$, $1^{II}$, $1^{III}$, ...), the photoactive layer ($2^I$, $2^{II}$, $2^{III}$, ...) and also the second electrode and/or conversion layer ($3^I$, $3^{II}$, $3^{III}$, ...) being cast offset relative to each other so that an overlapping region (B) and a transition region (A) are produced, and/or

c) by inkjet- and/or aerosol printing on the substrate (S), the rear-side electrode ($1^I$, $1^{II}$, $1^{III}$, ...), the photoactive layer ($2^I$, $2^{II}$, $2^{III}$, ...) and also the second electrode and/or conversion layer ($3^I$, $3^{II}$, $3^{III}$, ...) of one respective individual thin-film solar cell (I, II, III, ...) being printed situated one above the other at least in regions and, for respectively one pair (I-II, II-III, ...) of first (I, II, ...) and second thin-film solar cell (II, III, ...), the respective rear-side electrode ($1^I$, $1^{II}$, $1^{III}$, ...), the photoactive layer ($2^I$, $2^{II}$, $2^{III}$, ...) and also the second electrode and/or conversion layer ($3^I$, $3^{II}$, $3^{III}$, ...) being printed offset relative to each so that an overlapping region (B) and a transition region (A) are produced.

6. Method according to one of the preceding claims, **characterised in that**, on the substrate (S), a plurality of thin-film solar cells, which comprise respectively at least one first rear-side electrode, which is orientated towards the substrate (S), and a second electrode and/or a conversion layer and also a photoactive layer disposed between the rear-side electrode and the second electrode and/or the conversion layer, are deposited in succession partially overlapping.

7. Method according to one of the preceding claims, **characterised in that** the deposited partial thin-film solar cells or the thin-film solar cells are mounted on a temporary carrier (T) which is preferably a plastic material film before the lamination and is removed after the deposition, and/or the partial thin-film solar cells or the thin-film solar cells are deposited over an insulating adhesive layer (K) or conductive adhesive layer (K').

8. Method according to one of the preceding claims, **characterised in that** a plurality of pairs (I-II, II-III ...) of first (I, II, ...) and second thin-film solar cell (II, III, ...) is disposed iteratively, a plurality of transition regions ($B^{I-II}$, $B^{II-III}$, ...) being configured with thin-film solar cells (I-II, II-III, ...), connected in pairs, and also a plurality of transition regions ($A^I$, $A^{II}$, ...) of the respectively second thin-film solar cell (II, III, ...) of the plurality of pairs (I-II, II-III, ...) of first (I, II, ...) and second thin-film solar cell (II, III, ...).

9. Method according to one of the preceding claims, **characterised in that** the plurality of thin-film solar cells (I, II, III, ...)

a) is disposed in two layers (n, n+1), respectively the second thin-film solar cell (II, III, ...) of a pair of respectively first and respectively second thin-film solar cell (I-II, II-III, ...) having a transition region ($A^I$, $A^{II}$, ...) in which, configured in the second layer (n +1), the rear-side electrode ($1^{II}_{n+1}$, $1^{III}_{n+1}$, ...), the photoactive layer ($2^{II}_{n+1}$, $2^{III}_{n+1}$, ...) and the second electrode and/or the conversion layer ($3^{II}_{n+1}$, $3^{III}_{n+1}$, ...) of the respectively second thin-film solar cell (II, III, ...) is converted, configured in the first layer (n, ...), into respectively a rear-side electrode ($1^{II}_n$, $1^{III}_n$, ...), a photoactive layer ($2^{II}_n$, $2^{III}_n$, ...) and a second electrode and/or a conversion layer ($3^{II}_n$, $3^{III}_n$, ...), or

b) is disposed in three layers (n, n+1, n+2), respectively the second thin-film solar cell (II, III, ...) of a pair of respectively first and respectively second thin-film solar cell (I-II, II-III, ...) having two transition regions disposed in steps, configured in the third layer (n+2), the rear-side electrode, the photoactive layer and the second electrode and/or the conversion layer of the respectively second thin-film solar cell (II, III, ...), in the first transition region, being converted, configured in the second layer (n+1), into respectively a rear-side electrode, a photoactive layer and a second electrode and/or a conversion layer and, in the second transition region, into one thereof configured in the first layer (n), or

c) is disposed in four layers (n, n+1, n+2, n+3), respectively the second thin-film solar cell (II, III, ...) of a pair of respectively first and respectively second thin-film solar cell (I-II, II-III, ...) having three transition regions disposed in steps, configured in the fourth layer (n+3), the rear-side electrode, the photoactive layer and the second electrode and/or the conversion layer of the respectively second thin-film solar cell (II, III, ...), in the first transition region, being converted, configured in the third layer (n+2), into respectively a rear-side electrode, a photoactive layer and a second electrode and/or a conversion layer, in the second transition region, into one thereof configured in the second layer (n+1) and, in the third transition region, into one thereof configured in the first layer (n).

10. Method according to one of the preceding claims, **characterised in that** the width of each overlapping region (B) of each pair of respectively first and respectively second thin-film solar cell (I-II, II-III, ...) is between 0.01 and 0.99 times, preferably between 0.01 and 0.1 times, 0.4 to 0.6 times or 0.9 to 0.99 times the length of the respective second thin-film solar cell (II, III, ...).

**11.** Method according to one of the preceding claims, **characterised in that** the connection of the region of the respectively first thin-film solar cell (I, II, ...) and of the region of the respectively second thin-film solar cell (II, III, ...) is produced in the at least one overlapping region (B)

a) by direct connection of the second electrode and/or of the conversion layer ($3^I_n$, $3^{II}n$, ...) of the respectively first thin-film solar cell (I, II ...) to a rear-side electrode ($1^{II}_{n+1}$, $1^{III}_{n+1}$, ...) of the respectively second thin-film solar cell (II, III, ...) of the pair of respectively first and respectively second thin-film solar cell (I-II, II-III),
b) by an electrically conducting bond of the second electrode and/or of the conversion layer ($3^I_n$, $3^{II}n$, ...) of the respectively first thin-film solar cell (I, II, ...) to a rear-side electrode ($1^{II}_{n+1}$, $1^{III}_{n+1}$, ...) of the respectively second thin-film solar cell (II, III, ...) of the pair of respectively first and respectively second thin-film solar cell (I-II, II-III, ...) by means of an electrically conductive adhesive layer (K'), or
c) by an electrically insulating bond of the second electrode and/or of the conversion layer ($3^I_n$, $3^{II}_n$, ...) of the respectively first thin-film solar cell (I, II, ...) to a rear-side electrode ($1^{II}_{n+1}$, $1^{III}_{n+1}$, ...) of the respectively second thin-film solar cell (II, III, ...) of the pair of respectively first and respectively second thin-film solar cell (I-II, II-III, ...) by means of an electrically insulating adhesive layer (K), the electrical contracting of the second electrode and/or of the conversion layer ($3^I_n$, $3^{II}_n$, ...) of the respectively first thin-film solar cell (I, II, ...) to the rear-side electrode ($1^{II}_{n+1}$, $1^{III}_{n+1}$, ...) of the respectively second thin-film solar cell (II, III, ...) being produced by an electrically conducting connection (7).

**12.** Method according to one of the preceding claims, **characterised in that**, in the transition region (A),

a) the respectively first thin-film, solar cell (I, II, ...) of the pair of respectively first and respectively second thin-film solar cell (I-II, II-III, ...) is connected monolithically to the respectively second thin-film solar cell (II, III, ...), or
b) the rear-side electrode ($1^I$, $1^{II}$, ...), the photoactive layer ($2^I$, $2^{II}$, ...) and the second electrode and/or the conversion layer ($3^I$, $3^{II}$, ...) of the respectively first thin-film solar cell (I, II, ...) of the pair of respectively first and respectively second thin-film solar cell (I-II, II-III, ...) are terminated and insulated electrically from the second thin-film solar cell (II, III, ...), the termination being achieved preferably by an electrical insulator (4).

**13.** Method according to one of the preceding claims, **characterised in that**,
in the transition region (A), the rear-side electrode ($1^{II}$, $1^{III}$, ...), the photoactive layer ($2^{II}$, $2^{III}$, ...) and the second electrode and/or the conversion layer ($3^{II}$, $3^{III}$, ...) of the respectively second thin-film solar cell (II, III, ...) of the pair of respectively first and respectively second thin-film solar cell (I-II, II-III, ...) are converted in an S-shape or linearly into the first layer (n, ...) at least in regions perpendicularly to the substrate (S), and/or
in the at least one overlapping region (B), respectively the rear-side electrode ($1^I$, $1^I_n$, $1^{II}_n$, $1^{III}n$, ...), configured in the lowermost layer (n), of the thin-film solar cells (I, II, III...) is connected to the substrate (S) over the entire surface, wherein preferably the composite is produced by direct deposition of the rear-side electrode ($1^I$, $1^I_n$, $1^{II}_n$, $1^{III}_n$, ...) on the substrate (S) by an electrically conductive adhesive layer (K') or an electrically insulating adhesive layer (K).

**14.** Method according to one of the preceding claims, **characterised in that** the layer thicknesses, respectively independently of each other,
of the rear-side electrode ($1^I$, $1^{II}$, $1^{III}$, ...) are between 1 nm and 5 $\mu$m, preferably between 5 nm and 1 $\mu$m, particularly preferred between 10 nm and 200 nm,
of the second electrode and/or of the conversion layer ($3^1$, $3^{II}$, $3^{III}$, ...) are between 1 nm and 5 $\mu$m, preferably between 5 nm and 1 $\mu$m, particularly preferred between 10 nm and 200 nm and/or
of the photoactive layer ($2^I$, $2^{II}$, $2^{III}$, ...) are between 1 nm and 5 $\mu$m, preferably between 5 nm and 1 $\mu$m, particularly preferred between 10 nm and 200 nm.

**15.** Method according to one of the preceding claims, **characterised in that** the precursor materials or coating materials/media are, for the production of the

a) rear-side electrode and/or conversion layer ($1^I$, $1^{II}$, $1^{III}$, ...) and/or the second electrode and/or conversion layer ($3^I$, $3^{II}$, $3^{III}$, ...), solutions, emulsions or suspensions of poly(ethylenedioxythiophene):poly(styrene sulphonic acid) in water and solvents, such as isopropanol, ethanol and others, ZnO nanoparticles in chloroform or acetone from zinc acetate dihydrate, ZnO nanoparticles in chloroform from diethylzinc, zinc acetylacetonate hydrate in methanol, titanium isopropoxide in alcohol (methanol, isopropanol, methanol), $TiO_x$ NPs from titanium (IV) isopropoxide in isopropanol, $MoO_3$ NPs from ammonium molybdate in aqueous solution, molybdenum-(V)-isopropoxide in butanol, molybdenum tricarbonyl trispropionitrile in acetonitrile, bis(2,4-pentanedionato)molybdenum dioxide in

isopropanol, $V_2O_5$NPs in isopropanol, vanadium(V) oxiisopropoxide in isopropanol, aluminium-doped zinc oxide from zinc acetate and aluminium hydroxite acetate in ethanol and monoethanolamine, and/or

b) the photoactive layer ($2^I$, $2^{II}$, $2^{III}$, ...), solutions, suspensions, emulsions of inorganic semiconductors, such as for example Si, a-Si:H, CuZnSnS, CuZnSnSe), GaAs, CuInS, CuInSe, CuInGeS, CuInGeSe, Ge, CdTe, metal oxides, such as $TiO_2$, ZnO, or organic semiconductors such as for example poly(3-hexylthiophene), metal phthalocyanines, dicyanovinyl (DCV)-substituted quaterthiophenes, fullerene derivatives and nanoparticles of the various materials and also combinations hereof and/or semiconducting polymers and fullerene derivatives and/or inorganic metal- or semiconductor nanoparticles (Au, Ag, Al, $Al_2O_3$, ZnO, $TiO_2$, $MoO_3$, $V_2O_5$, CdS, CdSe, PbS, PbSe, CuInS, CuInSe, CuInGeS, CuInGeSe, CuZnSnS, CuZnSnSe) and/or hybrid semiconductors, such as perovskites, for example $CH_3NH_3PbI_3$ or precursors of organic and inorganic semiconductors in solvents, such as chlorobenzene, dichlorobenzene, xylene, toluene, alcohols, water and mixtures hereof.

**Revendications**

1. Procédé de fabrication d'une disposition de cellules photovoltaïques en couches minces comprenant une pluralité de cellules photovoltaïques en couches minces (I, II, III, ...) appliquées sur un substrat (S), qui comprennent chacune au moins une première électrode arrière (1', 1", 1"', ...), orientée vers le substrat (S), une deuxième électrode et/ou une couche de conversion (3', 3", 3"', ...) ainsi qu'une couche photo-active (2', 2", 2"', ...) disposée entre l'électrode arrière (1', 1", 1"', ...) et la deuxième électrode et/ou la couche de conversion (3', 3", 3"', ...), moyennant quoi la disposition de cellules photovoltaïques en couches minces

a) au moins une zone de chevauchement (B) dans laquelle sont superposées une première cellule photovoltaïque en couche mince (I, II, ...) et une deuxième cellule photovoltaïque en couche mince (II, III, ...) en deux couches (n, n+1, ...), par paires (I-II, II-III, ...), une zone de la première cellule photovoltaïque (I, II, ...) dans une première couche (n, ...) et une zone de la deuxième cellule photovoltaïque en couche mince (II, III, ...), qui est disposée sur le côté, opposé au substrat (S), de la première cellule photovoltaïque en couche mince (I, II, ...) dans une couche (n+1, ...) se trouvant au-dessus de la première cellule photovoltaïque en couche mince (I, II, ...), étant reliées entre elles et branchées électriquement en série et

b) au moins une zone de chevauchement (A) dans laquelle uniquement la deuxième cellule photovoltaïque en couche mince (II, III, ...) de la paire est constituée de la première et de la deuxième cellule photovoltaïque en couches minces (I-II, II-III, ...), l'électrode arrière ($1"_{n+1}$, $1"'_{n+1}$, ...), la couche photo-active ($2"_{n+1}$, $2"'_{n+1}$, ...) et la deuxième électrode et/ou la couche de conversion ($3"_{n+1}$, $3"'_{n+1}$, ...), réalisées dans la couche (n+1, ...) située au-dessus de la première couche, de la deuxième cellule photovoltaïque en couche mince (II, III, ...) étant transformées respectivement en une électrode arrière ($1"_n$, $1"'_n$, ...) une couche photo-active ($2"_n$, $2"'_n$, ...) et une deuxième électrode et/ou une couche de conversion ($3"_n$, $3"'_n$, ...) réalisées dans la première couche (n, ...),

dans lequel, sur un substrat (S), sont réalisés simultanément ou successivement plusieurs cellules photovoltaïques en couches minces (I, II, III, ...) par dépose simultanée ou successive d'au moins une première électrode arrière (1', 1", 1"') orientée vers le substrat (S), d'une couche photo-active (2', 2", 2"', ...) disposée au-dessus ainsi que d'une deuxième électrode et/ou d'une couche de conversion (3', 3", 3"', ....), disposées au-dessus, sur le substrat (S), au moins deux cellules photovoltaïques en couches minces (I, II, III, ...) étant réalisées de manière superposée dans au moins une zone de chevauchement (B), par paires (I-II, II-III, ...) dans au moins deux couches (n, n+1, ...) en déposant la deuxième cellule photovoltaïque en couche mince (II, III, ...) de chaque paire (I-II, II-III, ...), constituée d'une première (I, II, ...) et d'une deuxième cellule photovoltaïque en couche mince (II, III, ...), partiellement dans une couche (n+1, n+2, ...) se trouvant au-dessus de la première cellule photovoltaïque en couche mince, et la première cellule photovoltaïque en couche mince (I, II, ...) et la deuxième cellule photovoltaïque en couche mince (II, III, ...) étant branchées électriquement en série dans cette zone (B),

et la deuxième cellule photovoltaïque en couche mince (I III, ...) de chaque paire (I-II, II-III, ...), constituée d'une première (I, II, ...) et d'une deuxième cellule photovoltaïque en couche mince (II, III, étant déposée de manière décalée par rapport à la première cellule photovoltaïque en couche mince (I, II, ...) de chaque paire (I-II, II-III, ...), constituée d'une première (I, II, ...) et d'une deuxième cellule photovoltaïque en couche mince (II, III, ...), de façon à ce qu'une zone de transition (A) soit réalisée, dans laquelle l'électrode arrière (1", 1"', ...), la couche photo-active (2", 2"', ...), disposée au-dessus, ainsi que la deuxième électrode et/ou la couche de conversion (3", 3"'),

disposées au-dessus, de la deuxième cellule photovoltaïque en couche mince de chaque paire (I-II, II-III, ...), constituée d'une première (I, II, ...) et d'une deuxième cellule photovoltaïque en couche mince (II, III, ...), est transformée à partir d'une couche (n+1, n+2, ...) située au-dessus de la première cellule photovoltaïque en couche mince en une couche (n, n+1) disposée en dessous.

2. Procédé selon la revendication 1, **caractérisé en ce que** la dépose et/ou la préfabrication des cellules photovoltaïques en couches minces, les cellules photovoltaïques en couches minces partielles et/ou des premières électrodes arrière, orientées vers le substrat (S), des deuxièmes électrodes et/ou des couches de conversion ainsi que des couches photo-actives des cellules photovoltaïques en couches minces et/ou des cellules photovoltaïques en couches minces partielles a lieu à partir de la phase liquide ou de la phase gazeuse, plus particulièrement par impression d'aérosol, par dépose à vide, par impression par jet d'encre, par coulage d'un film et/ou par un procédé de collage.

3. Procédé selon l'une des revendications précédentes, **caractérisé en ce que**, dans une première couche (n, ...), au moins deux cellules photovoltaïques en couches minces partielles ($I_n$, $II_n$, ...), qui comprennent chacune au moins une première électrode arrière, orientée vers le substrat (S), une deuxième électrode et/ou une couche de conversion ainsi qu'une couche photo-active disposée entre l'électrode arrière et la deuxième électrode et/ou la couche de conversion, sont préfabriquées et au moins une autre cellule photovoltaïque en couche mince partielle ($II_{n+1}$, $III_{n+1}$, ...), qui comprend au moins une première électrode arrière, orientée vers le substrat (S), une deuxième électrode et/ou une couche de conversion ainsi qu'une couche photo-active disposée entre l'électrode arrière et la deuxième électrode et/ou la couche de conversion, est déposée dans une deuxième couche (n+1) de manière décalée sur les au moins deux cellules photovoltaïques en couches minces partielles ($I_n$, $II_n$, ...) disposées dans la première couche (n, ...), au moins une zone de chevauchement (B) étant réalisée entre au moins une cellule photovoltaïque en couche mince partielle (In), disposée dans la première couche (n, ...), et une cellule photovoltaïque en couche mince partielle ($II_{n+1}$) déposée dans une deuxième couche (n+1, ...) et au moins une zone de chevauchement (A) étant réalisée par la mise en contact de l'électrode arrière, de la couche photo-active ainsi que de la deuxième électrode et/ou de la couche de conversion de la cellule photovoltaïque en couche mince partielle ($II_{n+1}$), déposée dans la deuxième couche (n+1, ...), avec l'électrode arrière, la couche photo-active ainsi que la deuxième électrode et/ou la couche de conversion de la cellule photovoltaïque en couche mince partielle ($II_n$) disposée dans la première couche (n, ...),
de préférence, lors de la préfabrication ou du dépôt des au moins deux cellules photovoltaïques en couches minces partielles ($I_n$, $II_n$, ...) et/ou de l'au moins une autre cellule photovoltaïque en couche mince partielle ($II_{n+1}$, $III_{n+1}$, ...), l'au moins une première électrode arrière, orientée vers le substrat (S), la deuxième électrode et/ou la couche de conversion ainsi que la couche photo-active disposée entre l'électrode arrière et la deuxième électrode et/ou la couche de conversion sont déposées successivement pour chaque cellule photovoltaïque en couche mince partielle ($I_n$, $II_n$, ..., ou $II_{n+1}$, $III_{n+1}$, ...) et simultanément pour les cellules Photovoltaïques en couches minces partielles ($I_n$, $II_n$, ..., ou $II_{n+1}$, $III_{n+1}$, ...) correspondantes.

4. Procédé selon l'une des revendications précédentes, **caractérisé en ce que**, après le dépôt de la première électrode arrière, orientée vers le substrat (S), de la couche photo-active ainsi que de la deuxième électrode d'une cellule photovoltaïque en couche mince partielle ($I_n$, $II_n$, ...) dans la première couche (n, ...), la première électrode arrière, orientée vers le substrat (S), la couche photo-active et/ou la deuxième électrode de la cellule photovoltaïque en couche mince partielle ($I_n$, $II_n$, ...) est terminée, plus particulièrement par le dépôt d'un isolateur électrique (4) puis une couche de conversion est déposée pour la mise en contact électrique de la deuxième électrode d'une première cellule photovoltaïque en couche mince partielle ($I_n$, ...) avec la première électrode d'une deuxième cellule photovoltaïque en couche mince partielle ($II_n$, ...) adjacente et pour la formation d'une zone de chevauchement (A).

5. Procédé selon l'une des revendications précédentes, **caractérisé en ce que** le dépôt, réalisé simultanément ou successivement de l'au moins une première électrode arrière (1', 1", 1''', ...) de la couche photo-active (2', 2", 2''', ..) disposée au-dessus ainsi que de la deuxième électrode et/ou de la couche de conversion (3', 3", 3''', ...) disposée au-dessus

    a) a lieu par coulée d'un film, dans lequel les matériaux précurseurs sont coulés et/ou pressés au moyen d'une tête de coulée (G') comprenant une pluralité de fentes de coulée (a, b, ...) sur le substrat (S), les fentes de coulée (a, b, ...) étant divisées chacune en plusieurs compartiments (a2, a2, a3, a4, ... ; b1, b2, b3, b4, b5, b6, b7, ...) à travers lesquels les matériaux précurseurs de l'électrode arrière (1', 1", 1''', ...), la couche photo-active (2', 2", 2''', ...) ainsi que la deuxième électrode et/ou la couche de conversion (3', 3", 3''', ...) des différentes cellules photovoltaïques en couches minces (I, II, III, ...) sont coulés et/ou pressés, les compartiments (a2, a2, a3, a4, ... ; b1, b2, b3, b4, b5, b6, b7, ...) étant disposés les uns par rapport aux autres de façon à ce que l'électrode arrière (1', 1", 1"', ...), la couche photo-active (2', 2", 2"', ...) ainsi que la deuxième électrode et/ou la couche de conversion (3', 3", 3"', ...) d'une cellule photovoltaïque en couche mince individuelle (3', 3", 3"', ...) étant coulées de manière superposée au moins partiellement et, pour une paire (I-II, II-III, ...) constituée d'une première (I, II, ...) et d'une deuxième cellule photovoltaïque en couche mince (II, III, ...), l'électrode arrière (1', 1", 1"', ...) correspondante, la couche photo-active (2', 2", 2"', ...) ainsi que la deuxième électrode et/ou la couche de conversion (3', 3", 3"', ...) sont coulées de manière décalée entre elles, de façon à obtenir une zone de chevauchement (B) et une zone de transition (A) et/ou

b) a lieu par coulée d'un film, dans lequel les matériaux précurseurs sont coulés et/ou pressés au moyen d'une tête de coulée (G) comprenant une pluralité de fentes de coulée (X'$_1$, X'$_2$, X'$_3$, X"$_1$, X"$_2$, X"$_3$, X"'$_1$, X"'$_2$, X"'$_3$, ...) sur le substrat (S), les fentes de coulée (X'$_1$, X'$_2$, X'$_3$, X"$_1$, X"$_2$, X"$_3$, X"'$_1$, X"'$_2$, X"'$_3$, ...) d'une électrode arrière (1', 1", 1"', ...), d'une couche photo-active (2', 2", 2"', ...) ainsi que d'une deuxième électrode et/ou d'une couche de conversion (3', 3", 3"', ...) étant allouées à une cellule photovoltaïque en couche mince (I, II, III, ...) correspondante, réalisées de manière continue sur toute la largeur de l'électrode arrière (1', 1", 1"', ...) correspondante, de la couche photo-active (2', 2", 2"', ...) ainsi que de la deuxième électrode et/ou de la couche de conversion (3', 3", 3"', ...) de la cellule photovoltaïque en couche mince (I, II, III, ...) correspondante et étant disposées dans la tête de coulée (G) de façon à ce que l'électrode arrière (1', 1", 1"', la couche photo-active (2', 2", 2"', ...) ainsi que la deuxième électrode et/ou la couche de conversion (3', 3", 3"', ...) d'une cellule photovoltaïque en couche mince (I, II, III, ...) correspondante sont coulées de manière superposée au moins partiellement et, pour chaque paire (I-II, II-III, ...), constituée d'une première (I, II, ...) et d'une deuxième cellule photovoltaïque en couche mince (II, III, ...), l'électrode arrière (1', 1", 1"', ...) correspondante, la couche photo-active (2', 2", 2"', ...) ainsi que la deuxième électrode et/ou la couche de conversion (3', 3", 3"', ...) sont coulées de manière décalée entre elles de façon à obtenir une zone de chevauchement (B) et une zone de transition (A) et/ou

c) a lieu par impression à jet d'encre et/ou par aérosol sur le substrat (S), l'électrode arrière (1', 1", 1"', ...), la couche photo-active (2', 2", 2"', ...) ainsi que la deuxième électrode et/ou la couche de conversion (3', 3", 3"', ...) d'une cellule photovoltaïque en couche mince (I, II, III, ...) correspondante étant imprimées de manière au moins partiellement superposée et pour chaque paire (I-II, II-III, ...), constituée d'une première (I, II, ...) et d'une deuxième cellule photovoltaïque en couche mince (II, III, ...), l'électrode arrière (1', 1", 1"', ...) correspondante, la couche photo-active (2', 2", 2"', ...) ainsi que la deuxième électrode et/ou la couche de conversion (3', 3", 3"', ...) sont imprimées de manière décalée entre elles, de façon à obtenir une zone de chevauchement (B) et une zone de transition (A).

6. Procédé selon l'une des revendications précédentes, **caractérisé en ce que**, sur le substrat (S) sont déposées successivement de manière partiellement superposée une pluralité de cellules photovoltaïques en couches minces, qui comprennent chacune une première électrode arrière, orientée vers le substrat (S), une deuxième électrode et/ou une couche de conversion ainsi qu'une couche photo-active disposée entre l'électrode arrière et la deuxième électrode et/ou la couche de conversion.

7. Procédé selon l'une des revendications précédentes, **caractérisé en ce que** les cellules photovoltaïques en couches minces partielles ou les cellules photovoltaïque en couches minces déposées sont fixées, avant le laminage sur un support temporaire (T), qui est de préférence un film de matière plastique, qui est éliminé après le dépôt et/ou

les cellules photovoltaïque en couches minces partielles ou les cellules photovoltaïques en couches minces sont déposées au-dessus du couche adhésive isolante (K) ou une couche adhésive conductrice (K').

8. Procédé selon l'une des revendications précédentes, **caractérisé en ce que** plusieurs paires (I-II, II-III, ...), constituées d'une première (I, II, ...) et d'une deuxième cellule photovoltaïque en couche mince (II, III, ...), sont disposées de manière itérative, plusieurs zones de transitions (B$^{I-II}$, B$^{II-III}$, ...) étant réalisées avec des cellules photovoltaïques en couches minces reliées par paires (I-II, II-III, ...) ainsi que plusieurs zones de transition (A', A", ...) de la deuxième cellule photovoltaïque en couche mince (II, III, ...) des plusieurs paires (I-II, II-III, ...), constituées d'une première (I, II, ...) et d'une deuxième cellule photovoltaïque en couche mince (II, III, ...), étant réalisées.

9. Procédé selon l'une des revendications précédentes, **caractérisé en ce que** la pluralité de cellules photovoltaïques en couches minces (I, II, III, ...)

a) sont disposées en deux couches (n, n+1), la deuxième cellule photovoltaïque en couche mince (II, III, ...) d'une paire, constituée d'une première et d'une deuxième cellule photovoltaïque en couche mince (I-II, II-III, ...), comprenant une zone de transition (A', A", ...), dans laquelle l'électrode arrière ($1"_{n+1}$, $1"'_{n+1}$, ...), la couche photo-active ($2"_{n+1}$, $2"'_{n+1}$, ...) et la deuxième électrode et/ou la couche de conversion ($3"_{n+1}$, $3"'_{n+1}$, ...), réalisées dans la deuxième couche (n+1), de la deuxième cellule photovoltaïque en couche mince (II, III, ...) sont transformées respectivement en une électrode arrière ($1"_n$, $1"'_n$, ...), une couche photo-active ($2"_n$, $2"'_n$, ...) et une deuxième électrode et/ou une couche de conversion ($3"_n$, $3"'_n$, ...), réalisées dans la première couche (n, ...),

b) sont disposées en trois couches (n, n+1, n+2), la deuxième cellule photovoltaïque en couche mince (II, III, ...) d'une paire, constituée d'une première et d'une deuxième cellule photovoltaïque en couche mince (I-II, II-III, ...), comprenant deux zones de transition disposées de manière échelonnée, moyennant quoi, dans la première zone de transition, l'électrode arrière, la couche photo-active et la deuxième électrode et/ou la couche de conversion, réalisées dans la troisième couche (n+2), de la deuxième cellule photovoltaïque en couche mince (II, III, ...) sont transformées respectivement en une électrode arrière, une couche photo-active et une deuxième électrode et/ou une couche de conversion réalisées dans la deuxième couche (n+1) et, dans la deuxième zone de transition, en une électrode arrière, une couche photo-active et une deuxième électrode et/ou une couche de conversion réalisées dans la deuxième couche (n) ou

c) sont disposées en quatre couches (n, n+1, n+2, n+3), la deuxième cellule photovoltaïque en couche mince (II, III, ...) d'une paire, constituée d'une première et d'une deuxième cellule photovoltaïque en couche mince (I-II, II-III, ...), comprenant trois zones de transition disposées de manière échelonnée, moyennant quoi, dans la première zone de transition, l'électrode arrière, la couche photo-active et la deuxième électrode et/ou la couche de conversion, réalisées dans la quatrième couche (n+3), de la deuxième cellule photovoltaïque en couche mince (II, III, ...), sont transformées respectivement en une électrode arrière, une couche photo-active et une deuxième électrode et/ou une couche de conversion, réalisées dans la troisième couche (n+2), dans la deuxième zone de transition, en une électrode arrière, une couche photo-active et une deuxième électrode et/ou une couche de conversion, réalisées dans la deuxième couche (n+1) et, dans la troisième zone de transition, en une électrode arrière, une couche photo-active et une deuxième électrode et/ou une couche de conversion, réalisées dans la première couche (n).

10. Procédé selon l'une des revendications précédentes, **caractérisé en ce que** la largeur de chaque zone de chevauchement (B) de chaque paire, constituée d'une première et d'une deuxième cellule photovoltaïque en couche mince (I-II, II-III, ...) est entre 0,01 et 0,99 fois, de préférence entre 0,01 et 0,1 fois, de 0,4 fois à 0,6 fois ou de 0,9 à 0,99 fois la longueur de la deuxième cellule photovoltaïque en couche mince (II, III, ...) correspondante.

11. Procédé selon l'une des revendications précédentes, **caractérisé en ce que** la liaison entre la zone de la première cellule photovoltaïque en couche mince (I, II, ...) et la zone de la deuxième cellule photovoltaïque en couche mince (II, III, ...), dans au moins une zone de chevauchement (B)

a) est réalisée par une liaison directe de la deuxième électrode et/ou de la couche de conversion ($3'_n$, $3"_n$, ...) de la première cellule photovoltaïque en couche mince (I, II, ...) avec une électrode arrière ($1"_{n+1}$, $1"'_{n+1}$, ...) de la deuxième cellule photovoltaïque en couche mince (II, III, ...) de la paire constituée d'une première et d'une deuxième cellule photovoltaïque en couche mince (I-II, II-III, ...),

b) est réalisée par une liaison éloctro-conductrice de la deuxième électrode et/ou de la couche de conversion ($3'_n$, $3"_n$, ...) de la première cellule photovoltaïque en couche mince (I, II, ...) avec une électrode arrière ($1"_{n+1}$, $1"'_{n+1}$, ...) de la deuxième cellule photovoltaïque en couche mince (II, III, ...) de la paire constituée d'une première et d'une deuxième cellule photovoltaïque en couche mince (I-II, II-III, ...) au moyen d'une couche adhésive électro-conductrice (K') ou

c) est réalisée par une liaison électro-isolante de la deuxième électrode et/ou de la couche de conversion ($3'_n$, $3"_n$, ...) de la première cellule photovoltaïque en couche mince (I, II, ...) avec une électrode arrière ($1"_{n+1}$, $1"'_{n+1}$, ...) de la deuxième cellule photovoltaïque en couche mince (II, III, ...) de la paire constituée d'une première et d'une deuxième cellule photovoltaïque en couche mince (I-II, II-III, ...) au moyen d'une couche adhésive électro-isolante (K), le contact électrique de la deuxième électrode et/ou de la couche de conversion ($3'_n$, $3"_n$, ...) de la première cellule photovoltaïque en couche mince (I, II, ...) étant réalisé avec l'électrode arrière ($1"_{n+1}$, $1"'_{n+1}$, ...) de la deuxième cellule photovoltaïque en couche mince (II, III, ...) par l'intermédiaire d'une liaison électro-conductrice (7).

**12.** Procédé selon, l'une des revendications précédentes, **caractérisé en ce que**, dans la zone de transition (A)

a) la première cellule photovoltaïque en couche mince (I, II, ...) de la paire, constituée d'une première et d'une deuxième cellule photovoltaïque en couche mince (I-II, II-III, ...), est branchée de manière monolithique avec la deuxième cellule photovoltaïque en couche mince (II, III, ...) ou b) l'électrode arrière (1', 1", ...), la couche photo-active (2', 2", ...) et la deuxième électrode et/ou la couche de conversion (3', 3", ...) de la première cellule photovoltaïque en couche mince (I, II, ...) de la paire, constituée d'une première et d'une deuxième cellule photovoltaïque en couche mince (I-II, II-III, ...), sont terminées et isolées électriquement de la deuxième cellule photovoltaïque en couche mince (II, III, ...), la terminaison étant réalisée de préférence à l'aide d'un isolateur électrique (4).

**13.** Procédé selon, l'une des revendications précédentes, **caractérisé en ce que**
dans la zone de transition (A), l'électrode arrière (1", 1"', ...), la couche photo-active (2", 2"', et la deuxième électrode et/ou la couche de conversion (3", 3"', ...) de la deuxième cellule photovoltaïque en couche mince (II, III, ...) de la paire, constituée d'une première et d'une deuxième cellule photovoltaïque en couche mince (I-II, II-III, ...), sont transformées au moins partiellement perpendiculairement au substrat (S), en forme de S ou de manière linéaire, dans la première couche (n, ...) et/ou
dans au moins une zone de chevauchement (B), l'électrode arrière (1', 1'$_n$, 1"$_n$, 1"'$_n$, ...), réalisée dans la couche la plus basse (n), des cellules photovoltaïques en couches minces (I, II, III, ...) est reliée sur toute sa surface avec le substrat (S), de préférence la liaison étant réalisée par un dépôt direct de l'électrode arrière (1', 1'$_n$, 1"$_n$, 1"'$_n$, ...) sur le substrat (S), au moyen d'une couche adhésive électro-conductrice (K') ou d'une couche adhésive électro-isolante (K).

**14.** Procédé selon, l'une des revendications précédentes, **caractérisé en ce que**, indépendamment entre elles, les épaisseurs des couches
de l'électrode arrière (1', 1", 1"', ...) sont entre 1 nm et 5 μm, de préférence entre 5 nm et 1 μm, plus particulièrement de préférence entre 10 nm et 200 nm,
de la deuxième électrode et/ou de la couche de conversion (3', 3", 3"', ...) sont entre 1 nm et 5 μm, de préférence entre 5 nm et 1 μm, plus particulièrement de préférence entre 10 nm et 200 nm et/ou

de la couche photo-active (2', 2", 2"', ...) sont entre 1 nm et 5 μm, de préférence entre 5 nm et 1 μm, plus particulièrement de préférence entre 10 nm et 200 nm.

**15.** Procédé selon, l'une des revendications précédentes, **caractérisé en ce que** les matériaux précurseurs ou les produits/enduits de revêtements pour la fabrication

a) de l'électrode arrière et/ou de la couche de conversion (1' 1", 1"', ...) et/ou de la deuxième électrode et/ou de la couche de conversion (3', 3", 3"', ...), sont des solutions, des émulsions ou des suspensions de poly(éthylènedioxythiophène):(poly(acide styrolsulfone) dans de l'eau et de solvants comme l'isopropanol, l'éthanol et d'autres, des nanoparticules de ZnO dans du chloroforme ou de l'acétone, constituées de dihydrate d'acétate de zinc, de nanoparticules de ZnO dans du chloroforme, constituées de zinc diéthyle, de l'hydrate d'acétylacétonate de zinc dans de l'éthanol, de l'isopropoxyde de titane dans de l'alcool (méthanol, isopropanol, éthanol), de nanoparticules de TiOx constituées d'isopropoxyde de titane (IV) dans de l'isopropanol, des nanoparticules de $MoO_3$ constituées de molybdate d'ammonium dans une solution aqueuse, de l'isopropoxyde de molybdène (V) dans du butanol, du tricarbonyl-trisproprionitrile de molybdène dans de l'acétonitrile, du bis(2,4-pentandionato)-molybdène-dioxyde dans de l'isopropanol, des nanoparticules de $V_2O_5$ dans de l'isopropanol, de l'oxylsopropoxyde de vanadium (V) dans de l'isopropanol, de l'oxyde de zinc dopé à l'aluminium, constitué d'acétate de zinc et d'acétate d'hydroxyde d'aluminium dans de l'éthanol et de la monoéthanolamine et/ou b) de la couche photo-active (2', 2", 2"', ...) sont des solutions, des suspensions, des émulsions de semi-conducteurs anorganiques, comme Si, a-Si:H, CuZnSnS, CuZnSnSe, GaAs, CuInS, CuInSe, CuInGeS, CuInGeSe, Ge, CdTe, des oxydes métalliques comme le $TiO_2$, le ZnO ou de semi-conducteurs organiques comme le poly-(3-hexylthiophène), les phtalocyanines métalliques, les quaterthiophènes substitués avec du dicyanovinyle (DCV), des dérivés de fullérènes et des nanoparticules des différents matériaux ainsi que des combinaisons de ceux-ci et/ou de polymères semi-conducteurs et de dérivés de fullérènes et/ou de nanoparticules métalliques anorganiques ou semiconductrices (Au, Ag, Al, $Al_2O3$, ZnO, $TiO_2$, $MoO_3$, $V_2O_5$, CdS, CdSe, PbS, PbSe, CuInS, CuInSe, CuInGeS, CuInGe-Se, CuZnSnS, CuZnSnSe) et/ou de semi-conducteurs hybrides comme des pérovskites, par exemple $CH_3NH_3PbI_3$ ou des précurseurs de semi-conducteurs organiques et anorganiques dans des solvants comme le chlorobenzol, du dichlorobenzol, du xylol, du toluol, des alcools, de l'eau et des mélanges de ceux-ci.

**Figur 1 – Stand der Technik**

EP 2 936 560 B1

# Figur 2

EP 2 936 560 B1

Figur 3

**Figur 4**

**Figur 5**

Figur 6

# Figur 7

# Figur 8

EP 2 936 560 B1

Figur 8a

Figur 8b

Figur 8c

$II_{n+1}$

$III_{n+1}$

... n+1

... n ...

$I_n$

$II_n$

z

x

EP 2 936 560 B1

42

# Figur 8d

# Figur 8e

**Figur 8f**

$II_{n+1}$

$III_{n+1}$

...

n+1

...

n

...

$I_n$

$II_n$

z

x

EP 2 936 560 B1

Figur 9

## Figur 9a

$II_{n+1}$

$III_{n+1}$

... n+1

... n

$I_n$

$II_n$

... 

EP 2 936 560 B1

z

x

**Figur 9b**

$II_{n+1}$

$III_{n+1}$

. . .

. . . n+1

. . .

. . . n

$I_n$

$II_n$

EP 2 936 560 B1

z

x

# Figur 9c

EP 2 936 560 B1

**Figur 9d**

$II_{n+1}$

$III_{n+1}$

... n+1

... n

$I_n$

$II_n$

... 

EP 2 936 560 B1

50

z

x

Figur 9e

Figur 9f

$II_{n+1}$

$III_{n+1}$

... n+1

... n

$I_n$

$II_n$

EP 2 936 560 B1

z

x

Figur 9g

## Figur 10

EP 2 936 560 B1

**Figur 11**

EP 2 936 560 B1

**Figur 12**

$X_1^I$
$X_2^I$
$X_3^I$
$X_1^{II}$
$X_2^{II}$
$X_3^{II}$
$X_1^{III}$
$X_2^{III}$
$X_3^{III}$

$1^I$  $2^I$  $3^I$

$1^{II}$  $2^{II}$  $3^{II}$

$1^{III}$  $2^{III}$  $3^{III}$

I
II
III

\*

G

EP 2 936 560 B1

Figur 13

# Figur 14

EP 2 936 560 B1

**Figur 15**

**Figur 16**

EP 2 936 560 B1

**Figur 17**

**Figur 18**

EP 2 936 560 B1

**Figur 19**

V

T

d)

c)

K'

b)

a)

4

S

EP 2 936 560 B1

63

Z

X

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008049056

- DE 10020784

**In der Beschreibung aufgeführte Nicht-Patentliteratur**

- **LUNGENSCHMIED et al.** Flexible, long-lived, large-area, organic solar cells. *SOLAR ENERGY MATERIALS AND SOLAR CELLS,* vol. 91 (5), 379-384